# EUROPEAN PATENT APPLICATION

(11) **EP 4 834 570 A1**
(43) Date of publication of application: **04.11.2026**
(21) Application number: 24913005.5
(22) Date of filing: 26.12.2024
(51) Int. Cl.: B29C 65/02, B32B 15/08, H01P 3/14, H05K 1/02

(54) **HOLLOW STRUCTURAL FILM, CIRCUIT BOARD, ANTENNA EQUIPMENT, AND METHOD FOR PRODUCING HOLLOW STRUCTURAL FILM**

(30) Priority: 28.12.2023 JP 2023223682; 18.12.2024 JP 2024221867; 25.12.2024 JP 2024229033
(71) Applicant: Dai Nippon Printing Co., Ltd., Tokyo 162-8001 (JP)
(72) Inventor: KANKE Satoru, Tokyo 162-8001 (JP)
(74) Representative: Müller-Boré & Partner Patentanwälte PartG mbB
(86) International application number: PCT/JP2024/046151
(87) International publication number: WO 2025/143119

(57) **Abstract**

A hollow-structure film 1 having a hollow structure includes a first base portion 11 having a sheet shape, a second base portion 12 having a sheet shape and overlapping the first base portion 11, and a plurality of pillar portions 20 provided between the first base portion 11 and the second base portion 12. The first base portion 11 has a first facing surface 11a that faces the second base portion 12. The second base portion 12 has a second facing surface 12a that faces the first base portion 11. At least a part of the plurality of pillar portions 20 constitutes the continuous pillar portion 23 extending from the first facing surface 11a to the second facing surface 12a.

## Description

### Technical Field

The present disclosure relates to a hollow-structure film, a circuit board, an antenna device, and a method for manufacturing a hollow-structure film.

### Background Art

In recent years, information communication devices and the like have been required to transmit and receive a large amount of data at high speed. In response to such a background, an increase in the frequency of electric signals has been studied.

In particular, when a communication standard corresponding to 5G is used in a communication system defined by the International Telecommunication Union (ITU), 4.5 GHz band and 28 GHz band, which are higher-frequency band than 3.7 GHz band and the like that are frequency bands assigned to communication standards before 4G, are assigned to communication companies.

In contrast, a conventional circuit board designed on the premise of communication mainly utilizing a low frequency band has a relatively high dielectric constant value in some cases. The higher the value of the dielectric constant, the greater the propagation delay of the electric signals. Therefore, in order to increase the propagation speed of electric signals and enable high-speed operation, the dielectric constant is preferably low. As described above, in order to enable large-capacity high-speed communication by a circuit board used in a high-frequency band, it is required to make the dielectric constant of the circuit board lower than that in the related art.

Further, when the dielectric constant of a circuit board is high, the transmission loss of a high-frequency current generated on a circuit tends to increase. Therefore, when communication is attempted using the same amount of current, the loss of radio waves increases as the dielectric constant of the circuit board increases, and as a result, the radio waves that can be used for communication become weaker. Thus, a circuit board having a higher dielectric constant is more likely to cause inconvenience such as a decrease in communication distance.

As a sheet that can be used for a circuit board or the like and in which the dielectric constant is suppressed to be lower than that in the related art, a sheet manufactured by forming a resin foam containing bubbles, for example, such as the low-dielectric sheet for two-dimensional communication disclosed in PTL 1, is known.

### Citation List

### Patent Literature

PTL 1: Japanese Patent No. 5976714

### Summary of Invention

It has been required for a film used for a circuit board to have a low dielectric constant while ensuring strength.

The present disclosure has been made in view of the above points, and an object thereof is to provide a film having a low dielectric constant while ensuring strength.

Embodiments of the present disclosure relate to the following [1] to [35].
[1] A hollow-structure film having a hollow structure, the hollow-structure film including:
   a first base portion having a sheet shape;
   a second base portion having a sheet shape and overlapping the first base portion; and
   a plurality of pillar portions provided between the first base portion and the second base portion,
   in which the first base portion has a first facing surface facing the second base portion,
   in which the second base portion has a second facing surface facing the first base portion, and
   in which at least a part of the plurality of pillar portions constitutes a continuous pillar portion extending from the first facing surface to the second facing surface.
[2] The hollow-structure film according to [1],
   in which the pillar portions extend in a first direction perpendicular to a thickness direction of the hollow-structure film,
   in which, in a cross section of the hollow-structure film taken along a cross section passing through the pillar portions and perpendicular to the first direction, an angle formed by a surface of the first base portion and a portion of a surface of each of the pillar portions connected to the first base portion is 90° or more and 150° or less, and
   in which, in a cross section of the hollow-structure film taken along a cross section passing through the pillar portions and perpendicular to the first direction, an angle formed by a surface of the second base portion and a portion of a surface of each of the pillar portions connected to the second base portion is 90° or more and 150° or less.
[3] The hollow-structure film according to [1] or [2], the hollow-structure film including a main body portion,
   in which the main body portion includes the first base portion, the second base portion, the plurality of pillar portions, and a central portion having a sheet shape and located between the first facing surface and the second facing surface, and
   in which the plurality of pillar portions are located on the first facing surface side and the second facing surface side of the central portion.
[4] The hollow-structure film according to any one of [1] to [3], in which the hollow-structure film has a thickness of 50 µm or more and 1000 µm or less.
[5] The hollow-structure film according to any one of [1] to [4], in which at least one of the first base portion, the second base portion, and the pillar portions includes a first resin material having a density larger than 940 kg/m³ and a second resin material having a density smaller than or equal to 925 kg/m³.
[6] The hollow-structure film according to any one of [1] to [5], in which the hollow-structure film has a storage modulus of 1.0 × 10⁵ Pa or more.
[7] The hollow-structure film according to any one of [1] to [6], in which the hollow-structure film includes a glass particle.
[8] The hollow-structure film according to [7], in which the glass particle has a hollow portion.
[9] The hollow-structure film according to any one of [1] to [8], in which the hollow-structure film includes a compound having a double bond active to radiation or to a thermal radical initiator.
[10] The hollow-structure film according to any one of [1] to [9], in which the hollow-structure film has a porosity of 20% or more.
[11] The hollow-structure film according to any one of [1] to [10],
   in which the hollow-structure film has a first surface and a second surface opposite to the first surface, and
   in which the hollow-structure film further includes a metal layer constituting at least a portion of at least one of the first surface and the second surface.
[12] The hollow-structure film according to [11], further including a metal adjacent layer that bonds the metal layer to at least one of the first base portion and the second base portion,
   in which a material of the metal adjacent layer is different from a material of the first base portion and a material of the second base portion.
[13] The hollow-structure film according to [11] or [12], further including a metal adjacent layer that bonds the metal layer to at least one of the first base portion and the second base portion,
   in which a material of the metal adjacent layer is an adhesive.
[14] The hollow-structure film according to any one of [11] to [13], further including an ionomer layer or an ethylene (meth)acrylic acid copolymer layer that bonds the metal layer to at least one of the first base portion and the second base portion.
[15] The hollow-structure film according to any one of [11] to [14], in which at least one of conditions is satisfied, the conditions including a condition in which a value of transmission loss of an electric signal having a frequency of 10 GHz and applied to linear wiring formed from the metal layer is greater than -0.30 dB/3.5 cm, a condition in which a value of transmission loss of an electric signal having a frequency of 20 GHz and applied to the linear wiring is greater than -0.60 dB/3.5 cm, a condition in which a value of transmission loss of an electric signal having a frequency of 30 GHz and applied to the linear wiring is greater than -0.90 dB/3.5 cm, a condition in which a value of transmission loss of an electric signal having a frequency of 40 GHz and applied to the linear wiring is greater than - 1.30 dB/3.5 cm, a condition in which a value of transmission loss of an electric signal having a frequency of 50 GHz and applied to the linear wiring is greater than -1.80 dB/3.5 cm, and a condition in which a value of transmission loss of an electric signal having a frequency of 60 GHz and applied to the linear wiring is greater than -3.00 dB/3.5 cm.
[16] A circuit board including:
   the hollow-structure film according to any one of [1] to [10], the hollow-structure film having a first surface and a second surface opposite to the first surface; and
   a wiring pattern provided on at least one of the first surface and the second surface.
[17] An antenna device including:
   the circuit board according to [16]; and
   an antenna element connected to the circuit board.
[18] A method for manufacturing a hollow-structure film having a hollow structure, the method including:
   a step of producing, using a mold, a pair of single-sided shaped bodies each including a base portion having a sheet shape and a plurality of projecting portions formed on one surface of the base portion; and
   a step of overlapping the produced pair of single-sided shaped bodies such that a plurality of the projecting portions face each other at least partially, and thermocompression bonding the pair of single-sided shaped bodies.
[19] A hollow-structure film having a hollow structure, the hollow-structure film including:
   a main body portion including a first base portion having a sheet shape, a second base portion having a sheet shape and overlapping the first base portion, and a plurality of pillar portions provided between the first base portion and the second base portion,
   in which the first base portion has a first facing surface facing the second base portion,
   in which the second base portion has a second facing surface facing the first base portion,
   in which at least a part of a plurality of the pillar portions constitutes a continuous pillar portion extending from the first facing surface to the second facing surface,
   in which the main body portion includes an insulating inorganic material member, and
   in which a maximum width of the inorganic material member is more than or equal to three times a minimum width of the inorganic material member.
[20] The hollow-structure film according to [19], in which the inorganic material member is included in at least one of the first base portion and the second base portion.
[21] The hollow-structure film according to [19] or [20], in which the inorganic material member is included in at least a part of a plurality of the pillar portions.
[22] The hollow-structure film according to any one of [19] to [21],
   in which the main body portion further includes a central portion having a sheet shape and located between the first facing surface and the second facing surface, and
   in which the plurality of pillar portions are located on the first facing surface side and the second facing surface side of the central portion.
[23] The hollow-structure film according to [22], in which the inorganic material member is included in at least the central portion.
[24] The hollow-structure film according to any one of [19] to [23], in which the inorganic material member contains glass.
[25] The hollow-structure film according to any one of [19] to [24], in which the inorganic material member has a maximum width of 10 µm or more.
[26] The hollow-structure film according to any one of [19] to [25], in which the main body portion contains polyolefin.
[27] The hollow-structure film according to any one of [19] to [26], in which the hollow-structure film has a thickness of 50 µm or more and 1000 µm or less.
[28] The hollow-structure film according to any one of [19] to [27], in which the hollow-structure film has a porosity of 20% or more.
[29] The hollow-structure film according to any one of [19] to [28],
   in which the hollow-structure film has a first surface and a second surface opposite to the first surface, and
   in which the hollow-structure film further includes a metal layer constituting at least a portion of at least one of the first surface and the second surface.
[30] The hollow-structure film according to [29], further including a metal adjacent layer that bonds the metal layer to at least one of the first base portion and the second base portion,
   in which a material of the metal adjacent layer is different from a material of the first base portion and a material of the second base portion.
[31] The hollow-structure film according to [29] or [30], further including a metal adjacent layer that bonds the metal layer to at least one of the first base portion and the second base portion,
   in which a material of the metal adjacent layer is an adhesive.
[32] The hollow-structure film according to any one of [29] to [31], further including an ionomer layer or an ethylene (meth)acrylic acid copolymer layer that bonds the metal layer to at least one of the first base portion and the second base portion.
[33] A circuit board including:
   the hollow-structure film according to any one of [19] to [28], the hollow-structure film having a first surface and a second surface opposite to the first surface; and
   a wiring pattern provided on at least one of the first surface and the second surface.
[34] An antenna device including:
   the circuit board according to [33]; and
   an antenna element connected to the circuit board.
[35] A method for manufacturing a hollow-structure film having a hollow structure, the method including:
   a step of producing, using a mold, a pair of single-sided shaped bodies each including a base portion having a sheet shape and a plurality of projecting portions formed on one surface of the base portion, the single-sided shaped bodies each including an insulating inorganic material member; and
   a step of overlapping the produced pair of single-sided shaped bodies such that a plurality of the projecting portions face each other at least partially, and thermocompression bonding the pair of single-sided shaped bodies,
   in which a maximum width of the inorganic material member is more than or equal to three times a minimum width of the inorganic material member.

### Advantageous Effects of Invention

According to an embodiment of the present disclosure, it is possible to provide a film having a low dielectric constant while ensuring strength.

### Brief Description of Drawings

[Fig. 1] Fig. 1 is a cross-sectional view showing a hollow-structure film according to an embodiment.
[Fig. 2] Fig. 2 is a plan view showing a base portion of a hollow-structure film according to an embodiment.
[Fig. 3] Fig. 3 is a diagram showing an example of an image of a cross section of a hollow-structure film according to an embodiment.
[Fig. 4] Fig. 4 is a cross-sectional view showing a hollow-structure film according to an embodiment.
[Fig. 5] Fig. 5 is a cross-sectional view showing a hollow-structure film according to an embodiment.
[Fig. 6A] Fig. 6A is a perspective view showing a hollow-structure film in which transmission loss of an electric signal is measured.
[Fig. 6B] Fig. 6B is a view showing a method for measuring transmission loss of an electric signal in a hollow-structure film.
[Fig. 6C] Fig. 6C is a perspective view showing an antenna device according to an embodiment.
[Fig. 7A] Fig. 7A is a view showing a method for manufacturing a hollow-structure film according to an embodiment.
[Fig. 7B] Fig. 7B is a view showing a method for manufacturing a hollow-structure film according to an embodiment.
[Fig. 8A] Fig. 8A is a view showing a method for manufacturing a hollow-structure film according to an embodiment.
[Fig. 8B] Fig. 8B is a view showing a method for manufacturing a hollow-structure film according to an embodiment.
[Fig. 8C] Fig. 8C is a view showing a method for manufacturing a hollow-structure film according to an embodiment.
[Fig. 9] Fig. 9 is a plan view showing a base portion of a hollow-structure film according to Modification 1.
[Fig. 10] Fig. 10 is a cross-sectional view showing a hollow-structure film according to Modification 2.
[Fig. 11] Fig. 11 is a view showing a method for manufacturing a hollow-structure film according to Modification 3.
[Fig. 12] Fig. 12 is a cross-sectional view showing a hollow-structure film according to Modification 3.
[Fig. 13] Fig. 13 is a view showing a method for manufacturing a hollow-structure film according to Modification 4.
[Fig. 14] Fig. 14 is a cross-sectional view showing a hollow-structure film according to Modification 4.
[Fig. 15] Fig. 15 is a view showing a method for manufacturing a hollow-structure film according to Modification 5.
[Fig. 16] Fig. 16 is a cross-sectional view showing a hollow-structure film according to Modification 5.
[Fig. 17] Fig. 17 is a cross-sectional view showing a hollow-structure film according to Modification 6.
[Fig. 18] Fig. 18 is a cross-sectional view showing a hollow-structure film according to Modification 6.
[Fig. 19] Fig. 19 is a view showing a method for manufacturing a hollow-structure film according to Modification 6.
[Fig. 20] Fig. 20 is a view showing a method for manufacturing a hollow-structure film according to Modification 6.
[Fig. 21A] Fig. 21A is a plan view showing a hollow-structure film according to Modification 7.
[Fig. 21B] Fig. 21B is a perspective view showing a single-sided shaped body according to Modification 7.
[Fig. 22A] Fig. 22A is a plan view showing a hollow-structure film according to Modification 7.
[Fig. 22B] Fig. 22B is a plan view showing a hollow-structure film according to Modification 7.
[Fig. 22C] Fig. 22C is a plan view showing a hollow-structure film according to Modification 7.
[Fig. 22D] Fig. 22D is a perspective view showing a single-sided shaped body according to Modification 7.
[Fig. 23A] Fig. 23A is a plan view showing a hollow-structure film according to Modification 8.
[Fig. 23B] Fig. 23B is a plan view showing a hollow-structure film according to Modification 8.
[Fig. 23C] Fig. 23C is a plan view showing a hollow-structure film according to Modification 8.
[Fig. 23D] Fig. 23D is a perspective view showing a single-sided shaped body according to Modification 8.
[Fig. 23E] Fig. 23E is a perspective view showing a single-sided shaped body according to Modification 8.
[Fig. 23F] Fig. 23F is a perspective view showing a single-sided shaped body according to Modification 8.
[Fig. 24] Fig. 24 is a view showing a method of an antenna performance evaluation test.
[Fig. 25] Fig. 25 is a view showing a method of a CTE measurement test.

### Description of Embodiments

Hereinafter, an embodiment of the present disclosure will be described with reference to the drawings. In the drawings attached to the present description, for convenience of illustration and easy understanding, the scale, the aspect ratio, and the like are changed to be exaggerated, as appropriate, from those of an actual object.

Terms and the like used in the present description to specify shapes, geometrical conditions, and degrees thereof, for example, terms such as "parallel", "perpendicular", and "identical", values of lengths and angles, and the like are not bound by their strict meanings, and are to be interpreted to include a range in which similar functions can be expected.

In the present description, terms such as "film," "sheet," and "plate" are not distinguished from one another based solely on differences in designations.

In the present description, when a plurality of upper limit value candidates and a plurality of lower limit value candidates are listed for a certain parameter, the numerical range of the parameter may be configured by combining any one of the upper limit value candidates and any one of the lower limit value candidates. As an example, the description "the parameter B may be A1 or more, may be A2 or more, or may be A3 or more. The parameter B may be A4 or less, may be A5 or less, or may be A6 or less." is considered. In this example, the numerical value range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the present description, "suppress" means suppressing realization, occurrence, or the like, or hindering realization, occurrence, or the like. The term "suppress" means not only completely preventing realization, occurrence, or the like, but also reducing the possibility of realization, occurrence, or the like, making realization, occurrence, or the like less likely to occur, or the like.

### <Hollow-structure Film>

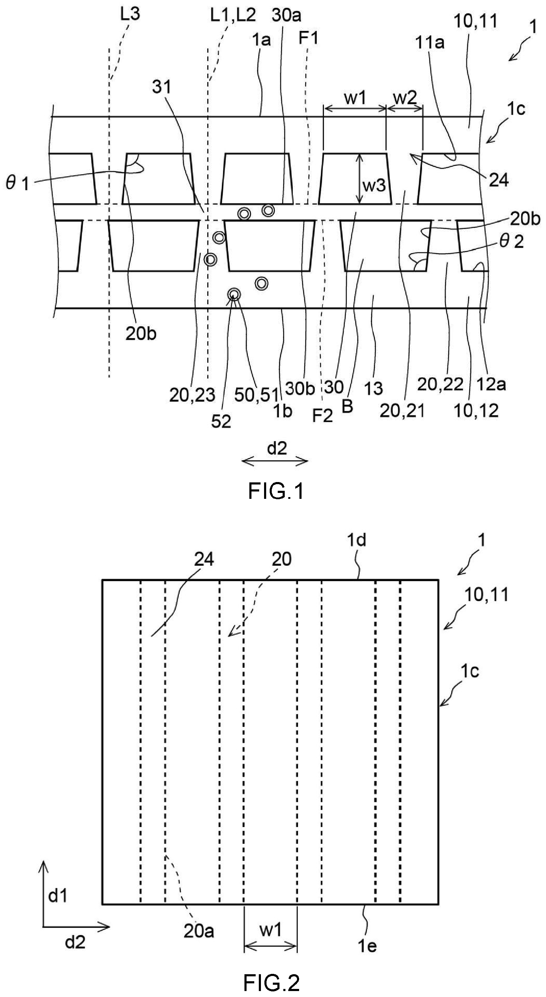

Fig. 1 to Fig. 8C are diagrams showing an embodiment. Fig. 1 is a cross-sectional view of a hollow-structure film 1 of the present embodiment, taken along a cross section parallel to the thickness direction of the hollow-structure film 1. The hollow-structure film 1 has a hollow structure. As shown in Fig. 1, the hollow-structure film 1 includes a pair of sheet-shaped base portions 10. The hollow-structure film 1 includes, as the pair of base portions 10, a sheet-shaped first base portion 11 and a sheet-shaped second base portion 12 overlapping the first base portion 11. Further, the hollow-structure film 1 includes a plurality of pillar portions 20 provided between the first base portion 11 and the second base portion 12. The hollow-structure film 1 includes a main body portion 1c. In particular, the hollow-structure film 1 shown in Fig. 1 is constituted by the main body portion 1c. The main body portion 1c includes the first base portion 11, the second base portion 12, and the plurality of pillar portions 20. Thus, the hollow-structure film 1 includes, as a part of the main body portion 1c, the first base portion 11, the second base portion 12, and the plurality of pillar portions 20. The first base portion 11 has a first facing surface 11a that faces the second base portion 12. The second base portion 12 has a second facing surface 12a that faces the first base portion 11. At least a part of the plurality of pillar portions 20 extends from the first facing surface 11a to the second facing surface 12a. In the example shown in Fig. 1, the hollow-structure film 1 further includes a sheet-shaped central portion 30 that overlaps the first base portion 11 and the second base portion 12. In the example shown in Fig. 1, the main body portion 1c further includes the central portion 30. Thus, the hollow-structure film 1 further includes the central portion 30 as a part of the main body portion 1c. The central portion 30 is positioned between the first facing surface 11a and the second facing surface 12a.

In other words, the main body portion 1c includes the first base portion 11, the second base portion 12, the plurality of pillar portions 20, and the sheet-shaped central portion 30 located between the first facing surface 11a and the second facing surface 12a. The plurality of pillar portions 20 are located on the first facing surface 11a side and the second facing surface 12a side of the central portion 30.

Since the plurality of pillar portions 20 are provided between the first base portion 11 and the second base portion 12, the first base portion 11 and the second base portion 12 are connected to each other via the pillar portions 20. Further, the space between the first base portion 11 and the second base portion 12 is partitioned by the plurality of pillar portions 20, and a plurality of hollow portions B are formed between the first base portion 11 and the second base portion 12. Thus, the hollow structure of the hollow-structure film 1 is formed. Since the hollow-structure film 1 has a hollow structure, the hollow-structure film 1 has a low dielectric constant. For this reason, it is possible to provide the hollow-structure film 1 having a low dielectric constant without being easily limited by the material of the hollow-structure film 1. In particular, the hollow-structure film 1 having a low dielectric constant can be provided without using a specific material having a low dielectric constant as the material of the hollow-structure film 1.

The hollow-structure film 1 has a first surface 1a and a second surface 1b located opposite to the first surface 1a. In the example shown in Fig. 1, the first base portion 11 constitutes the first surface 1a. The second base portion 12 constitutes the second surface 1b. The first base portion 11 and the second base portion 12 overlap each other in the thickness direction of the hollow-structure film 1.

The plurality of pillar portions 20 are provided between the pair of base portions 10, that is, between the first base portion 11 and the second base portion 12. In the example shown in Fig. 1, the plurality of pillar portions 20 extend in the thickness direction of the hollow-structure film 1. At least a part of the plurality of pillar portions 20 extends from the first facing surface 11a to the second facing surface 12a. In the example shown in Fig. 1, at least a part of the plurality of pillar portions 20 extends in the thickness direction of the hollow-structure film 1 from the first facing surface 11a to the second facing surface 12a. A portion of the plurality of pillar portions 20 extending from the first facing surface 11a to the second facing surface 12a is referred to as a continuous pillar portion 23. At least a part of the plurality of pillar portions 20 constitutes the continuous pillar portion 23 extending from the first facing surface 11a to the second facing surface 12a. When a straight line L1 extending from the first facing surface 11a to the second facing surface 12a without protruding from the hollow-structure film 1 can be drawn in a cross section obtained by cutting the hollow-structure film 1 along a plane parallel to the thickness direction, the pillar portion 20 through which the straight line L1 passes is regarded as the continuous pillar portion 23. In the hollow-structure film 1, when there are one or more cross sections in each of which the continuous pillar portion 23 appears, it is considered that at least a part of the plurality of pillar portions 20 extends from the first facing surface 11a to the second facing surface 12a in the hollow-structure film 1. The continuous pillar portion 23 extends from the first facing surface 11a to the second facing surface 12a. The plurality of pillar portions 20 may include a portion that does not extend from the first facing surface 11a to the second facing surface 12a. In the example shown in Fig. 1, the plurality of pillar portions 20 include, as a portion not extending from the first facing surface 11a to the second facing surface 12a, a first portion 21 extending from the first facing surface 11a to a first central surface 30a of the central portion 30 described later. The plurality of pillar portions 20 further include, as a portion not extending from one of the pair of base portions 10 to the other, a second portion 22 extending from the second base portion 12 to a second central surface 30b of the central portion 30 described later.

Fig. 2 is a plan view showing a state where one (first base portion 11) of the pair of base portions 10 of the hollow-structure film 1 shown in Fig. 1 is observed in the thickness direction of the hollow-structure film 1. A portion of the base portion 10 connected to the pillar portion 20 is referred to as a connection portion 24. A broken line having the sign 20a shown in Fig. 2 indicates an outline of the connection portion 24 of the first base portion 11 connected to the pillar portion 20. In the example shown in Fig. 2, a plurality of the connection portions 24 extend in a first direction d1 perpendicular to the thickness direction of the hollow-structure film 1. Therefore, the plurality of pillar portions 20 extend in the first direction d1 perpendicular to the thickness direction of the hollow-structure film 1. In the example shown in Fig. 2, the first base portion 11 does not include the connection portions 24 extending in a direction other than the first direction d1. Therefore, the hollow-structure film 1 does not include the pillar portions 20 extending in a direction other than the first direction d1.

In the example shown in Fig. 2, the connection portions 24 of the first base portion 11 are arranged at equal intervals in the thickness direction of the hollow-structure film 1 and in a second direction d2 perpendicular to the first direction d1. That is, in the example shown in Fig. 2, intervals w1 between the connection portions 24 in the second direction d2 are identical. Although not shown, the intervals w1 between the connection portions 24 in the second direction d2 are not necessarily identical.

As an example, the connection portions 24 of the second base portion 12 extend in a direction identical to a direction in which the connection portions 24 of the first base portion 11 extend, that is, in the first direction d1. In the present embodiment, the shapes of the second base portion 12 and the portions of the plurality of pillar portions 20 located closer to the second base portion 12 than the central portion 30 are identical to the shapes of the first base portion 11 and the portions of the plurality of pillar portions 20 located closer to the first base portion 11 than the central portion 30. The connection portions 24 of the second base portion 12 may extend in a direction different from the direction in which the connection portions 24 of the first base portion 11 extend. The shapes of the second base portion 12 and the portions of the plurality of pillar portions 20 located closer to the second base portion 12 than the central portion 30 may be different from the shapes of the first base portion 11 and the portions of the plurality of pillar portions 20 located closer to the first base portion 11 than the central portion 30. In the present description, unless otherwise specified, the hollow-structure film 1 in which the connection portions 24 of the second base portion 12 extend in a direction identical to the direction in which the connection portions 24 of the first base portion 11 extend will be described. In the present description, unless otherwise specified, the hollow-structure film 1 in which the shapes of the second base portion 12 and the portions of the plurality of pillar portions 20 located closer to the second base portion 12 than the central portion 30 are identical to the shapes of the first base portion 11 and the portions of the plurality of pillar portions 20 located closer to the first base portion 11 than the central portion 30 will be described.

The hollow-structure film 1 further includes the sheet-shaped central portion 30 that overlaps the first base portion 11 and the second base portion 12 and that is located between the first facing surface 11a and the second facing surface 12a. The central portion 30 has the first central surface 30a facing the first base portion 11 and the second central surface 30b facing the second base portion 12. The central portion 30 constitutes a portion of the part of the plurality of pillar portions 20 extending from one of the pair of base portions 10 to the other. Even when the hollow-structure film 1 includes the central portion 30 as shown in Fig. 1, if the straight line L1 extending from the first facing surface 11a to the second facing surface 12a without protruding from the hollow-structure film 1 can be drawn in a cross section obtained by cutting the hollow-structure film 1 along a plane parallel to the thickness direction, the pillar portion 20 through which the straight line L1 passes is regarded as the continuous pillar portion 23.

In the example shown in Fig. 1, the first portion 21 of the pillar portion 20 extends from the first facing surface 11a of the first base portion 11 to the first central surface 30a of the central portion 30. That is, the first portion 21 of the pillar portion 20 is connected to the central portion 30. Further, the second portion 22 of the pillar portion 20 extends from the second facing surface 12a of the second base portion 12 to the second central surface 30b of the central portion 30. That is, the second portion 22 of the pillar portion 20 is connected to the central portion 30.

Since the hollow-structure film 1 includes the central portion 30, the strength of the hollow-structure film 1 can be further increased. In particular, since the first portion 21 of the pillar portion 20 is connected to the central portion 30 and the second portion 22 of the pillar portion 20 is connected to the central portion 30, the strength of the hollow-structure film 1 can be further increased.

In the present embodiment, the hollow-structure film 1 contains polyolefin. In particular, the main body portion 1c of the hollow-structure film 1 contains polyolefin. In the present embodiment, each of the pair of base portions 10, the plurality of pillar portions 20, and the central portion 30 contains a resin. The resin contained in each of the pair of base portions 10, the plurality of pillar portions 20, and the central portion 30 may be polyolefin. In this case, any of polyethylene, polypropylene, and polymethylpentene may be used as the polyolefin. Each of the pair of base portions 10, the plurality of pillar portions 20, and the central portion 30 may contain polyethylene. Further, these resins may each have a partially modified structure. The hollow-structure film 1 may contain a plurality of types of resins. Each of the pair of base portions 10, the plurality of pillar portions 20, and the central portion 30 may contain a plurality of resins having different molecular weights or different branched structures in polymers. Specific examples of a partially modified polymer include a polymer (ethylene-acrylic acid copolymer) obtained by copolymerizing ethylene and acrylic acid. Examples of the case in which a plurality of resins having different molecular weights are contained include an example in which both of general high-density polyethylene (HDPE) and low-density polyethylene (LDPE) are contained. The material of the main body portion 1c of the hollow-structure film 1 may be a material that can be molded using a mold 90, which is described later, at a heating temperature of less than 330 °C. Consequently, by performing molding using the mold 90 while heating the material using a general heating device, it is possible to produce a single-sided shaped body 80, which is described later, and produce the main body portion 1c from the single-sided shaped body 80.

The case where the hollow-structure film 1 contains a plurality of kinds of resins will be described more specifically. The hollow-structure film 1 may contain a first resin material having a density higher than 940 kg/m³ and a second resin material having a density less than or equal to 925 kg/m³. For example, high-density polyethylene (HDPE) corresponds to the first resin material having a density higher than 940 kg/m³. For example, low-density polyethylene (LDPE) corresponds to the second resin material having a density of 925 kg/m³ or less. The densities of the resins are measured in accordance with the matters described in JISK6922-1:2018 under the heading "3.5.2 Densities". At least one of the first base portion 11, the second base portion 12, and the pillar portions 20 may contain the first resin material and the second resin material. At least one of the first base portion 11, the second base portion 12, and the pillar portions 20 may be formed of a mixture of the first resin material and the second resin material.

Examples of polyethylene products include HI-ZEX (registered trade mark) (HDPE), NEO-ZEX (registered trade mark) (C4-LLDPE), and ULTZEX (registered trade mark) (C6-LLDPE) manufactured by Prime Polymer Co., Ltd., DOWLEX (registered trade mark): 2045. 11G (C8 copolymer) (LLDPE) manufactured by Dow Chemical Company, NOVATEC (registered trade mark) HD (HDPE) and NOVATEC (registered trade mark) LL (LLDPE) manufactured by Japan Polyethylene Corporation, and SANTEC (registered trade mark) HD (HDPE) and SANTEC (registered trade mark) LD (LDPE) manufactured by Asahi Kasei Corporation. Examples of polypropylene products include Prime Polypro (registered trade mark) manufactured by Prime Polymer Co., Ltd., and Novatec (registered trade mark) PP manufactured by Japan Polypropylene Co., Ltd. Examples of polymethylpentene products include TPX (registered trade mark) manufactured by Mitsui Chemicals, Inc.

In the hollow-structure film 1, the pair of base portions 10 and a portion of the plurality of pillar portions 20 not constituted by the central portion 30 are also collectively referred to as a shaped-body corresponding portion 13. The resin contained in the shaped-body corresponding portion 13 and the resin contained in the central portion 30 may be different from each other. In this case, the shaped-body corresponding portion 13 may contain the first resin material while the central portion 30 contains the second resin material. The shaped-body corresponding portion 13 may contain the second resin material while the central portion 30 contains the first resin material. In this case, the boundary between the portion of the plurality of pillar portions 20 constituted by the central portion 30 and the portion of the plurality of pillar portions 20 not constituted by the central portion 30 is considered to be located at the position of a virtual plane F1 obtained by extending the first central surface 30a of the central portion 30 and the position of a virtual plane F2 obtained by extending the second central surface 30b of the central portion 30.

The resin contained in the central portion 30 may have a melting point lower than that of the resin contained in the shaped-body corresponding portion 13. In this case, the resin contained in the central portion 30 may be linear low-density polyethylene (LLDPE). The resin contained in the shaped-body corresponding portion 13 may be high-density polyethylene (HDPE).

The hollow-structure film 1 of the present embodiment has a hollow structure. Thus, the dielectric constant of the hollow-structure film 1 can be reduced without using a specific material having a low dielectric constant as the material of the hollow-structure film 1. Therefore, even when polyolefin is used as the material of each of the pair of base portions 10, the plurality of pillar portions 20, and the central portion 30, the dielectric constant of the hollow-structure film 1 can be reduced. When polyolefin is used as a resin contained in a film, such as the hollow-structure film 1, which can be used as a material of a circuit board to be described later, the following effects can be obtained as compared with the case where, for example, polyimide is used as a resin contained in the film. In general, polyolefin is less expensive as a material than polyimide, and, therefore, costs required for manufacturing a film and a circuit board can be reduced. In addition, as will be described later, when a metal layer 40 is bonded to the surface of the portion of the film formed of the resin, the metal layer 40 can more firmly adhere to the surface of the resin. Further, in general, a material, such as polyimide, having a low dielectric constant has a high melting point and is difficult to be processed in many cases. On the other hand, in the hollow-structure film 1 of the present embodiment, it is not necessary to use a specific material having a low dielectric constant as the material of the hollow-structure film 1. Thus, a material that can be processed by a simple method can be selected as the material to be used.

In the example shown in Fig. 1, the hollow-structure film 1 contains particles 50 that can reduce the amount of shrinkage of the hollow-structure film 1 after processing by heating. The particles 50 may increase the heat resistance of the hollow-structure film 1. In the present embodiment, the particles 50 are dispersed in the resin that is the material of the hollow-structure film 1. The particles 50 are contained in the resin-containing portion of the hollow-structure film 1. As a result, the amount of shrinkage of the resin-containing portion of the hollow-structure film 1 after processing by heating can be reduced. Further, the heat resistance of the resin-containing portion of the hollow-structure film 1 can be increased. At least one of the shaped-body corresponding portion 13 and the central portion 30 may include the particles 50. Both the shaped-body corresponding portion 13 and the central portion 30 may include the particles 50. At least one of the pair of base portions 10, the plurality of pillar portions 20, and the central portion 30 may include the particles 50. In the example shown in Fig. 1, each of the pair of base portions 10, the plurality of pillar portions 20, and the central portion 30 includes the particles 50. In Fig. 1, and Fig. 4 to Fig. 8C and Fig. 10, which will be described later, in order to avoid complication of the drawings, a part of the particles 50 contained in the hollow-structure film 1 is shown, and the other particles 50 are not shown. Since each of the pair of base portions 10, the plurality of pillar portions 20, and the central portion 30 includes the particles 50, it is possible to reduce the amount of shrinkage of each of the pair of base portions 10, the plurality of pillar portions 20, and the central portion 30 after processing by heating. In addition, the heat resistance of each of the pair of base portions 10, the plurality of pillar portions 20, and the central portion 30 can be increased. In particular, when the hollow-structure film 1 is used for a circuit board 100, the hollow-structure film 1 may be required to have heat resistance to withstand the temperature during soldering. According to the hollow-structure film 1 containing the particles 50, the heat resistance of the hollow-structure film 1 can be increased to such an extent that the hollow-structure film 1 can more stably withstand the temperature during soldering.

As an example, the particles 50 are glass particles 51. That is, the hollow-structure film 1 may contain the glass particles 51. In the example shown in Fig. 1, each of the glass particles 51 has a substantially spherical outer shape. Although not shown, the particles 50 may be particles other than the glass particles 51 that can reduce the amount of shrinkage of the hollow-structure film 1 after processing by heating. The material of the particles 50 may be, for example, resin other than polyolefin and having a higher heat resistance than a polyolefin. The particles 50 may be inorganic substances other than glass. The particles 50 may be, for example, flake-shaped fillers. The "flake-shaped filler" is, for example, a filling material having a flat shape. Although not shown, the hollow-structure film 1 may contain, instead of the particles 50 or together with the particles 50, fibers that can reduce the amount of shrinkage of the hollow-structure film 1 after processing by heating. In this case, the above-described material of the particles 50 can be used as the material of the fibers. In the hollow-structure film 1, the fibers are contained in, for example, a portion described above as a portion in which the particles 50 can be contained.

Each of the particles 50 may have a hollow portion 52. In the example shown in Fig. 1, each of the glass particles 51 has the hollow portion 52. Since the particles 50 have the hollow portions 52, in particular, since the glass particles 51 have the hollow portions 52, the shrinkage amount of the hollow-structure film 1 after being processed by heating can be further reduced. In addition, the heat resistance of the hollow-structure film 1 can be further increased by the hollow portions 52. Furthermore, the dielectric constant of the hollow-structure film 1 can be further reduced by the hollow portions 52. As a further effect, the weight of the hollow-structure film 1 can be reduced.

The ratio of the mass of the particles 50 contained in the shaped-body corresponding portion 13 to the total mass of the shaped-body corresponding portion 13 is preferably 60 mass% or less. The ratio of the mass of the particles 50 contained in the shaped-body corresponding portion 13 to the total mass of the shaped-body corresponding portion 13 may be 1 mass% or more. With the above-described ratio being 1 mass% or more, it is possible to make the dimensional change of the shaped-body corresponding portion 13 less likely to occur when the shaped-body corresponding portion 13 is heated, for example, in processing of the shaped-body corresponding portion 13 by, for example, a later-described method for manufacturing the hollow-structure film 1. In addition, when the hollow-structure film 1 including the shaped-body corresponding portion 13 is used as a product, even in the case where the ambient temperature changes, a change in the dimensions of the shaped-body corresponding portion 13 can be made less likely to occur. Although not shown, the shaped-body corresponding portion 13 does not necessarily contain the particles 50. The ratio of the mass of the particles 50 contained in the central portion 30 to the total mass of the central portion 30 is preferably 60 mass% or less. The ratio of the mass of the particles 50 contained in the central portion 30 to the total mass of the central portion 30 may be 1 mass% or more. With the above-described ratio being 1 mass% or more, the dimensions of the central portion 30 can be less likely to change when the central portion 30 is heated in, for example, a later-described method for manufacturing the hollow-structure film 1. Although not shown, the central portion 30 does not necessarily contain the particles 50.

The hollow-structure film 1 of the present embodiment may contain a compound having a double bond active to radiation or to a thermal radical initiator.

In particular, the hollow-structure film 1 of the present embodiment may contain a compound having a double bond active to radiation. The compound having a radiation-active double bond is, for example, an electron beam crosslinking agent. In this case, the compound is dispersed in the resin that is the material of the hollow-structure film 1. The compound is contained in the resin-containing portion of the hollow-structure film 1. At least one of the shaped-body corresponding portion 13 and the central portion 30 may contain the compound. Both the shaped-body corresponding portion 13 and the central portion 30 may contain the compound. The hollow-structure film 1 containing the compound is manufactured by a hollow-structure-film manufacturing method including a crosslinking step described later. According to such a hollow-structure film 1, the heat resistance of the hollow-structure film 1 can be increased. In particular, when the hollow-structure film 1 is used for a circuit board 100, the hollow-structure film 1 may be required to have heat resistance to withstand the temperature during soldering. According to the hollow-structure film 1 described above, the heat resistance of the hollow-structure film 1 can be increased to such an extent that the hollow-structure film 1 can withstand the temperature during soldering.

The hollow-structure film 1 may contain an ionizing radiation-curable compound as the compound having a double bond active to radiation. The ionizing radiation-curable compound means a compound that is crosslinked and cured by being irradiated with ionizing radiation, and has an ionizing radiation-curable functional group. The ionizing radiation-curable functional group is a group that is crosslinked by being irradiated with ionizing radiation, and examples thereof include functional groups (ethylenically unsaturated groups) having an ethylenic double bond, such as a (meth)acryloyl group, a vinyl group, and an allyl group. Ionizing radiation means electromagnetic waves or charged particle beams having energy quanta capable of polymerizing or crosslinking molecules. Examples of the ionizing radiation include electron beams (EB) and ultraviolet rays (UV), and also include electromagnetic waves such as X-rays and γ-rays; and charged particle beams such as α-rays and ion beams. The ionizing radiation-curable compound that is crosslinked and cured by being irradiated with an electron beam corresponds to the above-described electron beam crosslinking agent.

Examples of the ionizing radiation-curable compound include polymerizable monomers and polymerizable oligomers, which have been conventionally used as the ionizing radiation-curable compound. As the polymerizable monomer, a (meth)acrylate monomer having a (meth)acryloyl group in the molecule is preferable, and a polyfunctional (meth)acrylate monomer having two or more (meth)acryloyl groups in the molecule is more preferable. The number of (meth)acryloyl groups in the polyfunctional (meth)acrylate monomer is 2 or more and is preferably 8 or less and more preferably 6 or less.

Examples of the polymerizable monomer include difunctional (meth)acrylates such as ethylene glycol di(meth)acrylate, propylene glycol di(meth)acrylate, 1,4-butanediol di(meth)acrylate, 1,6-hexanediol di(meth)acrylate, bisphenol A tetraethoxy di(meth)acrylate, and bisphenol A tetrapropoxy di(meth)acrylate; trifunctional or higher (meth)acrylates such as trimethylolpropane tri(meth)acrylate, pentaerythritol tri(meth)acrylate, pentaerythritol tetra(meth)acrylate, dipentaerythritol tri(meth)acrylate, dipentaerythritol tetra(meth)acrylate, dipentaerythritol penta(meth)acrylate, and dipentaerythritol hexa(meth)acrylate; and ethylene oxide modified products, propylene oxide modified products, caprolactone modified products, isocyanuric acid modified products or propionic acid modified products of these (meth)acrylates.

Examples of the polymerizable oligomer include a (meth)acrylate oligomer having two or more (meth)acryloyl groups in the molecule. Examples of the (meth)acrylate oligomer include urethane (meth)acrylate; epoxy (meth)acrylate; polyester (meth)acrylate; polyether (meth)acrylate; polycarbonate (meth)acrylate; polycaprolactone urethane (meth)acrylate, polycaprolactone diol urethane (meth)acrylate, and acrylic (meth)acrylate. The number of (meth)acryloyl groups in the polymerizable oligomer is 2 or more and is preferably 8 or less and more preferably 6 or less.

Other examples of the polymerizable oligomer include a highly hydrophobic polybutadiene (meth)acrylate-based oligomer having a (meth)acryloyl group in a side chain of a polybutadiene oligomer, and a silicone (meth)acrylate-based oligomer having a polysiloxane bond in a main chain.

The weight-average molecular weight of the polymerizable oligomer may be 500 or more, 1,000 or more, 2,000 or more, 10,000 or less, 8,000 or less, or 6,000 or less. The weight-average molecular weight is an average molecular weight measured by gel permeation chromatography (GPC) analysis and converted to standard polystyrene.

As the ionizing radiation-curable compound, a monofunctional (meth)acrylate may be used, as appropriate, in combination with the polyfunctional (meth)acrylate for the purpose of, for example, reducing the viscosity of the curable composition at the time of coating. Examples of the monofunctional (meth)acrylate include methyl(meth)acrylate, ethyl(meth)acrylate, propyl(meth)acrylate, butyl(meth)acrylate, pentyl(meth)acrylate, hexyl(meth)acrylate, cyclohexyl(meth)acrylate, 2-ethylhexyl(meth)acrylate, lauryl(meth)acrylate, stearyl(meth)acrylate, and isobornyl(meth)acrylate.

As described above, the ionizing radiation-curable compound may have an allyl group. The ionizing radiation-curable compound containing the allyl group may be triallyl cyanurate, triallyl citrate, or triallyl 1,3,5-benzenetricarboxylate.

The hollow-structure film 1 may contain a thermal radical initiator. With the hollow-structure film 1 containing the thermal radical initiator, a crosslinking reaction is caused by heat generated by heating when the shaped-body corresponding portion 13 is heated, for example, in processing of the shaped-body corresponding portion 13 by a later-described method for manufacturing the hollow-structure film 1. This crosslinking reaction can increase the heat resistance of the hollow-structure film 1. In particular, when the hollow-structure film 1 is used for a circuit board 100, the hollow-structure film 1 may be required to have heat resistance to withstand the temperature during soldering. According to the hollow-structure film 1 containing the thermal radical initiator, the heat resistance of the hollow-structure film 1 can be increased to such an extent that the hollow-structure film 1 can withstand the temperature at the time of soldering. The thermal radical initiator contained in the hollow-structure film 1 is not particularly limited, but azo compounds such as 2,2-azobis(isobutyronitrile) and dimethyl 2,2'-azobis(2-methylpropionate), and peroxide compounds such as di-tert-butylperoxide can be suitably used.

The thermal radical initiator may be used as the thermal radical polymerization initiator. That is, the hollow-structure film 1 of the present embodiment may contain a compound generally known as a thermal radical polymerization initiator (a crosslinking agent that crosslinks molecules of polyethylene or the like by a chemical bond when heated), in addition to the compound having an active double bond. When the hollow-structure film 1 contains a thermal radical polymerization initiator, the following effects are obtained. As will be described later, in the step of molding the material of the shaped-body corresponding portion 13 in the method for manufacturing the hollow-structure film 1, a mixture that is the material of the shaped-body corresponding portion 13 is molded while the resin in the mixture is melted. At this time, with the thermal radical polymerization initiator being contained, a bond can be formed between molecules of the resin by heat when the resin is melted. This makes it possible to more reliably ensure heat resistance required when the hollow-structure film 1 is used in the circuit board 100.

When the hollow-structure film 1 of the present embodiment contains the thermal radical polymerization initiator described above, the hollow-structure film 1 may further contain a silane coupling agent in addition to the thermal radical polymerization initiator. In this case, the following effects can be obtained. As will be described later, in the step of molding the material of the shaped-body corresponding portion 13 in the method for manufacturing the hollow-structure film 1, a mixture that is the material of the shaped-body corresponding portion 13 is molded while the resin in the mixture is melted. At this time, with the thermal radical polymerization initiator and the silane coupling agent being contained, a cross-linking reaction occurs between the resin and the silane coupling agent due to a reaction caused by heat when the resin is melted. Further, in some cases, the hollow-structure film 1 is stored in a high-temperature and high-humidity environment in a step after the step of molding the material of the shaped-body corresponding portion 13. In this case, due to the hollow-structure film 1 being stored in a high-temperature and high-humidity environment, the silane coupling agents react with each other. By these reactions, heat resistance required when the hollow-structure film 1 is used for the circuit board 100 can be more reliably ensured.

Specific examples of the thermal radical polymerization initiator include di-t-butylperoxide, dicumyl peroxide and 2,2'-azobis(2,4-dimethylvaleronitrile), and the like.

The width of each of the connection portions 24, which are portions of the base portion 10 connected to the pillar portions 20, in the second direction d2 is referred to as a width w2. In this case, each interval w1 between the connection portions 24 in the second direction d2 is preferably not less than 0.5 times and not more than 20 times the width w2. With the interval w1 being not less than 0.5 times the width w2, the size of each hollow portion B can be ensured to be particularly large, and the dielectric constant of the hollow-structure film 1 can be made particularly low. With the interval w1 being not more than 20 times the width w2, the strength of the hollow-structure film 1 can be particularly increased.

In the hollow-structure film 1, such as that shown in Fig. 1, including the central portion 30, the distance between each base portion 10 and the central portion 30 is referred to as a distance w3. When the distance between each base portion 10 and the central portion 30 is not constant, the distance between each connection portion 24 of the base portion 10 and the central portion 30 is defined as the distance w3. In this case, the distance w3 is preferably not less than 1 times and not more than 10 times the width w2. With the distance w3 being not less than 1 time the width w2, the size of each hollow portion B can be ensured to be particularly large, and the dielectric constant of the hollow-structure film 1 can be made particularly low. With the distance w3 being not more than 10 times the width w2, the strength of the hollow-structure film 1 can be particularly increased.

The cross-sectional view of the hollow-structure film 1 shown in Fig. 1 corresponds to a view showing a cross section obtained by cutting the hollow-structure film 1, in which the plurality of pillar portions 20 extend in the first direction d1, along a plane that passes through the plurality of pillar portions 20 and that is perpendicular to the first direction d1. In a cross section such as that shown in Fig. 1, an angle θ1 formed by the first facing surface 11a and, of a surface 20b of the pillar portion 20 in contact with the hollow portion B, a portion connected to the first base portion 11 is 90° or more and 150° or less. In addition, in a cross section such as that shown in Fig. 1, an angle θ2 formed by the second facing surface 12a and, of the surface 20b of the pillar portion 20 in contact with the hollow portion B, a portion connected to the second base portion 12 is 90° or more and 150° or less. With the angle θ1 and the angle θ2 being each 90° or more and 150° or less, the strength of the hollow-structure film 1 can be ensured while the size of the hollow portion B is ensured to reduce the dielectric constant of the hollow-structure film 1.

In the example shown in Fig. 1, the surface 20b of the pillar portion 20 in contact with the hollow portion B is a flat surface. Therefore, in the cross-sectional view of the hollow-structure film 1 shown in Fig. 1, the surface 20b appears as a straight line. Although not shown, the surface 20b is not necessarily a flat surface. The surface 20b may be a curved surface. When the surface 20b is not a flat surface, the surface 20b may appear as a curved surface or a polygonal line in the cross-sectional view of the hollow-structure film 1. In this case, an angle formed by the first facing surface 11a and a tangent line at, of the surface 20b appearing in the cross-sectional view of the hollow-structure film 1, a portion connected to the first base portion 11 is regarded as the angle θ1. Further, an angle formed by the second facing surface 12a and a tangent line at, of the surface 20b appearing in the cross-sectional view of the hollow-structure film 1, a portion connected to the second base portion 12 is regarded as the angle θ2.

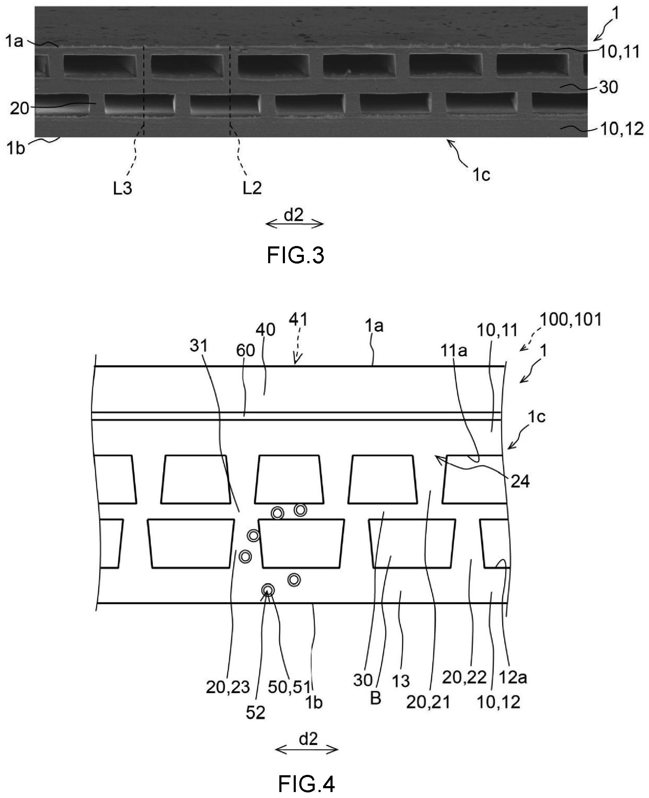

As an example, the porosity of the hollow-structure film 1 is 10% or more, and more preferably 20% or more. With the porosity of the hollow-structure film 1 being 20% or more, the size of the hollow portion B can be ensured to be particularly large, and the dielectric constant of the hollow-structure film 1 can be made particularly low. The porosity of the hollow-structure film 1 is preferably 70% or less. With the porosity of the hollow-structure film 1 being 70% or less, a decrease in the strength of the film due to a decrease in the amount of the resin contained in the hollow-structure film 1 can be suppressed. The porosity of the hollow-structure film 1 is measured by the following method. A cross section, such as that shown in Fig. 1, obtained by cutting the hollow-structure film 1 along a plane that passes through the plurality of pillar portions 20 and that is perpendicular to the first direction d1 is observed. In the cross section, a straight line L2 that passes through the center in the second direction d2 of one of the plurality of connection portions 24 of one (the first base portion 11) of the pair of base portions 10 and that is parallel to the thickness direction of the hollow-structure film 1 is drawn. Further, the connection portion 24 that is one of the plurality of connection portions 24 of one (the first base portion 11) of the pair of base portions 10 and that is adjacent in the second direction d2 to the connection portion 24 through which the straight line L2 is drawn is specified. A straight line L3 that passes through the center of the specified connection portion 24 in the second direction d2 and that is parallel to the thickness direction of the hollow-structure film 1 is drawn. Subsequently, the ratio of the areas of the hollow portions B to the entire area of the hollow-structure film 1 including the hollow portions B between the straight line L2 and the straight line L3 is calculated. The ratio is calculated at 10 different positions in the cross section. The porosity of the hollow-structure film 1 is obtained by averaging the ratios calculated at the 10 different positions. To be more specific, a cross section obtained by cutting the hollow-structure film 1 along a plane that passes through the plurality of pillar portions 20 and that is perpendicular to the first direction d1 is observed with a scanning electron microscope (SEM) or an optical microscope, and an image of the cross section is obtained. The magnification of the image to be obtained can be 100 times or more. Fig. 3 is a view showing an example of an image of a cross section of the hollow-structure film 1 obtained by a scanning electron microscope (SEM). As shown in Fig. 3, by drawing the straight line L2 and the straight line L3 on the obtained image, the porosity of the hollow-structure film 1 is obtained from the image.

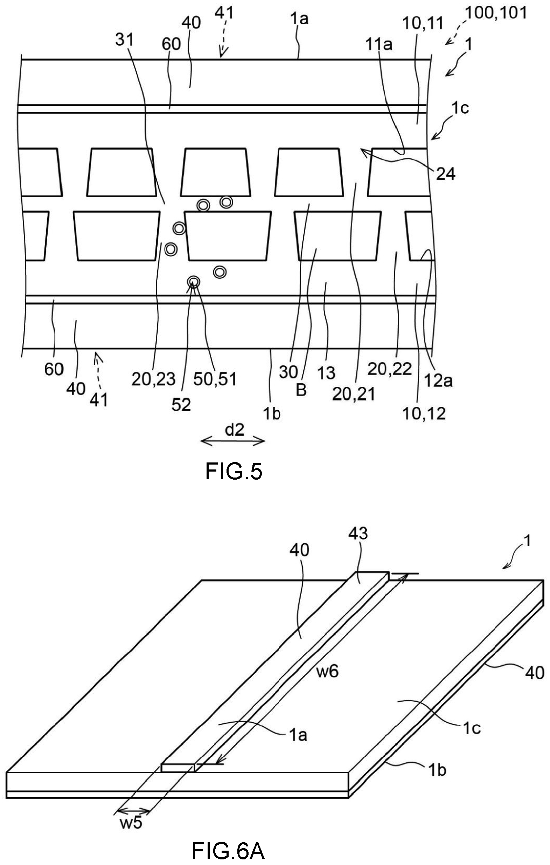

The hollow-structure film 1 may further include the metal layer 40. In this case, the later-described circuit board 100 can be manufactured by forming wiring 41, which is described later, from at least a portion of the metal layer 40. The hollow-structure film 1 may further include a metal adjacent layer 60. The metal adjacent layer 60 can bond the metal layer 40 to the base portions 10 more firmly. Fig. 4 is a cross-sectional view showing an example of the hollow-structure film 1 including the metal layer 40 and the metal adjacent layer 60. The hollow-structure film 1 shown in Fig. 4 corresponds to the hollow-structure film 1 shown in Fig. 1 having the first surface 1a on which the metal adjacent layer 60 and the metal layer 40 are stacked in this order. Fig. 5 is a cross-sectional view showing an example of the hollow-structure film 1 including the metal layer 40 and the metal adjacent layer 60, the example being different from that shown in Fig. 4. The hollow-structure film 1 shown in Fig. 5 corresponds to the hollow-structure film 1 shown in Fig. 1 having the first surface 1a and the second surface 1b on each of which the metal adjacent layer 60 and the metal layer 40 are stacked in this order.

The hollow-structure films 1 shown in Fig. 4 and Fig. 5 each have the first surface 1a and the second surface 1b located opposite to the first surface 1a. The metal layer 40 constitutes at least a portion of at least one of the first surface 1a and the second surface 1b. In the example shown in Fig. 4, the metal layer 40 constitutes the first surface 1a. In this case, the metal layer 40 may constitute the entirety of the first surface 1a or may constitute a portion of the first surface 1a. In the example shown in Fig. 5, the metal layer 40 constitutes the first surface 1a and the second surface 1b. In this case, the metal layer 40 may constitute the entirety of the first surface 1a or may constitute a portion of the first surface 1a. Further, the metal layer 40 may constitute the entirety of the second surface 1b or may constitute a portion of the second surface 1b.

The material of the metal layer 40 is not particularly limited as long as the wiring 41 of the circuit board 100 described later can be formed from at least a portion of the metal layer 40. The material of the metal layer 40 is, for example, copper. The metal layer 40 can be formed by bonding metal foil to the base portion 10. The metal layer 40 containing copper as a material can be formed by bonding copper foil to the base portion 10. The thickness of the metal layer 40 is, for example, 0.1 µm or more and 100 µm or less. The thickness of the metal layer 40 may be 2 µm or more and 20 µm or less.

The metal layer 40 may be formed by a method other than the method for bonding metal foil such as copper foil. The metal layer 40 may be formed by processing such as plating or sputtering. When the metal layer 40 is formed by plating, a generally known seed layer may be formed. When the metal layer 40 is formed by processing such as plating or sputtering, the surface of the base portion 10 on which the metal layer 40 is to be formed may be subjected to glow treatment or plasma treatment, which is known as reverse sputtering, before the metal layer 40 is formed. By such a treatment, the adhesion between the base portion 10 and the metal layer 40 can be further increased.

The metal adjacent layer 60 is a layer that bonds the metal layer 40 to the base portion 10. The metal adjacent layer 60 bonds the metal layer 40 to at least one of the first base portion 11 and the second base portion 12. The material of the metal adjacent layer 60 is different from the material of the base portion 10. The material of the metal adjacent layer 60 is different from the materials of the first base portion 11 and the second base portion 12. The metal adjacent layer 60 is a resin layer that has favorable adhesion to metal and that can be thermally welded to polyolefin. By bonding the metal layer 40 to the base portion 10 by the metal adjacent layer 60, the metal layer 40 can be more firmly bonded to the base portion 10. The metal adjacent layer 60 may be an ionomer layer, that is, an ionomer resin layer. When the metal adjacent layer 60 is an ionomer layer, the material of the metal adjacent layer 60 is, for example, carboxylic acid-copolymerized polyethylene containing metal ions. The metal adjacent layer 60 may be an ethylene (meth)acrylic acid copolymer layer. That is, the hollow-structure film 1 may further include an ionomer layer or an ethylene (meth)acrylic acid copolymer layer that bonds the metal layer 40 to the base portion 10. The hollow-structure film 1 may further include an ionomer layer or an ethylene (meth)acrylic acid copolymer layer that bonds the metal layer 40 to at least one of the first base portion 11 and the second base portion 12. Consequently, the metal layer 40 can be more firmly bonded to the base portion 10. The metal adjacent layer 60 has a thickness of, for example, 20 µm or less.

Specific examples of the ionomer include HIMILAN (registered trade mark) manufactured by Dow-Mitsui Polychemicals, Co., Ltd. Specific examples of the ethylene-acrylic acid copolymer include NUCREL (registered trade mark) manufactured by Dow-Mitsui Polychemicals, Co., Ltd. The material of the metal adjacent layer 60 is not limited to the above-described resin. A resin having the same function as the above-described resin can be suitably used as the material of the metal adjacent layer 60.

The metal adjacent layer 60 is not limited to the above example. Any resin can be suitably used as the metal adjacent layer 60 as long as the resin exhibits a function of adhering to metal.

The material of the metal adjacent layer 60 may be an adhesive. The metal adjacent layer 60 may be a layer formed by applying a varnish formed by dissolving a resin and drying the varnish. In the metal adjacent layer 60 of the above-described embodiment, an adhesive may be used as the resin used for forming the varnish.

The metal adjacent layer 60 may be a bonding sheet available in a sheet form, for example, a bonding sheet commercially available in a sheet form.

Since the hollow-structure film 1 of the present embodiment has the hollow structure, the dielectric constant can be reduced while the thickness is increased. Therefore, the thickness of the hollow-structure film 1 of the present embodiment may vary. In an example, the thickness of the hollow-structure film 1 is 50 µm or more and 1000 µm or less. As described above, according to the hollow-structure film 1 of the present embodiment, it is possible to widen the range of numerical values that can be adopted as the thickness of the hollow-structure film 1.

The storage modulus of the hollow-structure film 1 of the present embodiment is, for example, 1.0 × 10⁵ Pa or more. When the hollow-structure film 1 contains an electron beam crosslinking agent and the electron beam crosslinking agent is irradiated with an electron beam in the method for manufacturing the hollow-structure film 1 as described below, the storage modulus of the hollow-structure film 1 can be 1.0 × 10⁵ Pa or more. With the storage modulus being less than or equal to the aforementioned lower limit value, the hollow-structure film 1 is less likely to be deformed at the time of short-time high-temperature processing. Specifically, when the hollow-structure film 1 is soldered by a solder reflow step, the hollow-structure film 1 is sufficiently hardly deformed. The storage modulus of the hollow-structure film 1 is measured by using a dynamic viscoelasticity (DMA) measuring apparatus. In the measurement of the storage modulus of the hollow-structure film 1, the measurement mode of the dynamic viscoelasticity measuring apparatus is set to a tensile mode, and the storage modulus when the temperature of the hollow-structure film 1 is 280°C is measured. As a method for measuring the storage modulus of the hollow-structure film 1, a method for measuring the storage modulus described in an example below can be adopted.

In the hollow-structure film 1 including the metal layer 40 according to the present embodiment, at least one of conditions is satisfied, the conditions including a condition in which the value of the transmission loss of an electric signal having a frequency of 10 GHz and applied to linear wiring 43 formed from the metal layer 40 is greater than -0.30 dB/3.5 cm, a condition in which the value of the transmission loss of an electric signal having a frequency of 20 GHz and applied to the linear wiring 43 is greater than -0.60 dB/3.5 cm, a condition in which the value of the transmission loss of an electric signal having a frequency of 30 GHz and applied to the linear wiring 43 is greater than -0.90 dB/3.5 cm, a condition in which the value of the transmission loss of an electric signal having a frequency of 40 GHz and applied to the linear wiring 43 is greater than -1.30 dB/3.5 cm, a condition in which the value of the transmission loss of an electric signal having a frequency of 50 GHz and applied to the linear wiring 43 is greater than -1.80 dB/3.5 cm, and a condition in which the value of the transmission loss of an electric signal having a frequency of 60 GHz and applied to the linear wiring 43 is greater than -3.00 dB/3.5 cm. The transmission losses of electric signals have negative values. The closer to zero the value of the transmission loss of an electric signal is, the smaller the attenuation of the electric signal applied to the linear wiring 43 is. Therefore, for example, the value of the transmission loss being greater (close to zero) than -0.30 dB/3.5 cm means that the attenuation of an applied electric signal is lower than that in the case where the value of the transmission loss is -0.30 dB/3.5 cm. The "value of the transmission loss is large" means that the value of the transmission loss having a negative value is close to zero. The "value of the transmission loss is small" means that the value of the transmission loss having a negative value is far from zero. Simply describing that "the transmission loss is small" means that the absolute value of the value of the transmission loss having a negative value is small. When it is simply described that "the transmission loss is large", it means that the absolute value of the value of the transmission loss having a negative value is large.

In the hollow-structure film 1 having the metal layer 40, the value of the transmission loss of the electric signal having the frequency of 10 GHz and applied to the linear wiring 43 formed from the metal layer 40 may be greater than -0.30 dB/3.5 cm while the value of the transmission loss of the electric signal having the frequency of 20 GHz and applied to the linear wiring 43 is greater than -0.60 dB/3.5 cm, the value of the transmission loss of the electric signal having the frequency of 30 GHz and applied to the linear wiring 43 is greater than -0.90 dB/3.5 cm, the value of the transmission loss of the electric signal having the frequency of 40 GHz and applied to the linear wiring 43 is greater than -1.30 dB/3.5 cm, the value of the transmission loss of the electric signal having the frequency of 50 GHz and applied to the linear wiring 43 is greater than -1.80 dB/3.5 cm, and the value of the transmission loss of the electric signal having the frequency of 60 GHz and applied to the linear wiring 43 is greater than -3.00 dB/3.5 cm. According to such a hollow-structure film 1, even when electric signals having various frequencies are applied to the wiring formed from the metal layer 40, the value of the transmission loss can be made large (close to zero).

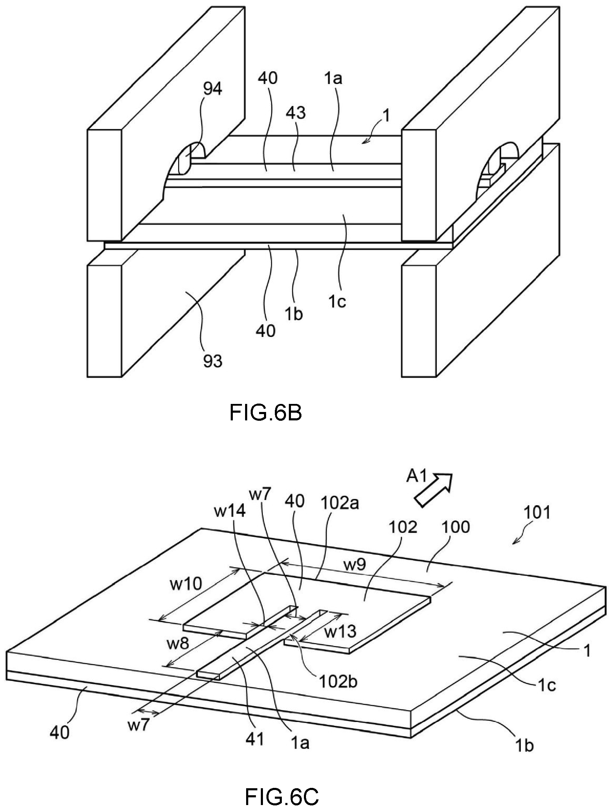

The transmission loss of an electric signal applied to the linear wiring 43 in the hollow-structure film 1 including the metal layer 40 is measured by the following method. First, as shown in Fig. 6A, the linear wiring 43 is formed from the metal layer 40 of the hollow-structure film 1. Fig. 6A is a perspective view showing the hollow-structure film 1 that includes the linear wiring 43 and that is to be used for measuring the transmission loss of an electric signal. In Fig. 6A and Fig. 6C, which is described later, the details of the structure of the main body portion 1c of the hollow-structure film 1 are not shown, and only the outline of the main body portion 1c is shown. In Fig. 6A and Fig. 6C, which is described later, illustration of the metal adjacent layer 60 is omitted.

The hollow-structure film 1 shown in Fig. 6A has the metal layer 40 on each of the first surface 1a side and the second surface 1b side. In the hollow-structure film 1 shown in Fig. 6A, the linear wiring 43 is formed from the metal layer 40 on the first surface 1a side. The hollow-structure film 1 shown in Fig. 6A is produced from the hollow-structure film 1, such as that shown in Fig. 5, having the metal layer 40 constituting at least a portion of the first surface 1a and the metal layer 40 constituting at least a portion of the second surface 1b. The hollow-structure film 1 shown in Fig. 6A can be produced by forming the linear wiring 43 from the metal layer 40 constituting at least a portion of the first surface 1a of the hollow-structure film 1 such as that shown in Fig. 5. A method for forming the linear wiring 43 from the metal layer 40 can be the same as a method for forming a wiring pattern from the metal layer 40 in a later-described method for manufacturing the circuit board 100.

A length (the dimension of the linear wiring 43 in a direction in which the linear wiring 43 extends) w5 of the linear wiring 43 is 3.5 cm or more. A width (the dimension of the linear wiring 43 in a direction perpendicular to the direction in which the linear wiring 43 extends and parallel to the first surface 1a) w6 of the linear wiring 43 is 0.75 mm. A thickness w11 of an insulating portion of the film is 0.25 mm. The thickness w11 of the insulating portion of the film corresponds to the distance between the metal layer 40 on the first surface 1a side and the metal layer 40 on the second surface 1b side. In the hollow-structure film 1 of the present embodiment, the thickness w11 of the insulating portion corresponds to the thickness of the main body portion 1c. The structure of the film such as that shown in Fig. 6A and described above is commonly referred to as a microstrip line. The width w6 of the linear wiring 43 is adjusted such that the characteristic impedance of the microstrip line present on the specific film becomes 50 Ω. A calculation formula used for adjusting the characteristic impedance of the linear wiring 43 is as follows. That is, the width w6 of the linear wiring 43 is adjusted such that the value of the characteristic impedance calculated from the following formula becomes 50 Ω. In the following formula, "εr" represents the dielectric constant, "Z0" represents the characteristic impedance, "h" represents the thickness w11, "w" represents the width w6 of the linear wiring 43, and "t" represents a thickness w12 of the linear wiring 43. [Math. 1] $Z 0 = \frac{87}{\sqrt{{ε}_{r} + 1.414}} \times ln \frac{5.98 h}{0.8 w + t}$

In the measurement of the transmission loss of an electric signal applied to the linear wiring 43, first, the hollow-structure film 1 including the linear wiring 43 is fixed to a fixture 93 as shown in Fig. 6B. A probe 94 connected to a network analyzer via a coaxial cable is attached to the fixture 93. By fixing the hollow-structure film 1 to the fixture 93, the probe 94 is brought into contact with the linear wiring 43 as shown in Fig. 6B. Subsequently, an alternating-current electric signal is applied to both ends of the linear wiring 43 from the network analyzer via the probe 94 attached to the fixture 93, and the transmission loss of the electric signal is measured. The transmission loss of the electric signal is measured under the following conditions. An electric signal is applied to a section of the linear wiring 43 having a length of 5.0 cm. At the time of measurement, de-embedding processing is performed in order to remove the influence of the fixture 93 from measurement results. In the de-embedding processing, first, the transmission loss of the electric signal in a section of 1.5 cm of a sample having the same wiring configuration as the linear wiring 43 is measured. Subsequently, de-embedding processing is performed based on a result of the measurement of the transmission loss of the sample. As a result, a value corresponding to the transmission loss measured by applying the electric signal to the section of the linear wiring 43 having a length of 3.5 cm, from which the influence of the transmission loss in both end portions of the linear wiring 43 and the fixture 93 is removed, is calculated from the transmission loss measured by applying the electric signal to the section of the linear wiring 43 having a length of 5.0 cm.

### <Circuit Board>

Next, the circuit board 100 of the present embodiment will be described. The circuit board 100 of the present embodiment includes the hollow-structure film 1 of the present embodiment. The circuit board 100 of the present embodiment further includes a wiring pattern provided on at least one of the first surface 1a and the second surface 1b. In the hollow-structure film 1 having the metal layer 40, such as that shown in Fig. 4 and Fig. 5, the circuit board 100 including the hollow-structure film 1 and the wiring pattern of the wiring 41 can be manufactured by forming the wiring 41 from at least a portion of the metal layer 40. The circuit board 100 manufactured by the above-described method can be regarded as the circuit board 100 including the hollow-structure film 1 (the hollow-structure film 1 shown in Fig. 1) including the main body portion 1c, and the wiring pattern of the wiring 41.

When the circuit board 100 is manufactured from the hollow-structure film 1 shown in Fig. 4, the wiring pattern of the wiring 41 can be formed from the metal layer 40 constituting the first surface 1a of the hollow-structure film 1. When the circuit board 100 is manufactured from the hollow-structure film 1 shown in Fig. 5, the wiring pattern of the wiring 41 may be formed from one of the metal layer 40 constituting the first surface 1a of the hollow-structure film 1 and the metal layer 40 constituting the second surface 1b of the hollow-structure film 1. When the circuit board 100 is manufactured from the hollow-structure film 1 shown in Fig. 5, the wiring pattern of the wiring 41 may be formed from both the metal layer 40 constituting the first surface 1a and the metal layer 40 constituting the second surface 1b.

When the circuit board 100 is manufactured from the hollow-structure film 1 shown in Fig. 5, the wiring pattern of the wiring 41 may be formed from the metal layer 40 constituting the first surface 1a of the hollow-structure film 1 while the wiring pattern of the wiring 41 is not formed from the metal layer 40 constituting the second surface 1b of the hollow-structure film 1. The circuit board 100 manufactured by this method can be regarded as the circuit board 100 including the hollow-structure film 1 (the hollow-structure film 1 shown in Fig. 1) including the main body portion 1c, the wiring pattern of the wiring 41 provided on the first surface 1a of the hollow-structure film 1, and the metal layer 40 provided on the second surface 1b of the hollow-structure film 1 and having no wiring pattern formed thereon. Since the circuit board 100 includes, together with the wiring pattern of the wiring 41 provided on the first surface 1a, the metal layer 40 provided on the second surface 1b and having no wiring pattern formed thereon, unnecessary noise is less likely to occur when an electric signal is transmitted via the wiring 41. The reason why unnecessary noise is less likely to be generated due to the metal layer 40 provided on the second surface 1b and having no wiring pattern formed thereon is considered as follows. When a current flows through the wiring 41 formed on the first surface 1a side, a current in a direction opposite to the direction of the current flowing through the wiring 41 is generated on the second surface 1b side according to Ampere's law. In particular, when high-frequency power is supplied to the wiring 41 formed on the first surface 1a side, a current in a direction opposite to the direction of the current flowing through the wiring 41 is generated on the second surface 1b side according to Ampere's law. This current is called a return current. The return current functions as a signal ground. In particular, when an antenna loop is formed by the wiring 41 and a ground surface, the return current effectively functions as a signal ground by reducing the size of the formed antenna loop. As a result, unnecessary noise is less likely to occur.

### <Antenna Device>

Next, an antenna device 101 of the present embodiment will be described. The antenna device 101 includes the above-described circuit board 100 and an antenna element 102 connected to the circuit board 100. The antenna device 101 of the present embodiment can also be referred to as an antenna substrate, and the terms "device" and "substrate" used in the present description are not bound by their strict meanings, and are to be interpreted to include a range in which similar functions can be expected. The antenna device 101 is, for example, a patch antenna. When the antenna device 101 is a patch antenna, the circuit board 100 functions as a dielectric board of the patch antenna. When the antenna device 101 is a patch antenna, the wiring 41 of the patch antenna may be formed so as to extend to a feeding point in order to pass a current, in particular, a high-frequency current. When the antenna device 101 is a patch antenna, a method for supplying power by electromagnetic coupling may be employed for the patch antenna. In this case, the wiring 41 of the patch antenna is not necessarily directly connected to the feeding point.

Fig. 6C is a perspective view showing an example of the antenna device 101 of the present embodiment. The antenna device 101 shown in Fig. 6C includes the above-described circuit board 100 and the antenna element 102 connected to the circuit board 100. The antenna element 102 is connected to the wiring 41 included in the circuit board 100 and forming the wiring pattern. In the example shown in Fig. 6C, the wiring 41 of the circuit board 100 and the antenna element 102 are integrated. In the example shown in Fig. 6C, the antenna device 101 includes the hollow-structure film 1 (the hollow-structure film 1 shown in Fig. 1) including the main body portion 1c, the wiring pattern of the wiring 41, and the antenna element 102. The wiring pattern of the wiring 41 and the antenna element 102 are provided on the first surface 1a of the hollow-structure film 1. In the example shown in Fig. 6C, the antenna device 101 includes the hollow-structure film 1, the wiring pattern of the wiring 41 provided on the first surface 1a of the hollow-structure film 1, and the metal layer 40 provided on the second surface 1b of the hollow-structure film 1 and having no wiring pattern formed thereon. Since the antenna device 101 includes the metal layer 40 provided on the second surface 1b and having no wiring pattern formed thereon, unnecessary noise is less likely to occur when an electric signal is transmitted via the wiring 41. The reason why unnecessary noise is less likely to be generated due to the metal layer 40 provided on the second surface 1b and having no wiring pattern formed thereon is considered as follows. When a current flows through the wiring 41 formed on the first surface 1a side, a current (the above-described return current) in a direction opposite to the direction of the current flowing through the wiring 41 is generated on the second surface 1b side according to Ampere's law. In particular, when high-frequency power is supplied to the wiring 41 formed on the first surface 1a side, a return current is generated on the second surface 1b side. The return current functions as a signal ground. In particular, when an antenna loop is formed by the wiring 41 and a ground surface, the return current effectively functions as a signal ground by reducing the size of the formed antenna loop. As a result, unnecessary noise is less likely to occur.

The antenna element 102 shown in Fig. 6C has a rectangular shape when observed in the thickness direction of the hollow-structure film 1. In the example shown in Fig. 6C, the wiring 41 extends from one side of the antenna element 102 to an end edge of the antenna device 101.

The antenna device 101 shown in Fig. 6C can be manufactured from the hollow-structure film 1 shown in Fig. 5. To be specific, by forming the wiring pattern of the wiring 41 and the antenna element 102 from the metal layer 40 constituting the first surface 1a of the hollow-structure film 1 shown in Fig. 5, the antenna device 101 shown in Fig. 6C can be manufactured.

### <Method for Manufacturing Hollow-structure Film>

A method for manufacturing the hollow-structure film 1 of the present embodiment will be described. Unless otherwise specified, as the method for manufacturing the hollow-structure film 1 of the present embodiment, a method for manufacturing the hollow-structure film 1, such as that shown in Fig. 5, in which the metal layer 40 constitutes the first surface 1a and the second surface 1b will be described. The method for manufacturing a hollow-structure film having a hollow structure according to the present embodiment includes a step of producing, with the mold 90, a pair of the single-sided shaped bodies 80 each including a sheet-shaped base portion 81 and a plurality of projecting portions 82 formed on one surface of the base portion 81, and a step of overlapping the produced pair of single-sided shaped bodies 80 such that the plurality of projecting portions 82 face each other at least partially and thermocompression-bonding the single-sided shaped bodies 80 to each other. The method for manufacturing a hollow-structure film of the present embodiment further includes a crosslinking step of causing a compound contained in the single-sided shaped bodies 80 and having a double bond active to radiation to react with a resin. When the compound having a double bond active to radiation is an electron beam crosslinking agent, the electron beam crosslinking agent contained in the single-sided shaped bodies 80 is irradiated with an electron beam in the crosslinking step to cause the compound to react with the resin. Even when the hollow-structure film 1 does not contain an electron beam crosslinking agent, preferable physical properties can be obtained in some cases by performing irradiation with an electron beam in a manufacturing step. For example, even when the hollow-structure film 1 does not contain an electron beam crosslinking agent, the heat resistance of the hollow-structure film 1 can be increased in some cases by performing irradiation with an electron beam in a manufacturing step. In such cases, the hollow-structure film 1 does not necessarily contain an electron beam crosslinking agent.

In the step of producing the single-sided shaped bodies 80, a pair of the single-sided shaped bodies 80 are produced using the mold 90. At this time, metal foil 42 as the material of the metal layer 40 is prepared. Further, a material of the shaped-body corresponding portion 13 is prepared. Further, a material of the metal adjacent layer 60 is prepared. In the present embodiment, the shaped-body corresponding portion 13 of the hollow-structure film 1 to be manufactured contains a resin. In this case, for example, raw material pellets of a corresponding resin are prepared as a material of the shaped-body corresponding portion 13. When the shaped-body corresponding portion 13 of the hollow-structure film 1 to be manufactured contains polyethylene, polyethylene raw material pellets are prepared as the material of the shaped-body corresponding portion 13. When the shaped-body corresponding portion 13 of the hollow-structure film 1 to be manufactured contains the particles 50, the particles 50 are prepared as the material of the shaped-body corresponding portion 13. When the shaped-body corresponding portion 13 of the hollow-structure film 1 to be manufactured contains a compound having a double bond active to radiation, the compound is prepared as a material of the shaped-body corresponding portion 13. When the shaped-body corresponding portion 13 contains a plurality of materials, the plurality of materials are mixed to prepare a mixture. When the shaped-body corresponding portion 13 of the hollow-structure film 1 to be manufactured contains a resin, the particles 50, and a compound having a double bond active to radiation, a mixture of the resin, the particles 50, and the compound is prepared.

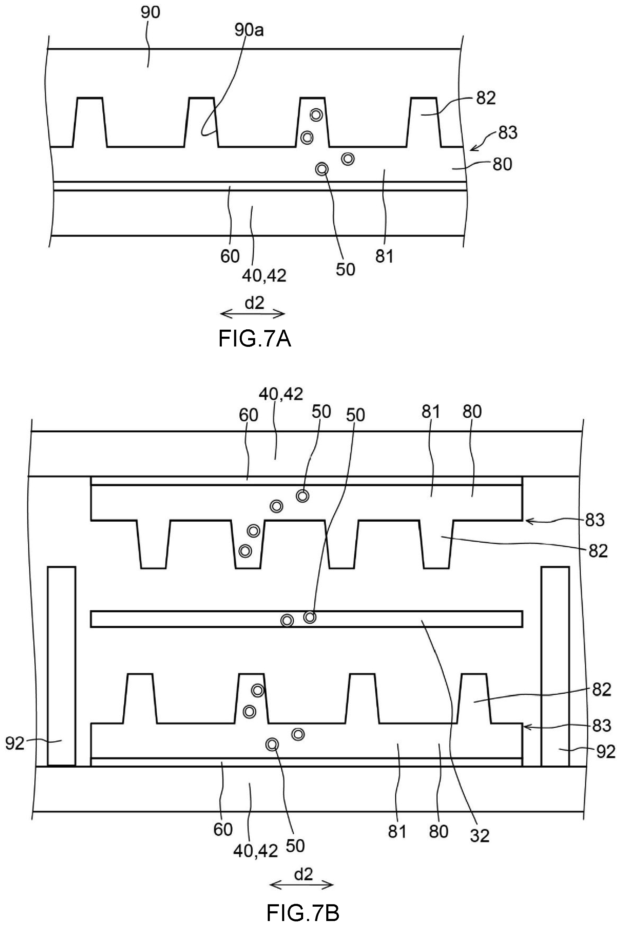

Subsequently, as shown in Fig. 7A, the material of the shaped-body corresponding portion 13 is molded with the mold 90. When the shaped-body corresponding portion 13 of the hollow-structure film 1 to be manufactured contains a resin, the particles 50, and a compound having a double bond active to radiation, a mixture of the resin, the particles 50, and the compound is molded using the mold 90. Molding of the mixture is performed while melting the resin contained in the mixture. The mold 90 has a surface 90a having a shape corresponding to the shape of the single-sided shaped body 80 to be produced. In particular, the surface 90a of the mold 90 has a shape corresponding to the shape of the surface of the single-sided shaped body 80 to be produced and on which the plurality of projecting portions 82 are formed. By molding the material of the shaped-body corresponding portion 13 with such a mold 90, the single-sided shaped body 80 including the sheet-shaped base portion 81 and the plurality of projecting portions 82 formed on one surface of the base portion 81 is produced from the material of the shaped-body corresponding portion 13. In the present embodiment, the material of the shaped-body corresponding portion 13 and the material of the metal adjacent layer 60 are molded on the metal foil 42 by co-extrusion molding using the mold 90. As a result, the metal adjacent layer 60 is produced from the material of the metal adjacent layer 60 on the metal foil 42, which is the metal layer 40, and the single-sided shaped body 80 is produced from the material of the shaped-body corresponding portion 13 on the metal adjacent layer 60. In this way, a laminate 83 in which the metal layer 40, the metal adjacent layer 60, and the single-sided shaped body 80 are stacked in this order is produced. Further, another single-sided shaped body 80 is produced by the same method as the method for producing the above-mentioned single-sided shaped body 80. In the present embodiment, another laminate 83 is produced by the same method as the method for producing the laminate 83 described above.

In the case of manufacturing the hollow-structure film 1, such as that shown in Fig. 1 and Fig. 4, in which the first surface 1a and the second surface 1b are not constituted by the metal layer 40, the single-sided shaped body 80 or a laminate of the metal adjacent layer 60 and the single-sided shaped body 80 may be produced by the following method. Instead of the metal foil 42, a material of the shaped-body corresponding portion 13 or a laminate of the material of the shaped-body corresponding portion 13 and a material of the metal adjacent layer 60 is formed on a peelable substrate. Thereafter, the substrate is peeled off. In this case, for example, a polyimide film can be used as the peelable substrate. In particular, Kapton (registered trade mark) manufactured by Du Pont-Toray Co., Ltd. can be used as the peelable substrate. When a peelable substrate is used, the substrate may be peeled before the step of thermocompression-bonding the pair of single-sided shaped bodies 80 or may be peeled after the step of thermocompression-bonding the pair of single-sided shaped bodies 80. When a peelable substrate is used, the substrate may be peeled before the crosslinking step or after the crosslinking step. As the peelable substrate, a PET (polyethylene terephthalate) film can also be used. Specific examples of the peelable PET film include COSMOSHINE (registered trade mark) and COSMOPEEL (registered trade mark) manufactured by Toyobo Co., Ltd.

Subsequently, a step of thermocompression-bonding the pair of single-sided shaped bodies 80 is performed. In this step, as shown in Fig. 7B, the pair of single-sided shaped bodies 80 are overlapped such that the plurality of projecting portions 82 face each other at least partially. The pair of single-sided shaped bodies 80 are overlapped such that respective surfaces on each of which the plurality of projecting portions 82 are formed face each other. In the present embodiment, a pair of the laminates 83 including the single-sided shaped bodies 80 are overlapped such that the plurality of projecting portions 82 of the pair of single-sided shaped bodies 80 face each other at least partially.

The hollow-structure film 1 shown in Fig. 5 includes the sheet-shaped central portion 30 that overlaps the first base portion 11 and the second base portion 12 and that is located between the first facing surface 11a and the second facing surface 12a. When such a hollow-structure film 1 is manufactured, the material of the central portion 30 is prepared before the step of thermocompression bonding the pair of single-sided shaped bodies 80. In the present embodiment, the central portion 30 of the hollow-structure film 1 to be manufactured contains a resin. Further, the central portion 30 of the hollow-structure film 1 to be manufactured contains the particles 50. Further, the central portion 30 of the hollow-structure film 1 to be manufactured contains a compound having a double bond active to radiation. In this case, as the material of the central portion 30, a resin sheet 32 molded into a sheet shape and in which the particles 50 and the compound are dispersed in a resin can be used. As an example, the resin contained in the central portion 30 has a lower melting point than the resin contained in the shaped-body corresponding portion 13. When the hollow-structure film 1 including the central portion 30 is manufactured, the resin sheet 32 is disposed, as shown in Fig. 7B, between the pair of single-sided shaped bodies 80 when the pair of single-sided shaped bodies 80 are overlapped.

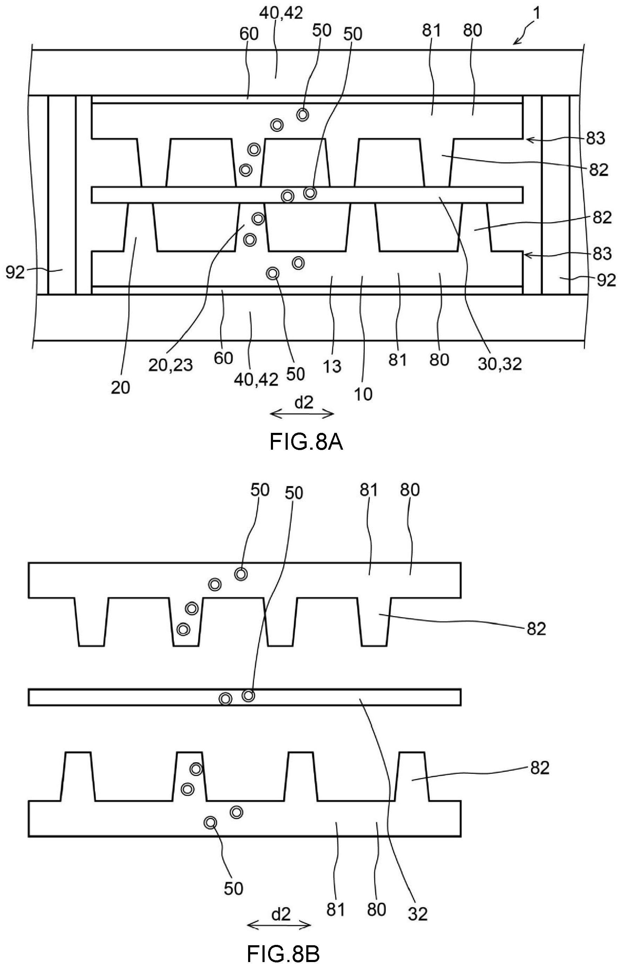

Subsequently, as shown in Fig. 8A, the pair of single-sided shaped bodies 80 are thermocompression-bonded. As a result, the pair of single-sided shaped bodies 80 are bonded to each other. As shown in Fig. 7B, when the resin sheet 32 is disposed between the pair of single-sided shaped bodies 80, the pair of single-sided shaped bodies 80 are bonded at the plurality of projecting portions 82 to the resin sheet 32 by thermocompression-bonding the pair of single-sided shaped bodies 80 as shown in Fig. 8A. As a result, the pair of single-sided shaped bodies 80 are bonded via the resin sheet 32. At this time, a part of the plurality of pillar portions 20 extending from the first facing surface 11a to the second facing surface 12a is formed at a part of the pair of single-sided shaped bodies 80 overlapped such that a plurality of the projecting portions 82 face each other. In particular, the continuous pillar portion 23 is formed at a part of the pair of single-sided shaped bodies 80 overlapped such that the plurality of projecting portions 82 face each other. As a result, the shaped-body corresponding portion 13 is formed from the pair of single-sided shaped bodies 80. Further, the central portion 30 is formed from the resin sheet 32. Further, a pair of the base portions 10 (the first base portion 11 and the second base portion 12) are formed from the base portions 81 of the single-sided shaped bodies 80.

The heating temperature when the pair of single-sided shaped bodies 80 are thermocompression-bonded is higher than the Vicat softening temperature of the resin contained in the central portion 30. In particular, as described above, when the resin contained in the central portion 30 is linear low-density polyethylene, the heating temperature when the pair of single-sided shaped bodies 80 are thermocompression-bonded is higher than the Vicat softening temperature of the linear low-density polyethylene. As a result, the resin sheet 32 is softened by the thermocompression bonding, and the pair of single-sided shaped bodies 80 can be bonded to the resin sheet 32. In this case, as described above, since the resin contained in the central portion 30 has a melting point lower than that of the resin contained in the shaped-body corresponding portion 13, a large deformation of the single-sided shaped bodies 80 due to heating can be suppressed when the resin contained in the central portion 30 is heated to a temperature higher than the Vicat softening temperature. The heating temperature when the pair of single-sided shaped bodies 80 are thermocompression-bonded can be set to be equal to or lower than the Vicat softening point of the resin contained in the single-sided shaped bodies 80. When the pair of single-sided shaped bodies 80 are to be thermocompression-bonded, a spacer 92 such as that shown in Fig. 8A may be used. The spacer 92 controls the pair of single-sided shaped bodies 80 not to approach each other by a certain distance or more when the pair of single-sided shaped bodies 80 are caused to approach each other in thermocompression bonding of the pair of single-sided shaped bodies 80. The thickness of the hollow-structure film 1 to be manufactured can be adjusted by the spacer 92.

In the step of thermocompression-bonding the pair of single-sided shaped bodies 80, the pair of single-sided shaped bodies 80 may be thermocompression-bonded by the following method, instead of the above-described method using the spacer 92. First, a pair of the single-sided shaped bodies 80 are each processed into a film shape having a certain length or more. Subsequently, the pair of single-sided shaped bodies 80 are overlapped such that the plurality of projecting portions 82 face each other at least partially. Subsequently, the pair of single-sided shaped bodies 80 in a mutually overlapped state are passed between two heated rolls. In this case, when the hollow-structure film 1 including the central portion 30 is to be manufactured, the resin sheet 32 having a certain length or more is prepared and is interposed between the pair of overlapped single-sided shaped bodies 80. In this state, the pair of single-sided shaped bodies 80 and the resin sheet 32 are passed between the two heated rolls. The pair of single-sided shaped bodies 80 may be thermocompression-bonded by the above method. When the method using the two rolls is employed, the thickness of the hollow-structure film 1 to be manufactured can be adjusted to a suitable thickness by, instead of using the spacer 92, adjusting the space between the two rolls.

Subsequently, the crosslinking step of causing a compound having a double bond active to radiation and a resin, the compound and the resin being contained in the single-sided shaped bodies 80, to react with each other is performed. When the compound that has the double bond active to radiation and that is contained in the single-sided shaped bodies 80 is an electron beam crosslinking agent, the electron beam crosslinking agent is irradiated with an electron beam in the crosslinking step to cause the compound to react with the resin. In this case, conditions of the electron beam for irradiation in the crosslinking step are, for example, as follows. The irradiation dose of the electron beam is, for example, 5 kGy or more and 500 kGy or less (0.5 Mrad or more and 50 Mrad or less), and preferably 10 kGy or more and 300 kGy or less (1 Mrad or more and 30 Mrad or less). The irradiation dose of the electron beam is, for example, 200 kGy (20 Mrad). The accelerating voltage of the electron beam is, for example, 165 kV. When the resin sheet 32 obtained by dispersing a compound having a radiation-active double bond in a resin and molding the resin into a sheet shape is used as the material of the central portion 30, the compound contained in the resin sheet 32 may be caused to react with the resin in the crosslinking step. In this case, the method for causing the compound and the resin that are contained in the resin sheet 32 to react with each other is the same as the method for causing the compound and the resin that are contained in the single-sided shaped bodies 80 to react with each other. Thus, the hollow-structure film 1 shown in Fig. 5 is manufactured.

The circuit board 100, such as that described above, including the hollow-structure film 1 and the wiring pattern can be manufactured by, for example, the following method. The metal layer 40 is formed such that the entirety of a surface of the hollow-structure film 1 on which the wiring pattern is to be formed is formed by the metal layer 40. For example, when the laminate 83, such as that shown in Fig. 7A, in which the metal layer 40 and the single-sided shaped body 80 are stacked is to be produced, the laminate 83 is produced such that the entirety of a surface of the single-sided shaped body 80 on which the plurality of projecting portions 82 are not formed is covered with the metal layer 40. By manufacturing the hollow-structure film 1 with the laminate 83, the entirety of a surface of the hollow-structure film 1 on which the wiring pattern is to be formed is formed by the metal layer 40. As the metal layer 40, for example, a copper layer can be formed. In one example, the metal layer 40 is bonded to the single-sided shaped body 80 via the metal adjacent layer 60. A wiring pattern can be formed from at least a portion of the metal layer 40 by covering the thus formed metal layer 40 with a mask layer and then etching the metal layer 40. More specifically, the wiring pattern can be formed from at least a portion of the metal layer 40 by, for example, etching the metal layer 40 by using, as a mask, a dry film resist (DFR) having a pattern formed thereon. As a result, the circuit board 100 including the hollow-structure film 1 and the wiring pattern can be manufactured.

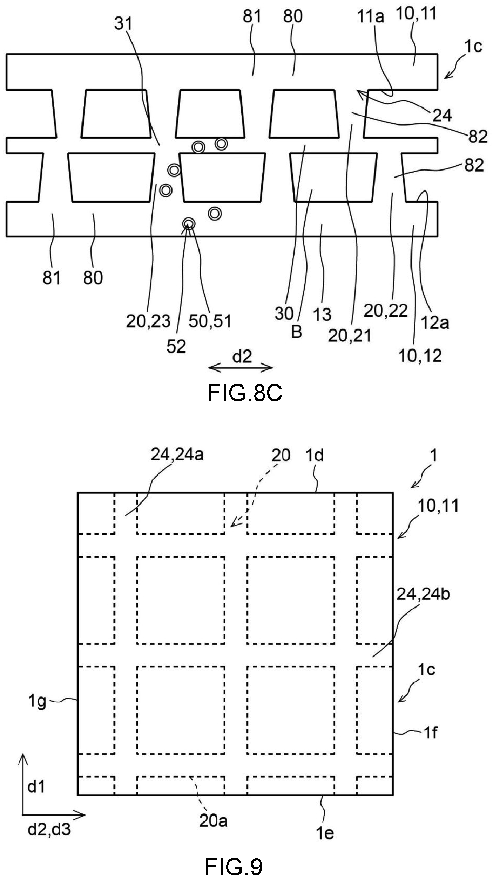

The circuit board 100 including the hollow-structure film 1 and the wiring pattern may be manufactured by the following method. First, as shown in Fig. 8B, the single-sided shaped bodies 80 are formed. The pair of single-sided shaped bodies 80 shown in Fig. 8B each have the same shape as the single-sided shaped body 80 included in the laminate 83 shown in Fig. 7A. Subsequently, a step of thermocompression-bonding the pair of single-sided shaped bodies 80 is performed. As one example, as shown in Fig. 8B, the resin sheet 32 is disposed between the pair of single-sided shaped bodies 80 in this step. Subsequently, as shown in Fig. 8C, the pair of single-sided shaped bodies 80 are thermocompression-bonded. As a result, the pair of single-sided shaped bodies 80 are bonded to each other. Subsequently, the metal layer 40 is formed so as to cover the entirety of surfaces of the single-sided shaped bodies 80 on which the plurality of projecting portions 82 are not formed. As an example, the metal layer 40 is bonded to the single-sided shaped body 80 via the metal adjacent layer 60. By etching the thus formed metal layer 40 by the above-described method or the like, a wiring pattern can be formed from at least a portion of the metal layer 40. Thus, the circuit board 100, such as that described above, including the hollow-structure film 1 and the wiring pattern can be manufactured.

The wiring pattern may be formed by attaching already formed copper wiring to the base portion 10. The wiring pattern may be formed by forming a pattern of a plated seed layer by printing including ink jet, and then performing plating up.

The antenna device 101 shown in Fig. 6C can be manufactured by forming the wiring 41 and the antenna element 102 from the metal layer 40 constituting at least a portion of the first surface 1a of the hollow-structure film 1 such as that shown in Fig. 5. A method for forming the wiring 41 and the antenna element 102 from the metal layer 40 can be the same as the method for forming the wiring pattern from the metal layer 40 in the above-described method for manufacturing the circuit board 100.

The wiring pattern may be formed by printing using a conductive ink. The wiring pattern may be formed by processing with a metal 3D printer.

The hollow-structure film 1 of the present embodiment includes the sheet-shaped first base portion 11, the sheet-shaped second base portion 12 overlapping the first base portion 11, and the plurality of pillar portions 20 provided between the first base portion 11 and the second base portion 12. The first base portion 11 has the first facing surface 11a that faces the second base portion 12. The second base portion 12 has the second facing surface 12a that faces the first base portion 11. At least a part of the plurality of pillar portions 20 constitutes the continuous pillar portion 23 extending from the first facing surface 11a to the second facing surface 12a. Thus, the plurality of hollow portions B are formed between the first base portion 11 and the second base portion 12. Therefore, the hollow-structure film 1 has a hollow structure. According to such a hollow-structure film 1, it is possible to reduce the dielectric constant of the hollow-structure film 1 while hardly being limited by the material of the hollow-structure film 1. Further, according to such a hollow-structure film 1, the dielectric loss tangent of the hollow-structure film 1 can be lowered by the hollow structure. The dielectric loss tangent indicates the amount of an electric signal propagating in a dielectric and being converted into heat and lost. When the hollow-structure film 1 is used for a circuit board designed on the premise of communication, the lower the value of the dielectric loss tangent of the hollow-structure film 1, the more the signal loss can be reduced to improve the transmission rate of an electric signal.

The effect of the low values of the dielectric constant and the dielectric loss tangent of the hollow-structure film 1 will be described in more detail. There is a demand for an increase in the frequency of electric signals handled in information communication devices and the like such as smartphones and tablet terminals. Along with the increase in the frequency of the electric signals, the transmission loss in the circuit board designed on the premise of communication increases (the value of the transmission loss having a negative value moves away from zero). On the other hand, it is known that the transmission loss, in particular, the dielectric loss can be reduced (the value of the transmission loss having a negative value approaches zero) by reducing the value of the dielectric constant or the dielectric loss tangent of the circuit board. The dielectric loss is expressed by the following formula (1). In Formula (1), αd is a dielectric loss, K is a proportional constant, f is a frequency, εγ is a relative dielectric constant, and tanδ is a dielectric loss tangent. The relative dielectric constant εγ is the ratio of the dielectric constant of an object, such as a circuit board, to the dielectric constant of vacuum.
[Math. 2] ${α}_{d} = K \times f \times \sqrt{{ε}_{γ}} \times tanδ$ Formula (1)

It can be understood from Formula (1) that the dielectric loss can be reduced by reducing the values of the dielectric constant and the dielectric loss tangent of a circuit board. In particular, it can be understood that, even when the value of the frequency is increased, that is, even when the frequency of an electric signal is increased, the dielectric loss can be reduced by reducing the values of the dielectric constant and the dielectric loss tangent of the circuit board. As described above, in particular, by using the hollow-structure film 1 of the present embodiment in a circuit board designed on the premise of communication, it is possible to reduce signal loss and improve the transmission rate of an electric signal. In particular, in a circuit board that handles high-frequency electric signals, it is required to lower the values of the dielectric constant and the dielectric loss tangent. Therefore, the hollow-structure film 1 of the present embodiment is suitably used in a circuit board that handles high-frequency electric signals. The hollow-structure film 1 of the present embodiment is suitably used, for example, in circuit boards that handle electric signals at frequencies of 6 GHz or higher, in particular, 26 GHz or higher, and, in particular, 60 GHz or higher. The hollow-structure film 1 of the present embodiment may be used for circuit boards that handle electric signals at frequencies of 6 GHz or higher and 39 GHz or lower, in particular, 26 GHz or higher and 39 GHz or lower. The hollow-structure film 1 of the present embodiment may be used for circuit boards that handle electric signals at frequencies of 60 GHz or higher and 80 GHz or lower.

As a sheet having a low dielectric constant, for example, a sheet, such as the low-dielectric sheet for two-dimensional communication disclosed in Japanese Patent No. 5976714, manufactured by forming a resin foam containing bubbles is also known. Examples of the sheet that is a resin foam containing bubbles include SOFTLON manufactured by Sekisui Chemical Co., Ltd. and SKYBOND (registered trade mark) FOAM manufactured by I.S.T. Corporation. However, the hollow-structure film 1 of the present embodiment is clearly different from a sheet that is formed of a resin foam in that the hollow-structure film 1 includes a plurality of the pillar portions 20, and, in particular, at least a part of the plurality of pillar portions 20 constitutes the continuous pillar portion 23. The hollow-structure film 1 of the present embodiment has a greater hardness than a sheet formed of a resin foam because the hollow-structure film 1 includes the plurality of pillar portions 20. In particular, the hollow-structure film 1 of the present embodiment has a higher indentation hardness than a sheet formed of a resin foam. As described above, the hollow-structure film 1 of the present embodiment is clearly different from a sheet formed of a resin foam in physical properties such as hardness. Since a resin foam sheet is flexible and easily bendable, it is considered to be difficult to use the resin foam sheet for forming the circuit board 100 of the antenna device 101 or the like. As described above, according to the hollow-structure film 1 of the present embodiment, it is possible to provide a film having a low dielectric constant while ensuring strength.

The hollow-structure film 1 of the present embodiment further includes the sheet-shaped central portion 30 that overlaps the first base portion 11 and the second base portion 12 and that is located between the first facing surface 11a and the second facing surface 12a. Thus, the strength of the hollow-structure film 1 can be further increased.

The hollow-structure film 1 of the present embodiment includes the main body portion 1c. The main body portion 1c includes the first base portion 11, the second base portion 12, the plurality of pillar portions 20, and the sheet-shaped central portion 30 located between the first facing surface 11a and the second facing surface 12a. The plurality of pillar portions 20 are located on the first facing surface 11a side and the second facing surface 12a side of the central portion 30. Thus, the strength of the hollow-structure film 1 can be further increased.

The hollow-structure film 1 of the present embodiment contains the glass particles 51. This makes it possible to further reduce the amount of shrinkage of the hollow-structure film 1 after processing by heating is performed.

In the hollow-structure film 1 of the present embodiment, each of the glass particles 51 has the hollow portion 52. This makes it possible to further reduce the amount of shrinkage of the hollow-structure film 1 after processing by heating is performed.

The hollow-structure film 1 of the present embodiment has the first surface 1a and the second surface 1b opposite to the first surface 1a. The hollow-structure film 1 of the present embodiment further includes the metal layer 40 constituting at least a portion of at least one of the first surface 1a and the second surface 1b. Thus, the wiring 41 can be formed from the metal layer 40 by forming a wiring pattern on the metal layer 40.

The hollow-structure film 1 of the present embodiment further includes the metal adjacent layer 60 that bonds the metal layer 40 to the base portions 10. Thus, the metal layer 40 can be more firmly bonded to the base portions 10.

The circuit board 100 of the present embodiment includes the above-described hollow-structure film 1, the hollow-structure film 1 having the first surface 1a, the second surface 1b opposite to the first surface 1a, and the wiring pattern provided on at least one of the first surface 1a and the second surface 1b. Thus, the dielectric constant of the circuit board 100 can be reduced.

The antenna device 101 of the present embodiment includes the above-described circuit board 100 and the antenna element connected to the circuit board 100. Thus, the dielectric constant of the circuit board 100 can be reduced. Therefore, the transmission loss in the circuit board can be reduced (the value of the transmission loss having a negative value can be brought close to zero).

Effects of the present embodiment will be described from the viewpoint of the relationship with the related art. As a technique for making the dielectric constant of a circuit board or the like lower than that in the related art, a technique of using, as a material of the circuit board or the like, a material having a low dielectric constant is known (see, for example, Japanese Unexamined Patent Publication No. 2023-121649).

Japanese Unexamined Patent Publication No. 2023-121649 describes a technique of using a polyimide film as a material applied to a high-frequency board or the like to lower the relative dielectric constant of the material.

However, when the dielectric constant of a film used for a circuit board is reduced by using a material having a low dielectric constant as a material, inconvenience may occur due to the fact that a specific material has to be used. For example, costs required for manufacturing the circuit board may increase. For this reason, a film used for a circuit board has been required to have a low dielectric constant while being less likely to be limited by a material.

According to the present embodiment, a film that has a low dielectric constant and that is not easily limited by a material can be provided.

### <Modifications>

Next, various modifications of the present embodiment will be described with reference to Figs. 9 to 12. In Figs. 9 to 12, parts identical to those of the embodiments shown in Figs. 1 to 8C are denoted by identical signs, and the detailed description thereof will be omitted.

### <Modification 1>

In the above-described embodiment, the hollow-structure film 1, such as that shown in Fig. 2, in which the base portions 10 include the plurality of connection portions 24 extending in the first direction d1 and do not include the connection portions 24 extending in a direction other than the first direction d1 has been described. Further, the hollow-structure film 1 that includes the plurality of pillar portions 20 extending in the first direction d1 and that does not include the pillar portions 20 extending in a direction other than the first direction d1 has been described. However, directions in which the connection portions 24 and the pillar portions 20 extend are not limited to the above-described examples. Fig. 9 corresponds to Fig. 2 and is a plan view showing a state in which the base portion 10 in Modification 1 is observed in the thickness direction of the hollow-structure film 1. In the example shown in Fig. 9, the base portion 10 includes a plurality of the connection portions 24. In the example shown in Fig. 9, the base portion 10 includes, as the plurality of connection portions 24, first connection portions 24a extending in the first direction d1. In addition, in the example shown in Fig. 9, the base portion 10 includes, as the plurality of connection portions 24, second connection portions 24b extending in a third direction d3 that is perpendicular to the thickness direction of the hollow-structure film 1 and that is different from the first direction d1. In the example shown in Fig. 9, the third direction d3 is a direction perpendicular to the first direction d1. In other words, the third direction d3 coincides with the second direction d2. Due to the base portion 10 including the first connection portions 24a and the second connection portions 24b as the plurality of connection portions 24, the hollow-structure film 1 of Modification 1 includes a plurality of the pillar portions 20 extending in the first direction d1 and a plurality of the pillar portions 20 extending in the third direction d3. The hollow-structure film 1 including the base portion 10, which has such connection portions 24, and the pillar portions 20 can also form a hollow structure to suppress the dielectric constant to be low.

The hollow-structure film 1 of Modification 1 includes a plurality of the pillar portions 20 extending in the first direction d1 and a plurality of the pillar portions 20 extending in the third direction d3. In such a hollow-structure film 1, the angle θ1, the angle θ2, and the porosity described above are measured, in a cross section cut along a plane that passes through the plurality of pillar portions 20 and that is perpendicular to the first direction d1, at a portion where the plurality of pillar portions 20 extending in the third direction d3 do not appear.

### <Modification 2>

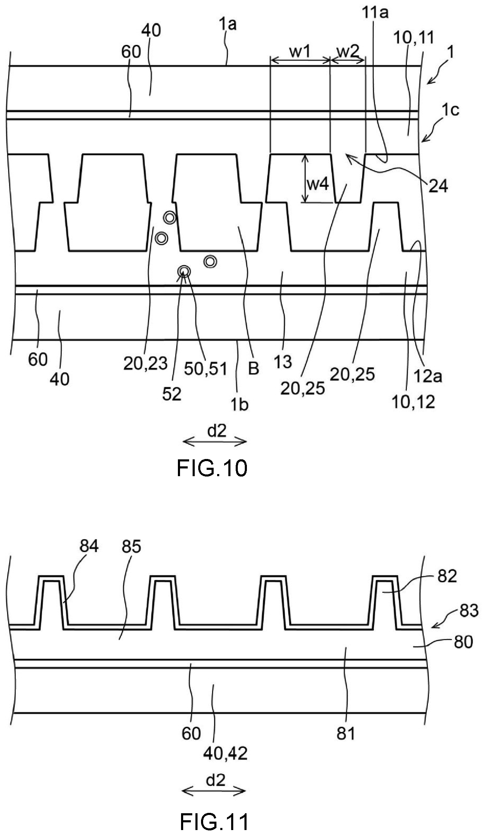

In the above-described embodiment, the hollow-structure film 1, such as that shown in Fig. 1, including the central portion 30 has been described. However, the hollow-structure film 1 does not necessarily include the central portion 30. Fig. 10 corresponds to Fig. 1 and is a cross-sectional view of the hollow-structure film 1 of Modification 2 taken along a cross section parallel to the thickness direction of the hollow-structure film 1. In the example shown in Fig. 10, the hollow-structure film 1 does not include the central portion 30. In the example shown in Fig. 10, at least a part of the plurality of pillar portions 20 extends in the thickness direction of the hollow-structure film 1 from the first facing surface 11a to the second facing surface 12a. In the example shown in Fig. 10, a part of the plurality of pillar portions 20 constitutes the continuous pillar portion 23. A part of the plurality of pillar portions 20 not constituting the continuous pillar portion 23 constitutes a projecting portion 25 projecting from the first facing surface 11a toward the second facing surface 12a or projecting from the second facing surface 12a toward the first facing surface 11a.

The height of the projecting portion 25 (the dimension of the projecting portion 25 in the thickness direction of the hollow-structure film 1) in the hollow-structure film 1, such as that shown in Fig. 10, in which a part of the plurality of pillar portions 20 constitutes the projecting portion 25 is defined as a height w4. At this time, the height w4 is preferably not less than 0.5 times and not more than 10 times the width w2 of the connection portion 24 in the second direction d2. When the height w4 is more than or equal to 0.5 times the width w2, a particularly large size of each hollow portion B can be ensured, and the dielectric constant of the hollow-structure film 1 can be made particularly low. When the height w4 is less than or equal to 10 times the width w2, the strength of the hollow-structure film 1 can be made particularly high.

The hollow-structure film 1, such as that shown in Fig. 10, without the central portion 30 can be manufactured by the same method as the method for manufacturing the hollow-structure film 1 including the central portion 30 in the embodiment described above, except for the points described below. In the step for thermocompression-bonding the pair of single-sided shaped bodies 80, the pair of single-sided shaped bodies 80 are overlapped without the resin sheet 32 disposed between the pair of single-sided shaped bodies 80. Then, the pair of single-sided shaped bodies 80 are thermocompression-bonded. As a result, a plurality of mutually facing projecting portions 82 of the pair of single-sided shaped bodies 80 are bonded to each other. The continuous pillar portion 23 is formed by the mutually facing projecting portions 82 being bonded to each other. As a result, the pair of single-sided shaped bodies 80 are directly bonded to each other. Among the projecting portions 82 of one of the pair of single-sided shaped bodies 80, the projecting portions 82 not facing the projecting portions 82 of the other of the pair of single-sided shaped bodies 80 when the pair of single-sided shaped bodies 80 are overlapped each constitute the projecting portion 25 in the manufactured hollow-structure film 1. The heating temperature when the pair of single-sided shaped bodies 80 are thermocompression-bonded is adjusted to a temperature at which the single-sided shaped bodies 80 are softened and the pair of single-sided shaped bodies 80 can be directly bonded to each other.

The hollow-structure film 1 of Modification 2 can also form a hollow structure to suppress the dielectric constant to be low.

### <Modification 3>

When the hollow-structure film 1 not including the central portion 30 is to be manufactured, the hollow-structure film 1 may be manufactured using a pair of single-sided shaped bodies 80 described below. Fig. 11 is a view showing the single-sided shaped body 80 used in a method for manufacturing the hollow-structure film of Modification 3. In the example shown in Fig. 11, the single-sided shaped body 80 has a first layer 84 containing a first resin, and a second layer 85 overlapping the first layer 84 and containing a second resin. In the example shown in Fig. 11, a surface of the single-sided shaped body 80 on which a plurality of the projecting portions 82 are formed is constituted by the first layer 84. The thickness of the first layer 84 is constant. The second layer 85 constitutes the base portion 81 and a part of the plurality of projecting portions 82 that is not constituted by the first layer 84. The first resin contained in the first layer 84 has a melting point lower than that of the second resin contained in the second layer 85. With such a configuration, the first layer 84 can be sufficiently melted while the shape of the second layer 85 is maintained when the pair of single-sided shaped bodies 80 are thermocompression-bonded. As a result, the pair of single-sided shaped bodies 80 can be bonded to each other while deformation of the shape of the entirety of each single-sided shaped body 80 is less likely to occur. The first resin in Modification 3 is, for example, the same as the resin contained in the central portion 30 in the above-described embodiment. The material of the first layer 84 in Modification 3 may be the same as the material of the central portion 30 in the above-described embodiment. That is, the first layer 84 may contain the particles 50 that can be contained in the central portion 30 in the above-described embodiment. The first layer 84 may contain a compound that has a radiation-active double bond and that can be contained in the central portion 30 in the above-described embodiment. The second resin in Modification 3 is the same as, for example, the resin contained in the shaped-body corresponding portion 13 in the above-described embodiment.

The single-sided shaped body 80 shown in Fig. 11 can be produced by co-extrusion molding in which, with the same mold as the mold 90 shown in Fig. 7A, the material of the second layer 85 containing the second resin and the material of the first layer 84 containing the first resin are molded on the metal foil 42.

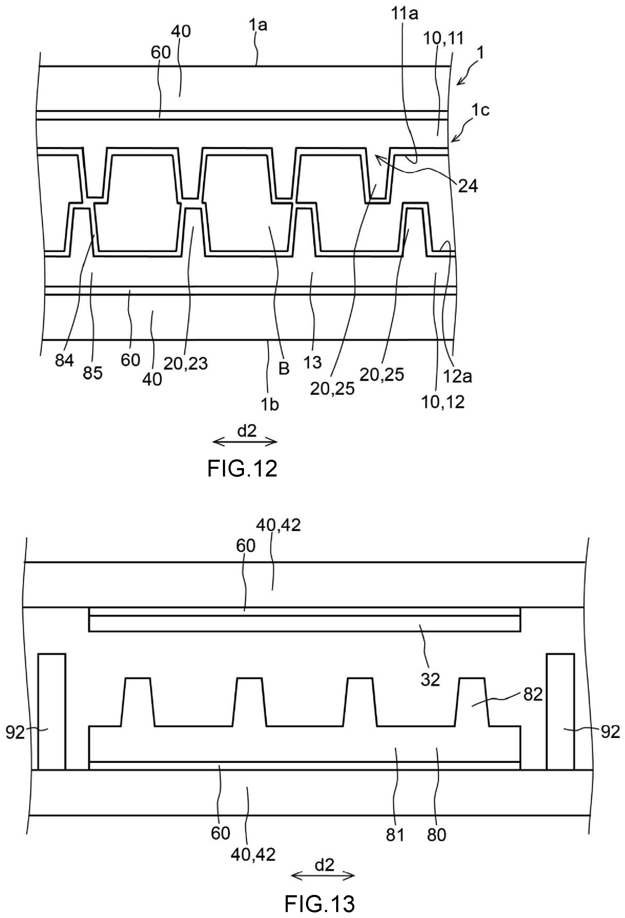

By using a pair of the single-sided shaped bodies 80 shown in Fig. 11, it is possible to manufacture the hollow-structure film 1, such as that shown in Fig. 12, without the central portion 30. In this case, the hollow-structure film 1 can be manufactured by the same method as the above-described method for manufacturing the hollow-structure film 1 of Modification 2 not including the central portion 30, except for the points described below. The heating temperature when the pair of single-sided shaped bodies 80 are thermocompression-bonded is adjusted to a temperature at which the first layer 84 of each single-sided shaped body 80 is softened and the pair of single-sided shaped bodies 80 can be directly bonded to each other. As an example, the heating temperature when the pair of single-sided shaped bodies 80 are thermocompression-bonded is higher than the Vicat softening temperature of the first resin contained in the first layer 84. As a result, the first layer 84 is softened by the thermocompression bonding, and a plurality of the mutually facing projecting portions 82 of the pair of single-sided shaped bodies 80 can be bonded to each other. In particular, the parts constituted by the first layers 84 of the plurality of mutually facing projecting portions 82 of the pair of single-sided shaped bodies 80 can be bonded to each other. In this case, as described above, since the first resin has a melting point lower than that of the second resin, when the first layer 84 is heated to a temperature equal to or higher than the Vicat softening temperature of the first resin, the second layer 85 can be suppressed so as not to greatly deform by the heating.

### <Modification 4>

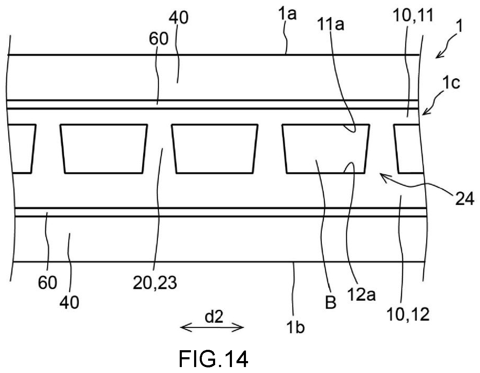

In the above-described embodiment and each modification, an example in which the hollow-structure film 1 is manufactured using two single-sided shaped bodies 80 is described. However, the method for manufacturing the hollow-structure film 1 is not limited thereto. The hollow-structure film 1 may be manufactured using one single-sided shaped body 80. Fig. 13 is a view showing a method for manufacturing a hollow-structure film of Modification 4. Fig. 14 is a view showing the hollow-structure film 1 manufactured by the method for manufacturing the hollow-structure film of Modification 4.

In the example shown in Fig. 13, the resin sheet 32 is disposed so as to face the surface of one single-sided shaped body 80 on which a plurality of the projecting portions 82 are formed. The method for manufacturing the hollow-structure film of Modification 4 includes a step of thermocompression-bonding the single-sided shaped body 80 and the resin sheet 32 that are disposed as shown in Fig. 13. Thus, the hollow-structure film 1, such as that shown in Fig. 14, including a pair of the base portions 10 and a plurality of the pillar portions 20 can be manufactured. At this time, the plurality of pillar portions 20 are formed from the plurality of projecting portions 82 of the single-sided shaped body 80. In the example shown in Fig. 14, the first base portion 11 is formed from the base portion 81 of the single-sided shaped body 80. In the example shown in Fig. 14, the second base portion 12 is formed from the resin sheet 32. Although not shown, the second base portion 12 may be formed from the base portion 81 of the single-sided shaped body 80 while the first base portion 11 is formed from the resin sheet 32.

When the single-sided shaped body 80 and the resin sheet 32 are to be thermocompression-bonded, the spacer 92, such as that shown in Fig. 13, may be used. When the single-sided shaped body 80 and the resin sheet 32 are to be thermocompression-bonded, the spacer 92 controls the single-sided shaped body 80 and the resin sheet 32 not to approach each other by a certain distance or more when the single-sided shaped body 80 and the resin sheet 32 are caused to approach each other. The thickness of the hollow-structure film 1 to be manufactured can be adjusted by the spacer 92.

As shown in Fig. 14, the hollow-structure film 1 of Modification 4 may include the metal layer 40 constituting at least a portion of at least one of the first surface 1a and the second surface 1b of the hollow-structure film 1. As shown in Fig. 14, the hollow-structure film 1 of Modification 4 may include the metal adjacent layer 60 that bonds the metal layer 40 to the base portions 10. In this case, the metal layer 40 may be bonded to the single-sided shaped body 80 or the resin sheet 32 via the metal adjacent layer 60 before the step of thermocompression-bonding the single-sided shaped body 80 and the resin sheet 32 or may be bonded to the base portions 10 via the metal adjacent layer 60 after the step of thermocompression-bonding the single-sided shaped body 80 and the resin sheet 32.

According to the method for manufacturing the hollow-structure film of Modification 4 and the hollow-structure film 1, the hollow-structure film 1 having a particularly small thickness can be provided.

### <Modification 5>

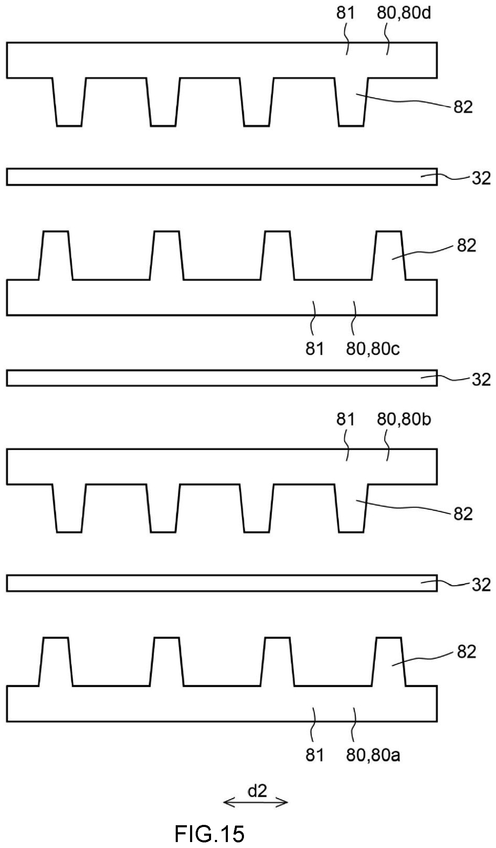

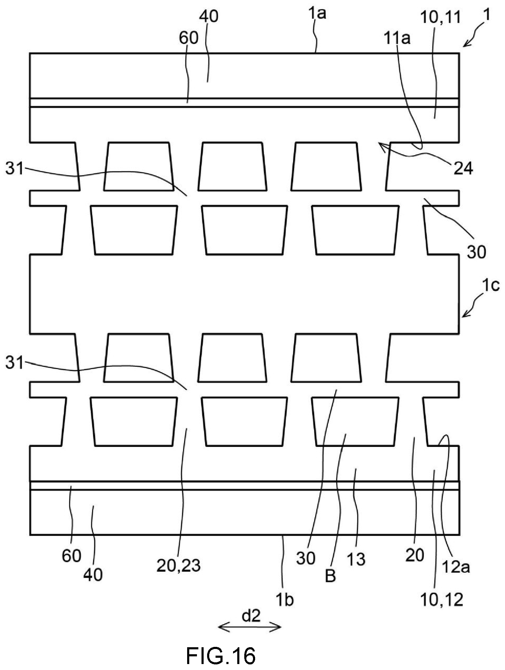

In the above-described embodiment and modifications, an example in which the hollow-structure film 1 is manufactured using two or less single-sided shaped bodies 80 is described. However, the method for manufacturing the hollow-structure film 1 is not limited thereto. The hollow-structure film 1 may be manufactured using three or more single-sided shaped bodies 80. Fig. 15 is a view showing members used in a method for manufacturing a hollow-structure film of Modification 5, the members being arranged in the order in which the members are overlapped to manufacture the hollow-structure film 1. Fig. 16 is a view showing a hollow-structure film 1 to be manufactured by the method for manufacturing the hollow-structure film of Modification 5.

In the example shown in Fig. 15, the members used in the method for manufacturing the hollow-structure film include four single-sided shaped bodies 80. The four single-sided shaped bodies 80 are overlapped in the thickness direction of the base portion 81. The members used in the method for manufacturing the hollow-structure film further include three resin sheets 32. The four single-sided shaped bodies 80 and the three resin sheets 32 are overlapped so as to be alternately arranged in the thickness direction of the base portion 81. The method for manufacturing the hollow-structure film of Modification 4 includes a step of thermocompression-bonding the single-sided shaped bodies 80 and the resin sheets 32 that are disposed as shown in Fig. 15. Thus, the hollow-structure film 1, such as that shown in Fig. 16, including a pair of the base portions 10 and a plurality of the pillar portions 20 can be manufactured. At this time, the plurality of pillar portions 20 are formed from a plurality of the projecting portions 82 of the plurality of single-sided shaped bodies 80. In particular, the continuous pillar portion 23 of the plurality of pillar portions 20 extending from the first facing surface 11a to the second facing surface 12a is formed at a part of the plurality of single-sided shaped bodies 80 overlapped such that a plurality of the projecting portions 82 face each other. A pair of the base portions 10 are formed from the base portions 81 of the pair of single-sided shaped bodies 80 positioned on the outermost side in the thickness direction of the base portion 81.

In the step of thermocompression-bonding the single-sided shaped bodies 80 and the resin sheets 32, the order of thermocompression-bonding of the plurality of single-sided shaped bodies 80 and the plurality of resin sheets 32 is not particularly limited. The hollow-structure film 1 may be manufactured by thermocompression-bonding all of the plurality of single-sided shaped bodies 80 and the plurality of resin sheets 32 simultaneously. The hollow-structure film 1 may be manufactured by repeating thermocompression-bonding of each single-sided shaped body 80 and each resin sheet 32 that are adjacent to each other. The hollow-structure film 1 shown in Fig. 16 may be manufactured by the following method. A first single-sided shaped body 80a and a second single-sided shaped body 80b shown in Fig. 15 are bonded to each other via a first resin sheet 32a. Further, a third single-sided shaped body 80c and a fourth single-sided shaped body 80d shown in Fig. 15 are bonded to each other via a second resin sheet 32b. Thereafter, the second single-sided shaped body 80b and the third single-sided shaped body 80c are bonded to each other via a third resin sheet 32c.

As shown in Fig. 16, the hollow-structure film 1 of Modification 5 may include the metal layer 40 constituting at least a portion of at least one of the first surface 1a and the second surface 1b of the hollow-structure film 1. As shown in Fig. 16, the hollow-structure film 1 of Modification 5 may include the metal adjacent layer 60 that bonds the metal layer 40 to the base portion 10. In this case, the metal layer 40 may be bonded to one of the single-sided shaped bodies 80 via the metal adjacent layer 60 before the step of thermocompression-bonding the single-sided shaped bodies 80 and the resin sheets 32 or may be bonded to the base portion 10 via the metal adjacent layer 60 after the step of thermocompression-bonding the single-sided shaped bodies 80 and the resin sheets 32.

According to the method for manufacturing the hollow-structure film of Modification 5 and the hollow-structure film 1, the hollow-structure film 1 having a particularly large thickness can be provided.

### <Modification 6>

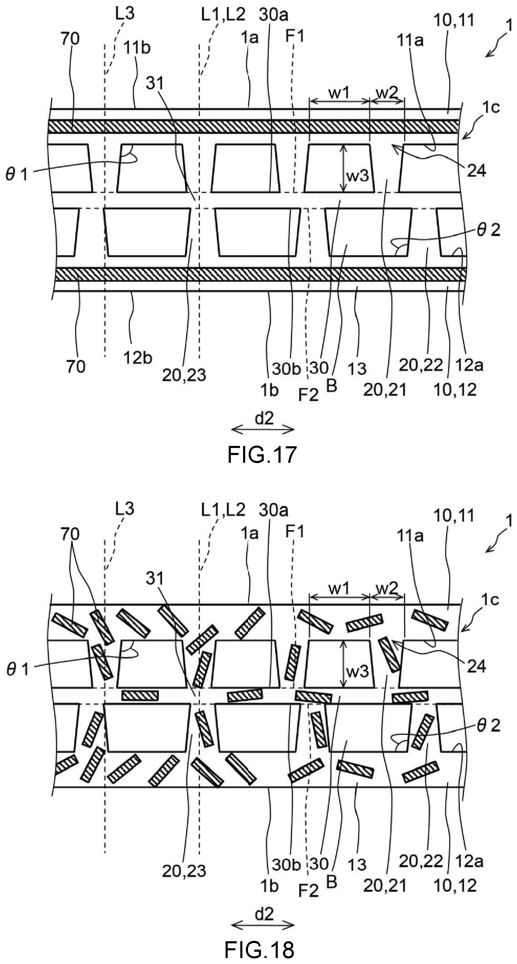

The main body portion 1c of the hollow-structure film 1 may include an insulating inorganic material member 70. The maximum width of the inorganic material member 70 is more than or equal to three times the minimum width of the inorganic material member. Fig. 17 is a cross-sectional view showing an example of the hollow-structure film 1 of Modification 6. Fig. 18 is a cross-sectional view showing an example of the hollow-structure film 1 of Modification 6, the example being different from the example shown in Fig. 17.

The inorganic material member 70 contains, for example, glass or a metal oxide. The inorganic material member 70 may contain glass. The inorganic material member 70 may contain a metal oxide. The metal oxide contained in the inorganic material member 70 is, for example, an aluminum oxide. The inorganic material member 70 may contain boehmite. The inorganic material member 70 may contain a ceramic material. When the inorganic material member 70 contains a ceramic material, a material having a dielectric constant and dielectric loss tangent that are sufficiently small is used as the ceramic material in consideration of sufficiently lowering the dielectric constant and dielectric loss tangent of the entire hollow-structure film 1.

The inorganic material member 70 may be included in at least one of the first base portion 11 and the second base portion 12. The inorganic material member 70 may be included in both the first base portion 11 and the second base portion 12. The inorganic material member 70 may be included in at least a part of the plurality of pillar portions 20. The inorganic material member 70 may be included in all of the plurality of pillar portions 20. In the case where the main body portion 1c includes the central portion 30, the inorganic material member 70 may be included in at least the central portion 30. In the example shown in Fig. 17, the inorganic material member 70 is included in both the first base portion 11 and the second base portion 12. In the example shown in Fig. 18, the inorganic material member 70 is included in the first base portion 11, the second base portion 12, all of the plurality of pillar portions 20, and the central portion 30.

The inorganic material member 70 may be a sheet-shaped member, such as that shown in Fig. 17. The sheet-shaped inorganic material member 70 is, for example, a woven fabric, called glass cloth, manufactured from fibrous glass.

When the inorganic material member 70 is a sheet-shaped member, the minimum width of the inorganic material member 70 is the thickness of the sheet-shaped inorganic material member 70. When the thickness of the sheet-shaped inorganic material member 70 is not constant, the minimum width of the sheet-shaped inorganic material member 70 is the minimum value, among thicknesses of the sheet-shaped inorganic material member 70 measured at 10 points. When the inorganic material member 70 is a sheet-shaped member, the maximum width of the inorganic material member 70 is the maximum value of the dimension of the inorganic material member 70 in a direction parallel to a surface of the sheet-shaped inorganic material member 70.

In the example shown in Fig. 17, the sheet-shaped inorganic material member 70 is included in both the first base portion 11 and the second base portion 12. A surface of the first base portion 11 opposite to the first facing surface 11a is referred to as a first outer surface 11b. The sheet-shaped inorganic material member 70 included in the first base portion 11 is positioned between the first facing surface 11a and the first outer surface 11b. The thickness direction of the sheet-shaped inorganic material member 70 is oriented in a direction identical to the thickness direction of the first base portion 11. A surface of the second base portion 12 opposite to the second facing surface 12a is referred to as a second outer surface 12b. The sheet-shaped inorganic material member 70 included in the second base portion 12 is located between the second facing surface 12a and the second outer surface 12b. The thickness direction of the sheet-shaped inorganic material member 70 is oriented in a direction identical to the thickness direction of the second base portion 12.

Although not shown, in the case where the main body portion 1c includes the central portion 30, the sheet-shaped inorganic material member 70 may be included in the central portion 30. In this case, the sheet-shaped inorganic material member 70 may be located between the first central surface 30a and the second central surface 30b. The thickness direction of the sheet-shaped inorganic material member 70 may be oriented in a direction identical to the thickness direction of the central portion 30.

The inorganic material member 70 may be a plurality of rod-shaped members, such as those shown in Fig. 18. The plurality of rod-shaped inorganic material members 70 may be, for example, fibrous glass called glass fiber. In the example shown in Fig. 18, the plurality of rod-shaped inorganic material members 70 are dispersed inside the main body portion 1c. The plurality of rod-shaped inorganic material members 70 are oriented in mutually different directions. The maximum width of each rod-shaped inorganic material member 70 is, for example, 100 µm. In the example shown in Fig. 18, a plurality of the rod-shaped inorganic material members 70 are included in the first base portion 11, the second base portion 12, all of the plurality of pillar portions 20, and the central portion 30.

When the inorganic material member 70 is a rod-shaped member, the maximum width of the inorganic material member 70 is the dimension of the inorganic material member 70 in a direction in which the rod-shaped inorganic material member 70 extends. When the inorganic material member 70 is a rod-shaped member, the minimum width of the inorganic material member 70 is the minimum value of the dimension of the inorganic material member 70 in a direction orthogonal to the direction in which the rod-shaped inorganic material member 70 extends.

Although not shown, the inorganic material member 70 may be a plurality of flaky members. The plurality of flaky inorganic material members 70 are, for example, GLASFLAKE (registered trade mark) manufactured by Nippon Sheet Glass Co., Ltd. The plurality of flaky inorganic material members 70 may be FINEFLAKE (registered trade mark) manufactured by Nippon Sheet Glass Co., Ltd. The plurality of flaky inorganic material members 70 may be dispersed inside the main body portion 1c. The plurality of flaky inorganic material members 70 may be oriented in mutually different directions.

When the inorganic material member 70 is a flaky member, the minimum width of the inorganic material member 70 is the thickness of the flaky inorganic material member 70. The maximum width of the inorganic material member 70 is the maximum value of the dimension of the inorganic material member 70 in a direction orthogonal to the thickness direction of the flaky inorganic material member 70.

The maximum width of the flaky inorganic material member 70 is, for example, 200 µm. The minimum width (thickness) of the flaky inorganic material member 70 is, for example, 0.3 µm or more and 6 µm or less. When the inorganic material member 70 is a plurality of flaky members, the material of the inorganic material member 70 can be the same as the above-described material of the inorganic material member 70. The inorganic material member 70 that is a plurality of flaky members may contain glass. The inorganic material member 70 that is a plurality of flaky members may contain an aluminum oxide. The inorganic material member 70 that is a plurality of flaky members may contain boehmite.

Although not shown, the main body portion 1c may include, as the inorganic material member 70, any two or more members selected from the group consisting of a sheet-shaped member, a plurality of rod-shaped members, and a plurality of flaky members.

Although not shown, the inorganic material member 70 may have a shape other than a sheet shape, a rod shape, and a flaky shape. In this case, the maximum width and the minimum width of the inorganic material member 70 are defined by the following method. When a dimension of the inorganic material member 70 is measured in every direction, a direction da in which the dimension of the inorganic material member 70 is maximum is considered. The maximum width of the inorganic material member 70 is defined as the dimension of the inorganic material member 70 in the direction da. The minimum width of the inorganic material member 70 is defined as the minimum value of the dimension of the inorganic material member 70 in a direction orthogonal to the direction da.

The main body portion 1c including the inorganic material member 70 may further include the glass particles 51 described above. The main body portion 1c including the inorganic material member 70 does not necessarily include the glass particles 51. The maximum width of each glass particle 51 may be less than three times the minimum width of the glass particle.

Effects of the inorganic material member 70 included in the main body portion 1c will be described. A case where the metal layer 40 is bonded to a part (the base portion 10, the single-sided shaped body 80, the resin sheet 32, or the like) constituting at least a portion of the main body portion 1c will be considered. In this case, due to a difference in coefficient of thermal expansion (CTE) between the main body portion 1c and the metal layer 40, the metal layer 40 may peel off from the main body portion 1c, or the metal layer 40 may wrinkle. In particular, when the metal layer 40 and the main body portion 1c are heated at the time of bonding the metal layer 40 to the main body portion 1c, the metal layer 40 may peel off from the main body portion 1c or the metal layer 40 may wrinkle due to a difference in CTE between the main body portion 1c and the metal layer 40. In particular, when the metal layer 40 is formed of copper foil and the main body portion 1c contains polyolefin, the difference in CTE between the main body portion 1c and the metal layer 40 can be large. In this case, the CTE of the metal layer 40 can be smaller than the CTE of the main body portion 1c. In this case, the metal layer 40 may peel off from the main body portion 1c, or the metal layer 40 may wrinkle.

On the other hand, due to the inorganic material member 70 included in the main body portion 1c, the CTE of the main body portion 1c can be adjusted. This makes it possible to adjust the CTE of the hollow-structure film 1 whose dielectric constant is suppressed to be low by having a hollow structure. In particular, due to the inorganic material member 70 included in the main body portion 1c of the hollow-structure film 1, the CTE of the main body portion 1c can be adjusted such that the difference in CTE between the main body portion 1c and the metal layer 40 is reduced. In particular, due to the inorganic material member 70 included in the main body portion 1c, the CTE of the main body portion 1c can be reduced. In an example, due to the inorganic material member 70 included in the main body portion 1c, the CTE of the main body portion 1c can be 120 ppm/°C or less. Due to the glass or the metal oxide, in particular, the glass contained in the inorganic material member 70, the CTE of the main body portion 1c can be adjusted such that the difference in CTE between the main body portion 1c and the metal layer 40 is reduced. In particular, in the case where the main body portion 1c contains polyolefin, the CTE of the main body portion 1c can be reduced by the main body portion 1c further including the inorganic material member 70. As described above, due to the main body portion 1c including the inorganic material member 70, by adjusting the CTE of the main body portion 1c such that the difference in CTE between the main body portion 1c and the metal layer 40 is reduced, it is possible to make the metal layer 40 less likely to peel off from the main body portion 1c and make the metal layer 40 less likely to wrinkle. In particular, in the case where the metal layer 40 is formed of copper foil and the main body portion 1c contains polyolefin, the metal layer 40 can be made less likely to peel off from the main body portion 1c, and the metal layer 40 can be made less likely to wrinkle. Furthermore, since the difference in CTE between the main body portion 1c and the metal layer 40 is reduced, the hollow-structure film 1 is less likely to warp due to the difference in CTE between the main body portion 1c and the metal layer 40. Consequently, the processability of the hollow-structure film 1 can be ensured.

The method for manufacturing the hollow-structure film 1 of Modification 6 can be the same as the method for manufacturing the hollow-structure film 1 in the above-described embodiment, except that the single-sided shaped bodies 80 produced in the step of producing a pair of the single-sided shaped bodies 80 include the insulating inorganic material member 70. At least one of the pair of single-sided shaped bodies 80 may include the inorganic material member 70. Both of the pair of single-sided shaped bodies 80 may include the inorganic material member 70. The inorganic material member 70 may be included in the base portion 81 of the single-sided shaped body 80. The inorganic material member 70 may be included in at least a part of the plurality of projecting portions 82. The inorganic material member 70 may be included in all of the plurality of projecting portions 82. When the resin sheet 32 is used for manufacturing the hollow-structure film 1, the inorganic material member 70 may be included in the resin sheet 32.

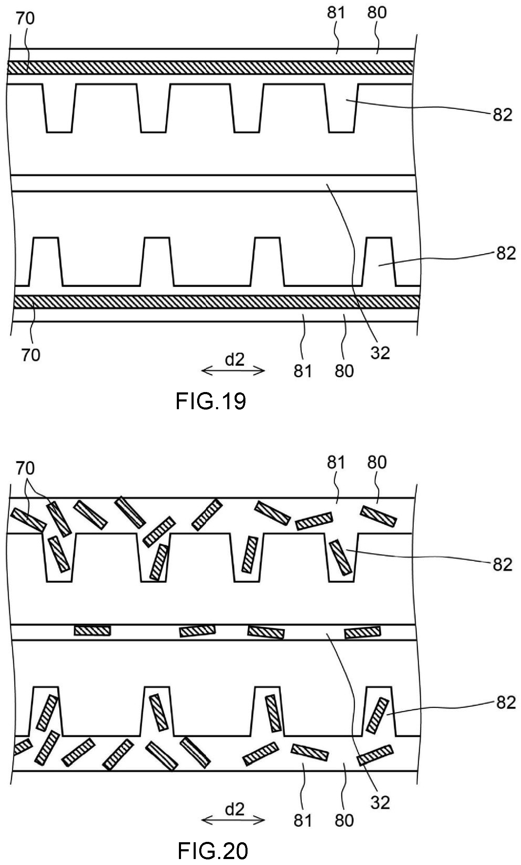

The hollow-structure film 1 shown in Fig. 17 can be manufactured from a pair of the single-sided shaped bodies 80, such as those shown in Fig. 19, in which the sheet-shaped inorganic material member 70 is included in the base portion 81, and the resin sheet 32. The hollow-structure film 1 shown in Fig. 18 can be manufactured from a pair of the single-sided shaped bodies 80, such as those shown in Fig. 20, in which the rod-shaped inorganic material member 70 is included in the base portion 81 and all of the plurality of projecting portions 82, and the resin sheet 32 in which the rod-shaped inorganic material member 70 is included.

The hollow-structure film 1 of Modification 6 includes the main body portion 1c including the sheet-shaped first base portion 11, the sheet-shaped second base portion 12 overlapping the first base portion 11, and a plurality of pillar portions 20 provided between the first base portion 11 and the second base portion 12. The first base portion 11 has the first facing surface 11a that faces the second base portion 12. The second base portion 12 has the second facing surface 12a that faces the first base portion 11. At least a part of the plurality of pillar portions 20 constitutes the continuous pillar portion 23 extending from the first facing surface 11a to the second facing surface 12a. The main body portion 1c includes the insulating inorganic material member 70. The maximum width of the inorganic material member 70 is more than or equal to three times the minimum width of the inorganic material member. As a result, the metal layer 40 can be made less likely to peel off from the main body portion 1c, and wrinkling can be made less likely to occur in the metal layer 40.

In the hollow-structure film 1 of Modification 6, the inorganic material member 70 may be included in at least one of the first base portion 11 and the second base portion 12. Consequently, when the base portion 10 and the metal layer 40 are bonded to each other, the CTE of the base portion 10 can be adjusted such that the difference in CTE between the base portion 10 and the metal layer 40 is reduced. As a result, the metal layer 40 can be made less likely to peel off from the base portion 10, and the metal layer 40 bonded to the base portion 10 can be made less likely to wrinkle.

In the hollow-structure film 1 of Modification 6, the inorganic material member 70 may be included in at least a part of the plurality of pillar portions 20. This also makes it possible to adjust the CTE of the main body portion 1c so as to reduce the difference in CTE between the main body portion 1c and the metal layer 40. As a result, the metal layer 40 can be made less likely to peel off from the main body portion 1c, and wrinkling can be made less likely to occur in the metal layer 40.

In the hollow-structure film 1 of Modification 6, the main body portion 1c may further include the sheet-shaped central portion 30 that overlaps the first base portion 11 and the second base portion 12 and that is located between the first facing surface 11a and the second facing surface 12a. In this case, the inorganic material member 70 may be included in at least the central portion 30. This also makes it possible to adjust the CTE of the main body portion 1c so as to reduce the difference in CTE between the main body portion 1c and the metal layer 40. As a result, the metal layer 40 can be made less likely to peel off from the main body portion 1c, and wrinkling can be made less likely to occur in the metal layer 40.

In the hollow-structure film 1 of Modification 6, the inorganic material member 70 may contain glass. Consequently, the CTE of the main body portion 1c can be more effectively adjusted by using the inorganic material member 70 so as to reduce the difference in CTE between the main body portion 1c and the metal layer 40.

The maximum width of the inorganic material member 70 may be 10 µm or more. Consequently, the CTE of the main body portion 1c can be more effectively adjusted by using the inorganic material member 70 so as to reduce the difference in CTE between the main body portion 1c and the metal layer 40.

The method for manufacturing the hollow-structure film 1 of Modification 6 by using the mold 90 includes a step of producing a pair of the single-sided shaped bodies 80 each having the sheet-shaped base portion 81 and a plurality of the projecting portions 82 formed on one surface of the base portion 81 and each including the insulating inorganic material member 70, and a step of overlapping the produced pair of single-sided shaped bodies 80 such that the plurality of projecting portions 82 face each other at least partially and thermocompression-bonding the pair of single-sided shaped bodies 80. The maximum width of the inorganic material member 70 is more than or equal to three times the minimum width of the inorganic material member. By such a manufacturing method, the hollow-structure film 1 in which the main body portion 1c includes the inorganic material member 70 can be manufactured.

The effect of Modification 6 will be described from the viewpoint of the relationship with the related art. As a sheet that has a dielectric constant suppressed to be lower than that of the related art and that can be used for a circuit board or the like, a sheet, such as a low-dielectric sheet for twodimensional communication disclosed in, for example, Japanese Patent No. 5976714, manufactured by forming a resin foam containing bubbles is known.

However, it has been desired to adjust the CTE (coefficient of thermal expansion) of the low dielectric-constant film used in a circuit board.

According to Modification 6, the CTE of a film having a low dielectric constant can be adjusted.

### <Modification 7>

The forms of the connection portions 24 and the pillar portions 20 are not limited to the examples described in the above-described embodiment and modifications. The hollow-structure film 1 has, as end portions in the first direction d1, a first end portion 1d and a second end portion 1e. In the hollow-structure film 1, the connection portions 24 and the pillar portions 20 do not necessarily extend from the first end portion 1d to the second end portion 1e.

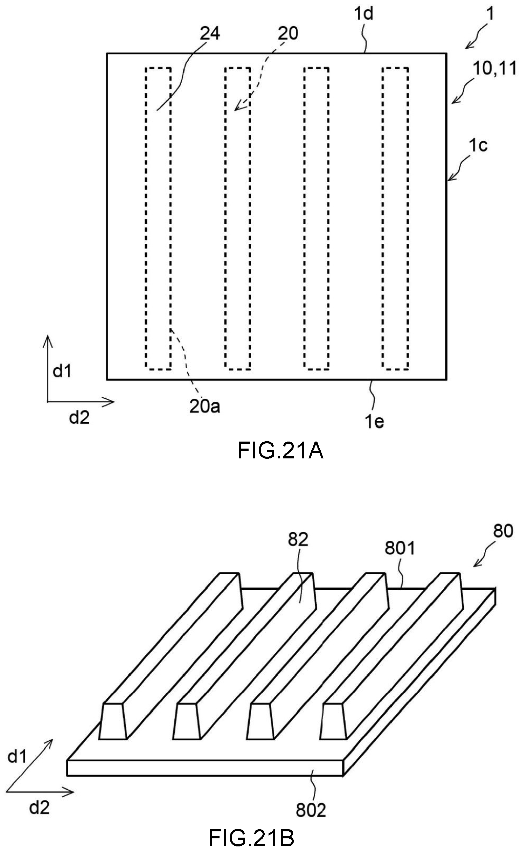

In the above-described example shown in Fig. 2, the base portion 10 includes a plurality of the connection portions 24 extending in the first direction d1, and does not include the connection portions 24 extending in directions other than the first direction d1. Further, in the above-described example shown in Fig. 2, the hollow-structure film 1 includes a plurality of the pillar portions 20 extending in the first direction d1, and does not include the pillar portions 20 extending in directions other than the first direction d1. In the above-described example shown in Fig. 2, the connection portions 24 and the pillar portions 20 extend from the first end portion 1d to the second end portion 1e. However, with respect to the hollow-structure film 1 that does not include the connection portions 24 and the pillar portions 20 extending in directions other than the first direction d1, the forms of the connection portions 24 and the pillar portions 20 are not limited thereto. Fig. 21A corresponds to Fig. 2 and is a plan view showing a state in which an example of the hollow-structure film 1 of Modification 7 is observed in the thickness direction of the hollow-structure film 1. That is, Fig. 21A is a plan view showing, in the same expression as Fig. 2, a state in which one (the first base portion 11) of the pair of base portions 10 in an example of the hollow-structure film 1 is observed in the thickness direction of the hollow-structure film 1. As shown in Fig. 21A, the connection portions 24 and the pillar portions 20 do not necessarily extend from the first end portion 1d to the second end portion 1e. In the example shown in Fig. 21A, the connection portions 24 and the pillar portions 20 are not located at the first end portion 1d. Further, in the example shown in Fig. 21A, the connection portions 24 and the pillar portions 20 are not located at the second end portion 1e.

Fig. 21B is a perspective view showing the single-sided shaped body 80 used for manufacturing the hollow-structure film 1 shown in Fig. 21A. In the drawings, including Fig. 21B, showing the single-sided shaped body 80, a direction that becomes the first direction d1 when the hollow-structure film 1 is manufactured using the single-sided shaped body 80 is shown as the first direction d1. Furthermore, a direction that becomes the second direction d2 when the hollow-structure film 1 is manufactured using the single-sided shaped body 80 is shown as the second direction d2. The hollow-structure film 1 shown in Fig. 21A can be manufactured using the single-sided shaped body 80 shown in Fig. 21B. The single-sided shaped body 80 includes, as end portions in the first direction d1, a first end portion 801 and a second end portion 802. In the example shown in Fig. 21B, the projecting portions 82 do not extend from the first end portion 801 to the second end portion 802. In the example shown in Fig. 21B, the projecting portions 82 are not located at the first end portion 801. Further, in the example shown in Fig. 21B, the projecting portions 82 are not located at the second end portion 802.

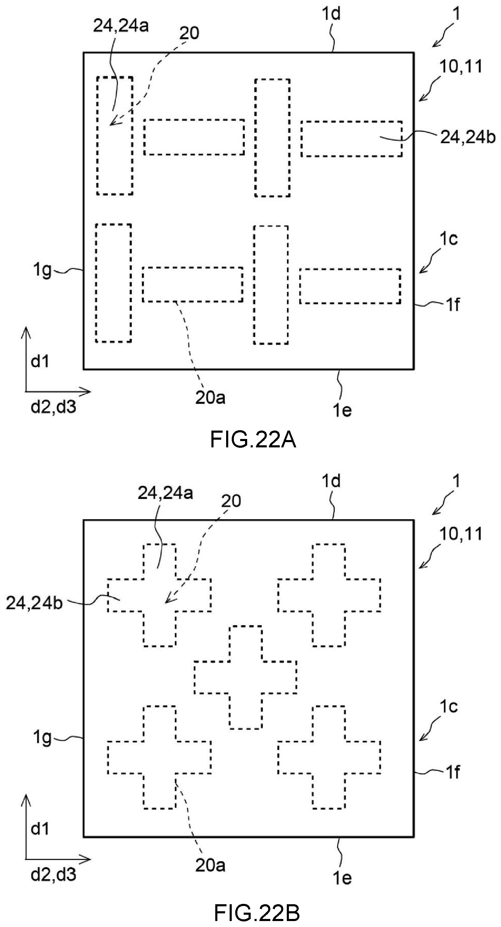

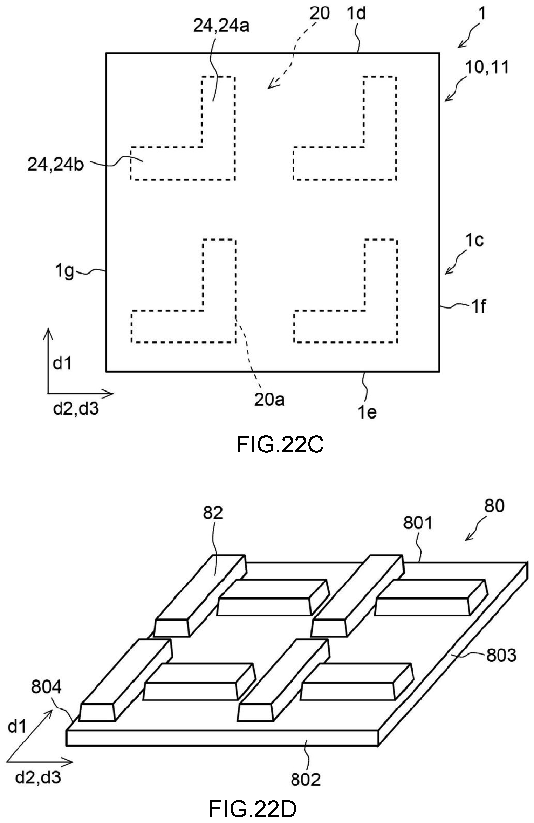

In the above-described example shown in Fig. 9, the hollow-structure film 1 has, as end portions in the third direction d3, a third end portion 1f and a fourth end portion 1g. In the above-described example shown in Fig. 9, the base portion 10 has, as a plurality of connection portions 24, the first connection portions 24a extending in the first direction d1 and the second connection portions 24b extending in the third direction d3. Furthermore, in the above-described example shown in Fig. 9, the hollow-structure film 1 includes a plurality of the pillar portions 20 extending in the first direction d1 and a plurality of the pillar portions 20 extending in the third direction d3. In the above-described example shown in Fig. 9, the first connection portions 24a and the pillar portions 20 that extend in the first direction d1 extend from the first end portion 1d to the second end portion 1e. In the above-described example shown in Fig. 9, the second connection portions 24b and the pillar portions 20 that extend in the third direction d3 extend from the third end portion 1f to the fourth end portion 1g. However, in the hollow-structure film 1 in which the base portion 10 has the first connection portions 24a and the second connection portions 24b and in which the pillar portions 20 extending in the first direction d1 and the pillar portions 20 extending in the third direction d3 are included, the forms of the connection portions 24 and the pillar portions 20 are not limited thereto. Fig. 22A, Fig. 22B, and Fig. 22C each correspond to Fig. 2 and are each a plan view showing a state in which an example of the hollow-structure film 1 of Modification 7 is observed in the thickness direction of the hollow-structure film 1. As shown in Fig. 22A, Fig. 22B, and Fig. 22C, the first connection portions 24a and the pillar portions 20 that extend in the first direction d1 do not necessarily extend from the first end portion 1d to the second end portion 1e. As shown in Fig. 22A, Fig. 22B, and Fig. 22C, the second connection portions 24b and the pillar portions 20 that extend in the third direction d3 do not necessarily extend from the third end portion 1f to the fourth end portion 1g. In the examples shown in Fig. 22A, Fig. 22B, and Fig. 22C, the connection portions 24 and the pillar portions 20 are not located at the first end portion 1d. In the examples shown in Fig. 22A, Fig. 22B, and Fig. 22C, the connection portions 24 and the pillar portions 20 are not located at the second end portion 1e. In the examples shown in Fig. 22A, Fig. 22B, and Fig. 22C, the connection portions 24 and the pillar portions 20 are not located at the third end portion 1f. Further, in the examples shown in Fig. 22A, Fig. 22B, and Fig. 22C, the connection portions 24 and the pillar portions 20 are not located at the fourth end portion 1g.

As shown in Fig. 22A, the first connection portions 24a and the second connection portions 24b may be spaced apart from each other. The pillar portions 20 extending in the first direction d1 may be spaced apart from the pillar portions 20 extending in the third direction d3.

As shown in Fig. 22B and Fig. 22C, the first connection portions 24a and the second connection portions 24b may be connected to each other. The pillar portions 20 extending in the first direction d1 and the pillar portions 20 extending in the third direction d3 may be connected to each other. In this case, as shown in Fig. 22B, the first connection portion 24a and the second connection portion 24b may form a "+" shape by being connected to each other. The pillar portion 20 extending in the first direction d1 and the pillar portion 20 extending in the third direction d3 may form a "+" shape by being connected to each other. As shown in Fig. 22C, the first connection portion 24a and the second connection portion 24b may form an L-shape by being connected to each other. The pillar portion 20 extending in the first direction d1 and the pillar portion 20 extending in the third direction d3 may form an L-shape by being connected to each other.

The hollow-structure films 1 shown in Fig. 22A, Fig. 22B, and Fig. 22C can be manufactured using the single-sided shaped bodies 80 having shapes corresponding thereto. As an example, the single-sided shaped body 80 used for manufacturing the hollow-structure film 1 shown in Fig. 22A will be described. Fig. 22D is a perspective view showing the single-sided shaped body 80 used for manufacturing the hollow-structure film 1 shown in Fig. 22A. In Fig. 22D, a direction that becomes the third direction d3 when the hollow-structure film 1 is manufactured using the single-sided shaped body 80 is shown as the third direction d3. The single-sided shaped body 80 has, as end portions in the first direction d1, the first end portion 801 and the second end portion 802. The single-sided shaped body 80 has, as end portions in the third direction d3, a third end portion 803 and a fourth end portion 804. In the example shown in Fig. 22D, the single-sided shaped body 80 includes, as the projecting portions 82, the projecting portions 82 extending in the first direction d1 and the projecting portions 82 extending in the third direction d3. In the example shown in Fig. 22D, the projecting portions 82 extending in the first direction d1 do not extend from the first end portion 801 to the second end portion 802. In the example shown in Fig. 22D, the projecting portions 82 extending in the third direction d3 do not extend from the third end portion 803 to the fourth end portion 804. In the example shown in Fig. 22D, the projecting portions 82 are not located at the first end portion 801. In the example shown in Fig. 22D, the projecting portions 82 are not located at the second end portion 802. In the example shown in Fig. 22D, the projecting portions 82 are not located at the third end portion 803. Furthermore, in the example shown in Fig. 22D, the projecting portions 82 are not located at the fourth end portion 804.

The hollow-structure film 1 of Modification 7 can also form a hollow structure to suppress the dielectric constant to be low.

### <Modification 8>

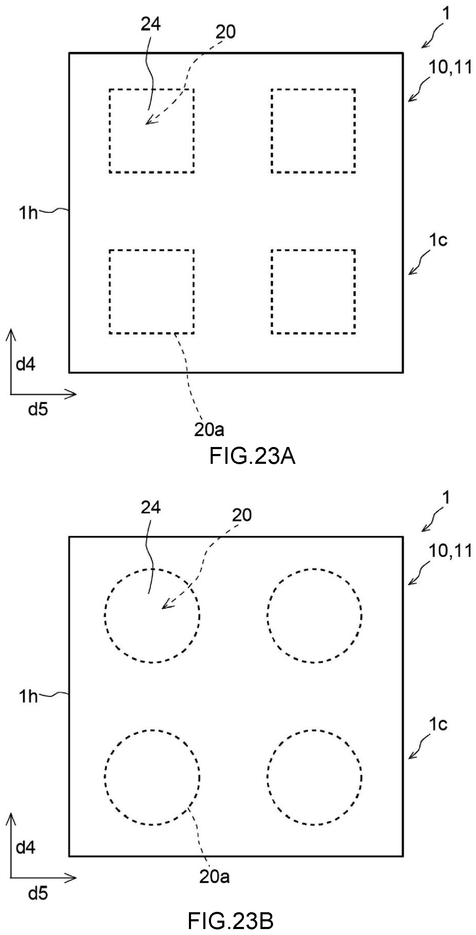

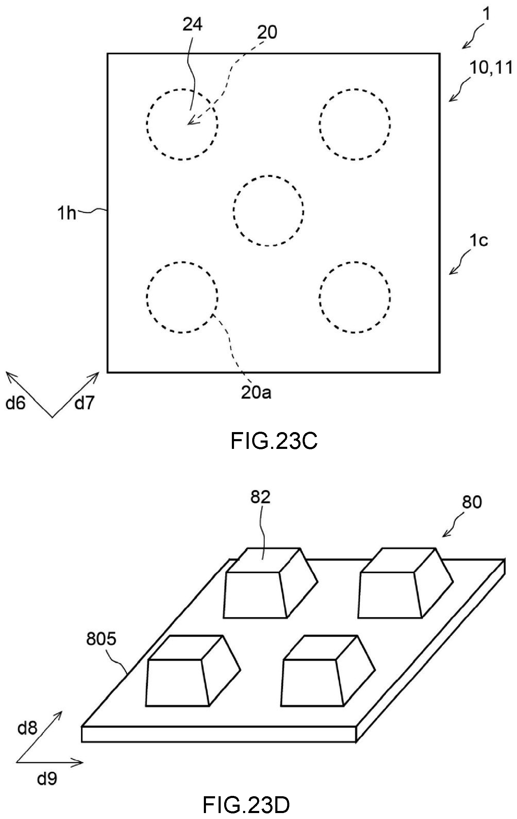

The forms of the connection portions 24 and the pillar portions 20 are not limited to the examples described in the above-described embodiment and modifications. The contour shapes of the connection portions 24 and the pillar portions 20 observed in the thickness direction of the hollow-structure film 1 may be shapes other than a rectangle having a short side and a long side. Fig. 23A, Fig. 23B, and Fig. 23C each correspond to Fig. 2 and are each a plan view showing a state of an example of the hollow-structure film 1 of Modification 8 as observed in the thickness direction of the hollow-structure film 1. In the example shown in Fig. 23A, the contour shapes of the connection portions 24 and the pillar portions 20 are each a square when observed in the thickness direction of the hollow-structure film 1. In the example shown in Fig. 23B and Fig. 23C, the contour shapes of the connection portions 24 and the pillar portions 20 observed in the thickness direction of the hollow-structure film 1 are circular. Although not shown, the contour shapes of the connection portions 24 and the pillar portions 20 observed in the thickness direction of the hollow-structure film 1 may be elliptical. In the hollow-structure film 1, the connection portions 24 and the pillar portions 20 do not necessarily extend in the first direction d1.

Further, a method for arranging the connection portions 24 and the pillar portions 20 is not particularly limited as long as the continuous pillar portion 23 can be formed. In the examples shown in Fig. 23A, Fig. 23B, and Fig. 23C, the connection portions 24 and the pillar portions 20 are regularly arranged. In the examples shown in Fig. 23A, Fig. 23B, and Fig. 23C, the connection portions 24 and the pillar portions 20 are arranged at equal intervals. Although not shown, the connection portions 24 and the pillar portions 20 may be randomly disposed. The hollow-structure film 1 may have a region in which the connection portions 24 and the pillar portions 20 are regularly disposed and a region in which the connection portions 24 and the pillar portions 20 are randomly disposed.

As shown in Fig. 23A and Fig. 23B, the connection portions 24 and the pillar portions 20 may be arranged along a fourth direction d4 that is a direction in which one of end edges 1h of the hollow-structure film 1 extends and along a fifth direction d5 intersecting the fourth direction d4. In the examples shown in Fig. 23A and Fig. 23B, the fourth direction d4 and the fifth direction d5 are orthogonal to each other.

As shown in Fig. 23C, the connection portions 24 and the pillar portions 20 may be arranged along a sixth direction d6 and a seventh direction d7 intersecting the sixth direction d6. The sixth direction d6 is a direction that is not parallel to the direction in which the end edges 1h of the hollow-structure film 1 extend. The seventh direction d7 is a direction that is not parallel to the direction in which the end edges 1h of the hollow-structure film 1 extend and that is not parallel to the sixth direction d6. In the example shown in Fig. 23C, the sixth direction d6 and the seventh direction d7 are orthogonal to each other.

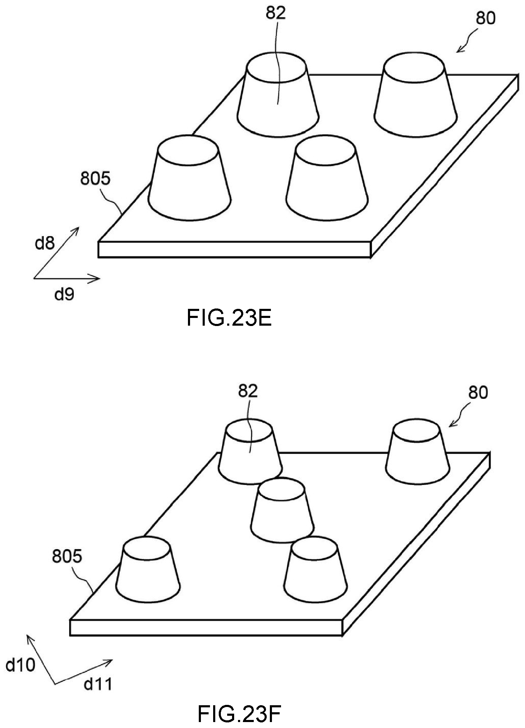

The hollow-structure film 1 shown in Fig. 23A, Fig. 23B, and Fig. 23C can each be manufactured using the single-sided shaped body 80 having a shape corresponding thereto. Fig. 22D is a perspective view showing the single-sided shaped body 80 used for manufacturing the hollow-structure film 1 shown in Fig. 23A. Fig. 23E is a perspective view showing the single-sided shaped body 80 used for manufacturing the hollow-structure film 1 shown in Fig. 23B. Fig. 23F is a perspective view showing the single-sided shaped body 80 used for manufacturing the hollow-structure film 1 shown in Fig. 23C. In the example shown in Fig. 23D, the projecting portions 82 each have a quadrangular frustum shape, in particular, a regular quadrangular frustum shape. In the examples shown in Fig. 23E and Fig. 23F, the projecting portions 82 each have a conical frustum shape.

In the examples shown in Fig. 23D and Fig. 23E, the projecting portions 82 are arranged along an eighth direction d8 that is a direction in which one of end edges 805 of the single-sided shaped body 80 extends and along a ninth direction d9 intersecting the eighth direction d8. In the examples shown in Fig. 23D and Fig. 23E, the eighth direction d8 and the ninth direction d9 are orthogonal to each other.

In the example shown in Fig. 23F, the projecting portions 82 are arranged along a tenth direction d10 and an eleventh direction d11 intersecting the tenth direction d10. The tenth direction d10 is a direction that is not parallel to the direction in which the end edges 805 of the single-sided shaped body 80 extend. The eleventh direction d11 is a direction that is not parallel to the direction in which the end edges 805 of the single-sided shaped body 80 extend and that is not parallel to the tenth direction d10. In the example shown in Fig. 23F, the tenth direction d10 and the eleventh direction d11 are orthogonal to each other.

The hollow-structure film 1 of Modification 8 can also form a hollow structure to suppress the dielectric constant to be low.

### EXAMPLES

Next, specific examples of the above-described embodiment and modifications will be described.

### (EXAMPLE 1)

The hollow-structure film 1 similar to the hollow-structure film 1 shown in Fig. 1 except that the particles 50 were not contained was manufactured. At this time, first, a pair of the single-sided shaped bodies 80 were produced using the mold 90. At this time, Kapton (registered trade mark) manufactured by Du Pont-Toray Co., Ltd. was prepared as a peelable substrate. Further, a mixture of a resin and an electron beam crosslinking agent was prepared as a material of the shaped-body corresponding portion 13. High-density polyethylene raw material pellets (product name "HI-ZEX (registered trade mark) 5000SR", manufactured by Prime Polymer Co., Ltd.) were used as the resin. As the electron beam crosslinking agent, TAIC (registered trade mark) (manufactured by Shinryo Corporation) was used. The ratio of the mass of the resin to the total mass of the mixture was 95 mass%. The ratio of the mass of the electron beam crosslinking agent to the total mass of the mixture was 5 mass%.

Subsequently, using the mold 90 having the surface 90a that has a shape corresponding to the shape of the single-sided shaped body 80 to be produced, the material of the shaped-body corresponding portion 13 was molded on the peelable substrate. Thus, the pair of single-sided shaped bodies 80 were produced from the material of the shaped-body corresponding portion 13. The pair of single-sided shaped bodies 80 produced each had the sheet-shaped base portion 81 and a plurality of the projecting portions 82 formed on one surface of the base portion 81. The thickness (the total of the thickness of the base portion 81 and the dimension of the projecting portion 82 in the thickness direction of the base portion 81) of the single-sided shaped body 80 was 150 µm.

Further, the resin sheet 32 to be used as a material for the central portion 30 was produced. As the resin sheet 32, a resin sheet 32 molded into a sheet shape and in which an electron beam crosslinking agent was dispersed in a resin was used. Linear low-density polyethylene raw material pellets (product name "DOWLEX (registered trade mark): 2045.11G (C8 Copolymer)", manufactured by Dow Chemical Company) were used as the resin material contained in the resin sheet 32. As the electron beam crosslinking agent contained in the resin sheet 32, the same electron beam crosslinking agent as the electron beam crosslinking agent contained in the shaped-body corresponding portion 13 was used. The ratio of the mass of the resin to the total mass of the resin and the electron beam crosslinking agent was 95 mass%. The ratio of the mass of the electron beam crosslinking agent to the total mass of the resin and the electron beam crosslinking agent was 5 mass%. The thickness of the resin sheet 32 was 50 µm.

Subsequently, a pair of laminates each including the single-sided shaped body 80 and the peelable substrate were overlapped such that the plurality of projecting portions 82 of the pair of single-sided shaped bodies 80 partially faced each other. As a result, the pair of single-sided shaped bodies 80 were overlapped such that the plurality of projecting portions 82 partially faced each other. At this time, the resin sheet 32 was disposed between the pair of single-sided shaped bodies 80.

Subsequently, the pair of single-sided shaped bodies 80 were thermocompression-bonded. In particular, the pair of single-sided shaped bodies 80 were bonded to the resin sheet 32 at the plurality of projecting portions 82 by thermocompression-bonding the pair of single-sided shaped bodies 80. As a result, the pair of single-sided shaped bodies 80 were bonded to each other via the resin sheet 32. The heating temperature when the pair of single-sided shaped bodies 80 were thermocompression-bonded was set to be higher than the Vicat softening point of the resin contained in the central portion 30.

Subsequently, the peelable substrate was peeled off from the pair of single-sided shaped bodies 80.

Subsequently, the crosslinking step of irradiating the electron beam crosslinking agent contained in the single-sided shaped bodies 80 with an electron beam to cause the electron beam crosslinking agent to react with the resin was performed. In the irradiation with the electron beam, the accelerating voltage was 200 kV, the current value was 5 mA, and the irradiation dose was 289 kGy. Further, in the crosslinking step, the electron beam crosslinking agent contained in the resin sheet 32 was irradiated with the electron beam to cause the electron beam crosslinking agent to react with the resin. More specifically, in the crosslinking step, the electron beam crosslinking agent contained in the single-sided shaped bodies 80 and the electron beam crosslinking agent contained in the resin sheet 32 were simultaneously irradiated with the electron beam to cause the electron beam crosslinking agent to react with the resin in the single-sided shaped bodies 80 and in the resin sheet 32 simultaneously. Thus, the hollow-structure film 1 shown in Fig. 1 was manufactured. The ratio between the width w2 and the interval w1 shown in Fig. 1 in the hollow-structure film 1 was 1:3.

### (EXAMPLE 2)

A hollow-structure film 1 was manufactured by the same method as in Example 1 except for the following points. The thickness (the total of the thickness of the base portion 81 and the dimension of the projecting portion 82 in the thickness direction of the base portion 81) of the single-sided shaped body 80 was 120 µm.

### (EXAMPLE 3)

A hollow-structure film 1 was manufactured by the same method as in Example 1 except for the following points. The hollow-structure film 1, such as that shown in Fig. 9, in which the base portion 10 had, as the plurality of connection portions 24, the first connection portions 24a extending in the first direction d1 and the second connection portions 24b extending in the third direction d3 was manufactured. The third direction d3 in which the second connection portions 24b extend is orthogonal to the first direction d1 in which the first connection portions 24a extend. The ratio of the width w2 to the interval w1 of the hollow-structure film 1 was 1:10.

### (EXAMPLE 4)

A hollow-structure film 1 was manufactured by the same method as in Example 1 except for the following points. One of the pair of single-sided shaped bodies 80 was produced as follows. By co-extrusion molding, a material of the metal adjacent layer 60 and a material of the shaped-body corresponding portion 13 were molded, using the mold 90, in this order on a peelable substrate. The material of the metal adjacent layer 60 was an ethylene-methacrylic acid copolymer (product name "NUCREL (registered trade mark) AN4233C", manufactured by Dow-Mitsui Polychemicals, Co., Ltd.). The metal adjacent layer 60 had a thickness of 30 µm. As a result, the metal adjacent layer 60 was produced on the peelable substrate from the material of the metal adjacent layer 60, and the single-sided shaped body 80 was produced on the metal adjacent layer 60 from the material of the shaped-body corresponding portion 13. In this manner, a laminate in which the peelable substrate, the metal adjacent layer 60, and the single-sided shaped body 80 were stacked in this order was produced. The laminate produced as described above and a laminate produced by the same method as in Example 1 and including the single-sided shaped body 80 and the peelable substrate were overlapped such that the plurality of projecting portions 82 of the pair of single-sided shaped bodies 80 partially faced each other. As a result, the pair of single-sided shaped bodies 80 were overlapped such that the plurality of projecting portions 82 partially faced each other. Subsequently, the pair of single-sided shaped bodies 80 were thermocompression-bonded. Subsequently, the peelable substrate was peeled off from the single-sided shaped bodies 80 and the metal adjacent layer 60. Thus, the hollow-structure film 1 corresponding to the hollow-structure film 1 shown in Fig. 1 in which the metal adjacent layer 60 was provided on one surface of each of the pair of base portions 10 was manufactured.

### (EXAMPLE 5)

A hollow-structure film 1 was manufactured by the same method as in Example 1 except for the following points. A mixture of a resin and an electron beam crosslinking agent was prepared as a material of the shaped-body corresponding portion 13. As the resin contained in the mixture, linear low-density polyethylene raw material pellets (product name "DOWLEX (registered trade mark): 2045.11G (C8 Copolymer)", manufactured by Dow Chemical Company) were used. The ratio of the mass of the resin to the total mass of the mixture was 95 mass%. The ratio of the mass of the electron beam crosslinking agent to the total mass of the mixture was 5 mass%. A sheet (product name "NUCREL (registered trade mark) AN4233C", manufactured by Dow-Mitsui Polychemicals, Co., Ltd.) containing an ethylene-methacrylic acid copolymer as a material was used as the resin sheet 32. The resin sheet 32 did not contain the particles 50 and the electron beam crosslinking agent.

### (EXAMPLE 6)

A hollow-structure film 1 was manufactured by the same method as in Example 1 except for the following points. A mixture of a resin, the particles 50, and an electron beam crosslinking agent was prepared as a material of the shaped-body corresponding portion 13. As the resin contained in the mixture, linear low-density polyethylene raw material pellets (product name "DOWLEX (registered trade mark): 2045.11G (C8 Copolymer)", manufactured by Dow Chemical Company) were used. As the particles 50 contained in the mixture, hollow glass particles (the glass particles 51 having the hollow portions 52, product name "Sphericel (registered trade mark) 25P45", manufactured by Potters-Ballotini Co., Ltd.) were used. The ratio of the mass of the resin to the total mass of the mixture was 85 mass%. The ratio of the mass of the particles 50 to the total mass of the mixture was 10 mass%. The ratio of the mass of the electron beam crosslinking agent to the total mass of the mixture was 5 mass%. A sheet (product name "NUCREL (registered trade mark) AN4233C", manufactured by Dow-Mitsui Polychemicals, Co., Ltd.) containing an ethylene-methacrylic acid copolymer as a material was used as the resin sheet 32. The resin sheet 32 did not contain the particles 50 and the electron beam crosslinking agent.

### (EXAMPLE 7)

A hollow-structure film 1 was manufactured by the same method as in Example 1 except for the following points. A mixture of a resin, the particles 50, and an electron beam crosslinking agent was prepared as a material of the shaped-body corresponding portion 13. As the resin contained in the mixture, linear low-density polyethylene raw material pellets (product name "DOWLEX (registered trade mark): 2045.11G (C8 Copolymer)", manufactured by Dow Chemical Company) were used. As the particles 50 contained in the mixture, hollow glass particles (the glass particles 51 having the hollow portions 52, product name "Sphericel (registered trade mark) 25P45", manufactured by Potters-Ballotini Co., Ltd.) were used. The ratio of the mass of the resin to the total mass of the mixture was 75 mass%. The ratio of the mass of the particles 50 to the total mass of the mixture was 10 mass%. The ratio of the mass of the electron beam crosslinking agent to the total mass of the mixture was 15 mass%. A sheet (product name "NUCREL (registered trade mark) AN4233C", manufactured by Dow-Mitsui Polychemicals, Co., Ltd.) containing an ethylene-methacrylic acid copolymer as a material was used as the resin sheet 32. The resin sheet 32 did not contain the particles 50 and the electron beam crosslinking agent.

### (EXAMPLE 8)

A hollow-structure film 1 was manufactured by the same method as in Example 1 except for the following points. Only one laminate including the single-sided shaped body 80 and the peelable substrate was produced. Further, only one laminate including the resin sheet 32 and the peelable substrate was produced. The laminate including the single-sided shaped body 80 and the laminate including the resin sheet 32 were disposed such that the resin sheet 32 faced the surface of the single-sided shaped body 80 on which the plurality of projecting portions 82 were formed. Subsequently, the two layers of the single-sided shaped body 80 and the resin sheet 32 were thermally welded by thermocompression-bonding. Subsequently, the peelable base substrates were peeled from the single-sided shaped body 80 and the resin sheet 32. Thus, the hollow-structure film 1 corresponding to the hollow-structure film 1 shown in Fig. 14 from which the metal layer 40 and the metal adjacent layer 60 were removed was manufactured.

### (EXAMPLE 9)

A hollow-structure film 1 was manufactured by the same method as in Example 1 except for the following points. Four single-sided shaped bodies 80, including the first single-sided shaped body 80a, the second single-sided shaped body 80b, the third single-sided shaped body 80c, and the fourth single-sided shaped body 80d, were produced. Further, three resin sheets 32 were produced. Subsequently, the first single-sided shaped body 80a, the resin sheet 32, the second single-sided shaped body 80b, the resin sheet 32, the third single-sided shaped body 80c, the resin sheet 32, and the fourth single-sided shaped body 80d were stacked in this order and thermally welded. That is, the four single-sided shaped bodies 80 and the three resin sheets 32 were stacked as shown in Fig. 15 and thermally welded. At this time, the surfaces of the first single-sided shaped body 80a and the second single-sided shaped body 80b on each of which the plurality of projecting portions 82 were formed faced each other. The surfaces of the second single-sided shaped body 80b and the third single-sided shaped body 80c constituted by the base portions 81 faced each other. The surfaces of the third single-sided shaped body 80c and the fourth single-sided shaped body 80d on each of which the plurality of projecting portions 82 were formed faced each other. As described above, the four single-sided shaped bodies 80 and the three resin sheets 32 were stacked and thermally welded to thereby manufacture the hollow-structure film 1 corresponding to the hollow-structure film 1 shown in Fig. 16 from which the metal layers 40 and the metal adjacent layers 60 were removed. In the crosslinking step, the side of the first single-sided shaped body 80a was irradiated with an electron beam at an irradiation dose of 289 kGy, and the side of the fourth single-sided shaped body 80d was irradiated with an electron beam at an irradiation dose of 289 kGy.

### (Comparative Example 1)

A commercially available polyimide film (product name "UPILEX 125S", manufactured by UBE Corporation) was used as a film of Comparative Example 1. The thickness of the film of Comparative Example 1 was 125 µm.

### (Comparative Example 2)

A commercially available liquid crystal polymer (product name "R-F705", manufactured by Panasonic Industry Co., Ltd.) was used as a film of Comparative Example 2. The thickness of the film of Comparative Example 2 was 100 µm.

### (Comparative Example 3)

High-density polyethylene raw material pellets (product name "HI-ZEX (registered trade mark) 5000SR", manufactured by Prime Polymer Co., Ltd.) were hot-pressed with a gap of 200 µm. Thus, a smooth film-shaped sample was prepared. This sample was used as a film of Comparative Example 3. Since the gap during hot pressing was 200 µm, the thickness of the film of Comparative Example 3 was 200 µm.

### (1) Porosity Measurement Test

Next, a porosity measurement test was performed on the hollow-structure film 1 of each of Examples 1 to 9. In the porosity measurement test, an image of a cross section obtained by cutting the hollow-structure film 1 along a plane that passes through the plurality of pillar portions 20 and that is perpendicular to the first direction d1 was obtained with a scanning electron microscope (SEM). The straight line L2 and the straight line L3 described above were drawn on the obtained image. Subsequently, the ratio of the areas of the hollow portions B to the entire area of the hollow-structure film 1 including the hollow portions B between the straight line L2 and the straight line L3 was calculated. The ratio was calculated at 10 different positions in the cross section. The porosity of the hollow-structure film 1 was obtained by averaging the ratios calculated at the 10 different positions. In Comparative Examples 1 to 3 in which the hollow portion B was not originally provided, the porosity was considered zero.

### (2) Specific Gravity Measurement Test

Next, the hollow-structure films 1 of Examples 1 to 9 and the films of Comparative Examples 1 to 3 were subjected to a specific gravity (the ratio of the density of a target to the density of water at standard atmospheric pressure) measurement test. In the specific gravity measurement test, a square sample having one side of 100 mm was cut out from each of the hollow-structure films 1 of the examples and the films of the comparative examples. Subsequently, the mass of the sample was measured. Further, the thickness of the sample was measured. The thickness of the sample was measured by the following method. The thickness of the sample was measured at 16 in-plane points of the sample on a surface plate by an apparatus in which Digimicro Head MF-501 and Counter MFC-200, manufactured by Nikon Corporation, were combined. The measured points were spaced apart from each other by 3 cm. The average of the thicknesses at the 16 in-plane points was defined as the thickness of the sample. The volume of the sample was calculated by multiplying the square of the length (100 mm) of one side of the sample by the thickness. The specific gravity of the hollow-structure film 1 of each of Examples and Comparative Examples was calculated from the measured mass and the calculated volume.

### (3) Measurement Test for Dielectric Constant and Dielectric Loss Tangent

Next, the hollow-structure films 1 of Examples 1 to 9 and the films of Comparative Examples 1 to 3 were subjected to a measurement test for dielectric constant and dielectric loss tangent. In the measurement test for dielectric constant and dielectric loss tangent, the dielectric constant and the dielectric loss tangent were measured by the following method using a cavity-resonance measurement device (product name "S parameter network analyzer 8722ES", manufactured by Agilent Technologies, Inc.) as a measurement device, a cavity resonator, and a program CPMA-V2 installed in a notebook PC. A rectangular sample having a short side of 2 mm and a long side of 100 mm was cut out from each of the hollow-structure films 1 of the examples and the films of the comparative examples. Subsequently, the measurement device was started up. Thereafter, the sample was inserted into a cavity of the cavity resonator of the measurement device from one of the short sides, and the dielectric constant and dielectric loss tangent of the sample were measured. The dielectric constant and the dielectric loss tangent of the same sample were measured three times, and values obtained by averaging the three measurement results were used as the measured values of the dielectric constant and the dielectric loss tangent. Furthermore, the product of the square root of the relative dielectric constant calculated from the measured dielectric constant and the measured dielectric loss tangent was calculated as a value (also referred to as a "transmission loss coefficient") serving as an index for comparing the magnitude of the transmission loss.

### (4) Heat Resistance Evaluation Test

Next, the hollow-structure films 1 of Examples 1 to 9 and the films of Comparative Examples 1 to 3 were subjected to a heat resistance evaluation test. In the heat resistance evaluation test, a rectangular sample having a long side of 20 mm and a short side of 2 mm was cut out from each of the hollow-structure films 1 of the examples and the films of the comparative examples. The sample was disposed on a glass substrate such that only a 10 mm portion of a long side of the sample was placed on the glass substrate, and the sample was fixed to the glass substrate using a tape (product name "Kapton (registered trade mark) adhesive tape #12", manufactured by Teraoka Seisakusho Co., Ltd.). Subsequently, the sample in a state of being fixed to the glass substrate was heated by being disposed for 90 seconds in an oven heated to 290°C. At this time, the sample was positioned on the upper side of a surface of the glass substrate. Subsequently, the sample after heating was visually observed to evaluate whether the sample was deformed after heating and the degree of deformation after heating. The sample was evaluated as "○" when no deformation was observed, "△" when slight deformation (deformation such as warpage of the sample in which a portion of the sample protruding from the glass substrate did not droop and break and in which a portion of the sample fixed to the glass substrate and the portion protruding from the glass substrate remained connected) was observed, and "×" when severe deformation (deformation in which, for example, a portion of the sample protruding from the glass substrate completely droops and thus breaks between a portion of the sample fixed to the glass substrate and the portion protruding from the glass substrate) was observed.

### (5) Evaluating Test for Adhesion of Copper Foil

Next, the hollow-structure films 1 of Example 1 to Example 9 and the films of Comparative Example 1 to Comparative Example 3 were subjected to an evaluation test for adhesion of copper foil. In the evaluation test for the adhesion of the copper foil, the resistance of the copper foil to a load was evaluated by the following method. A rectangular sample having a long side of 100 mm and a short side of 20 mm was cut out from each of the hollow-structure films 1 of the examples and the films of the comparative examples. The sample was placed on copper foil (10 µm thick, product name "CF-LB9-10", purchased from Hohsen Corp). The copper foil had the same size as the sample. That is, the copper foil to be used had a rectangular shape with a long side of 100 mm and a short side of 20 mm. This copper foil and the sample were positioned such that the long side direction of the copper foil and the long side direction of the sample coincided with each other and only 20 mm of the long side of the sample was placed on the copper foil. Further, a material (30 µm thick, product name "NUCREL (registered trade mark) AN4233C", manufactured by Dow-Mitsui Polychemicals, Co., Ltd.) for the metal adjacent layer was disposed between the sample and the copper foil. Subsequently, a portion where the sample, the material of the metal adjacent layer, and the copper foil overlap each other was thermocompression-bonded at 100°C. The compression-bonded portion was formed at an end portion of the sample. In the compression-bonded portion, a laminate in which the sample, the metal adjacent layer, and the copper foil were stacked in this order was formed. A portion of the sample that was not compression-bonded to the copper foil and a portion of the copper foil that was not compression-bonded to the sample were formed over a length of 80 mm in the long side direction of the sample and the copper foil. Thus, the sample was bonded to the copper foil. Subsequently, the adhesion of the copper foil was evaluated by the following method. As a testing apparatus, a force tester MCT-2150, manufactured by A&D Company, Limited., in which a pair of parallel-tightening jaws for 500 N were set so as to be arranged in the vertical direction was prepared. The portion of the sample not compression-bonded to the copper foil was then set in a chuck of one of the pair of parallel-tightening jaws. In addition, the portion of the copper foil that was not compression-bonded to the sample was set in a chuck of the other of the pair of parallel-tightening jaws. Subsequently, a load was applied to a bonding surface where the sample and the copper foil were bonded, by separating one and the other of the pair of parallel-tightening jaws at a speed of 5 N/min, and whether peeling occurred at the bonding surface between the sample and the copper foil was observed. Further, in the case where peeling occurred, the peeling force (the load applied to the bonding surface between the sample and the copper foil when peeling occurred) when peeling occurred was measured. If peeling did not occur or the peeling force when peeling occurred was larger than 10 N/20 mm, it was evaluated as "○", and if the peeling force when peeling occurred was equal to or smaller than 10 N/20 mm, it was evaluated as "×".

In addition, in the evaluation test for the adhesion of the copper foil, an evaluation test for etchant resistance was performed by the following method. A laminate in which the sample, the metal adjacent layer, and the copper foil were stacked in this order was formed by the same method as the method in the evaluation test for the resistance of the copper foil to the load, except that the sample, the metal adjacent layer, and the copper foil that were large enough to perform a step of cutting out a laminate sample to be described later were used. That is, in the same manner as in the evaluation test for the resistance of the copper foil to a load, the metal adjacent layer was disposed between the sample and the copper foil and subjected to thermocompression bonding to form the laminate. A square laminate sample having one side of 20 mm was cut out from a portion of the laminate where the sample and the copper foil were thermally welded via the metal adjacent layer. A masking tape (product name "ELEP Masking N-300", manufactured by Nitto Denko Corporation) having a square shape with one side of 5 mm was attached to a central portion of a surface of the laminate sample constituted by the copper foil. Thereafter, the laminate sample was placed in a 1L glass beaker containing an aqueous iron chloride solution (concentration: 40%, Baume degree at 15°C: 42 Baume, manufactured by Wako Pure Chemical Corporation) heated to 50°C, thereby performing an etching treatment for 5 minutes. Thereafter, the laminate sample was washed twice with distilled water at room temperature for 1 minute. Subsequently, the laminate sample was dried. Thereafter, the masking tape was peeled off from the laminate sample, and a state of the copper foil remaining under the masking tape without being etched was observed. After the masking tape was peeled off, if the copper foil remained in a square shape with one side of 5 mm and there was no visible peeling or lifting of the copper foil, it was evaluated as "○", and if there was visible lifting at an end portion of the copper foil or there was peeling of the copper foil, it was evaluated as "×".

### (6) Dynamic Viscoelasticity Evaluation Test

Next, the hollow-structure films 1 of Example 1 to Example 9 and the films of Comparative Example 1 to Comparative Example 3 were subjected to a dynamic viscoelasticity evaluation test when the temperature of the sample became high. In the dynamic viscoelasticity evaluation test, a dynamic viscoelasticity (DMA) measuring apparatus (product name "RSA-G2"), manufactured by TA Instruments Japan Inc., was prepared. The mode of the dynamic viscoelasticity measuring apparatus was a tensile mode. In addition, a rectangular sample having a short side of 5 mm was cut out from each of the hollow-structure films 1 of the examples and the films of the comparative examples. Subsequently, the interval between a pair of chucks of the dynamic viscoelasticity measuring apparatus was set to 10 mm. Then, one of the short sides of the sample was set on one of the pair of chucks, and the other short side of the sample was set on the other of the pair of chucks. Subsequently, the dynamic viscoelasticity was measured while the temperature of the sample was changed from 30°C to 300°C. The heating rate was 5°C/min. In the test for measuring dynamic viscoelasticity, a stress that changes with time was applied to the sample, and the frequency of the change in the stress was set to 1 Hz. Thus, the storage modulus of the sample, in particular, when the temperature of the sample was 280°C was measured.

Table 1 shows results of the porosity measurement test, the specific gravity measurement test, the measurement test for dielectric constant and dielectric loss tangent, the heat resistance evaluation test, the evaluation test for adhesion of copper foil, and the dynamic viscoelasticity evaluation test regarding the hollow-structure films 1 of Examples 1 to 9. In addition, Table 1 shows results of the specific gravity measurement test, the measurement test for dielectric constant and dielectric loss tangent, the heat resistance evaluation test, the evaluation test for adhesion of copper foil, and the dynamic viscoelasticity evaluation test regarding the films of Comparative Examples 1 to 3.

**[Table 1]**

| | Porosity (%) | Specific gravity | Dielectric constant (5 GHz) | Dielectric loss tangent (5 GHz) | Transmission loss coefficient | Heat resistance | Storage modulus (Pa) | Adhesion of copper foil | |
|---|---|---|---|---|---|---|---|---|---|
| | | | | | | | | Resistance of copper foil to load | Etchant resistance |
| Example 1 | 35 | 0.62 | 1.865 | 0.00095 | 0.00130 | ○ | 2.5 × 10⁶ | ○ | ○ |
| Example 2 | 41 | 0.57 | 1.716 | 0.00099 | 0.00130 | ○ | 2.2 × 10⁶ | ○ | ○ |
| Example 3 | 43 | 0.56 | 1.708 | 0.00089 | 0.00116 | ○ | 1.5 × 10⁶ | ○ | ○ |
| Example 4 | 32 | 0.65 | 1.952 | 0.00169 | 0.00236 | ○ | 2.6 × 10⁶ | ○ | ○ |
| Example 5 | 35 | 0.63 | 1.846 | 0.00204 | 0.00277 | ○ | 2.3 × 10⁶ | ○ | ○ |
| Example 6 | 35 | 0.60 | 1.883 | 0.00231 | 0.00317 | ○ | 2.8 × 10⁶ | ○ | ○ |
| Example 7 | 35 | 0.59 | 1.967 | 0.00265 | 0.00371 | ○ | 3.0 × 10⁶ | ○ | ○ |
| Example 8 | 33 | 0.64 | 1.886 | 0.00101 | 0.00139 | ○ | 1.5 × 10⁶ | ○ | ○ |
| Example 9 | 32 | 0.66 | 1.949 | 0.00068 | 0.00095 | ○ | 3.8 × 10⁶ | ○ | ○ |
| Comparative example 1 | 0 | 1.47 | 3.7 | 0.0057 | 0.01096 | ○ | 5.5 × 10⁶ | × | × |
| Comparative example 2 | 0 | 1.38 | 3.0 | 0.0030 | 0.00520 | ○ | 1.1 × 10⁶ | × | × |
| Comparative example 3 | 0 | 0.95 | 2.3 | 0.0010 | 0.00152 | × | <1.0 × 10⁶ | ○ | ○ |

From the results shown in Table 1, it was found that all of Examples 1 to 9 were smaller in dielectric constant, dielectric loss tangent, and transmission loss coefficient than Comparative Examples 1 to 3. Furthermore, it was found that all of Examples 1 to 9 were evaluated as "○" in terms of heat resistance, resistance of copper foil to a load, and etchant resistance. Furthermore, it was found that the storage modulus was 1.0 × 10⁵ Pa or more in all of Examples 1 to 9.

Furthermore, in order to evaluate the performance of the antenna device 101 manufactured using the hollow-structure film 1 and the transmission loss in the hollow-structure film 1, the hollow-structure films 1 of Example 10 and Example 11 and the films of Comparative Example 4 to Comparative Example 6 were prepared.

### (EXAMPLE 10)

A part of the main body portion 1c of the hollow-structure film 1, such as that shown in Fig. 16, was manufactured by the same method as in Example 9 except for the following points. The thickness of the main body portion 1c was 800 µm. Furthermore, two sheets of copper foil (18 µm thick, product name "C1100 Electrolytic Copper Foil 18 µm", purchased from Hohsen Corp.) and materials of two metal adjacent layers (30 µm thick, product name "NUCREL (registered trade mark) AN4233C", manufactured by Dow-Mitsui Polychemicals, Co., Ltd.) were prepared. Subsequently, the copper foil, the material of the metal adjacent layer, the main body portion 1c, the material of the metal adjacent layer, and the copper foil were overlapped in this order. Subsequently, the copper foil, the material of the metal adjacent layer, the main body portion 1c, the material of the metal adjacent layer, and the copper foil were thermocompression-bonded at 100 °C. Thus, the hollow-structure film 1, such as that shown in Fig. 16, including the metal layer 40 formed of the copper foil, the metal adjacent layer 60, the main body portion 1c, the metal adjacent layer 60, and the metal layer 40 formed of the copper foil in this order was manufactured.

### (EXAMPLE 11)

A hollow-structure film 1 was manufactured by the same method as in Example 10 except for the following points. A hollow-structure film 1 having a configuration corresponding to Modification 4 was produced. More specifically, the hollow-structure film 1, such as that shown in Fig. 14, was produced. First, one single-sided shaped body 80 and one resin sheet 32 were produced by the same method as in Example 10. The thickness (the total of the thickness of the base portion 81 and the dimension of the projecting portion 82 in the thickness direction of the base portion 81) of the single-sided shaped body 80 was 150 µm. The thickness of the resin sheet 32 was 50 µm. Subsequently, the resin sheet 32 was disposed so as to face the surface of the single-sided shaped body 80 on which the plurality of projecting portions 82 were formed. The single-sided shaped body 80 and the resin sheet 32 were thermocompression-bonded. In the crosslinking step after the thermocompression bonding, the single-sided shaped body 80 and the resin sheet 32 were irradiated with an electron beam at an accelerating voltage of 200 kV, a current value of 5 mA, and an irradiation dose of 289 kGy. Consequently, the main body portion 1c of the hollow-structure film 1, such as that shown in Fig. 14, was produced. Further, two sheets of copper foil (18 µm thick, product name "C1100 Electrolytic Copper Foil 18 µm", purchased from Hohsen Corp.) were prepared. Subsequently, an olefin resin-based adhesive was applied to one surface of each of the two sheets of copper foil. The application amount of the adhesive was adjusted such that the thickness of the adhesive after drying was 2 µm. Subsequently, the main body portion 1c was disposed between the two sheets of copper foil. At this time, the main body portion 1c was disposed between the two sheets of copper foil such that the surfaces of the two sheets of copper foil applied with the adhesive and the surfaces of the main body portion 1c faced each other. Subsequently, the two sheets of copper foil and the main body portion 1c were thermocompression-bonded at 100°C for 2 minutes. Further, the copper foil and the main body portion 1c subjected to thermocompression bonding were stored in an oven at 80°C for 36 hours to be annealed. As a result, the hollow-structure film 1, such as that shown in Fig. 14, including the metal layer 40 formed of the copper foil, the metal adjacent layer 60 formed of the adhesive, the main body portion 1c, the metal adjacent layer 60 formed of the adhesive, and the metal layer 40 formed of the copper foil in this order was manufactured.

### (Comparative Example 4)

A commercially available PTFE substrate (product name RO3003 (registered trade mark), manufactured by Rogers Corporation) was purchased as a film of Comparative Example 4. The PTFE substrate had a thickness of 800 µm. Copper foil having a thickness of 18 µm had been provided on both surfaces of the PTFE substrate.

### (Comparative Example 5)

A commercially available glass epoxy resin film (product name "CS-3355W", manufactured by Risho Kogyo Co., Ltd.) was purchased as a film of Comparative Example 5. Copper foil having a thickness of 18 µm had been provided on both surfaces of the glass epoxy resin film.

### (Comparative Example 6)

Two commercially available LCP films (product name "R-F705", manufactured by Panasonic Industry Co., Ltd.) were purchased. The LCP films each had a thickness of 100 µm. Copper foil having a thickness of 18 µm had been provided on one surface of each LCP film. Further, a commercially available bonding sheet (product name "R-BM17", manufactured by Panasonic Industry Co., Ltd.) was purchased. The bonding sheet had a thickness of 25 µm. Subsequently, the bonding sheet was disposed between the two LCP films. At this time, the bonding sheet was disposed between the two LCP films such that a surface of each LCP film opposite to the surface on which the copper foil had been provided faced a surface of the bonding sheet. Subsequently, the two LCP films and the bonding sheet were bonded by a bonding process. Thus, a film of Comparative Example 6 was produced. The thickness of the film of Comparative Example 6 was m225 µm. On both surfaces of the film of Comparative Example 6, copper foil having a thickness of 18 µm and derived from the copper foil provided on the LCP films was provided.

### (7) Antenna Performance Evaluation Test

Next, the antenna device 101 was produced from each of the films of Example 10 and Comparative Example 4, and an antenna performance evaluation test was performed on the produced antenna device 101. In the production of the antenna device 101, the wiring pattern of the wiring 41 having a desired shape and the antenna element 102 were formed from the metal layer 40 constituting one surface of the hollow-structure film 1 of each example or the film of each comparative example, thereby manufacturing the antenna device 101, such as that shown in Fig. 6C. A step of forming the wiring pattern of the wiring 41 having a desired shape and the antenna element 102 from the metal layer 40 was performed as follows. First, a weakly adhesive sheet was bonded to a surface of the metal layer 40. Subsequently, the weakly adhesive sheet was cut and removed except for a portion thereof, thereby forming a mask layer having a shape corresponding to a shape of the wiring pattern of the wiring 41 and the antenna element 102 to be formed. Subsequently, the metal layer 40 was etched using the mask layer. In this way, the antenna device 101, such as that shown in Fig. 6C, was manufactured. In Example 10, a dimension w7 (the width of the wiring 41) of the wiring 41 shown in Fig. 6C was 3.2 mm. A dimension w8 (the length of the wiring 41) of the wiring 41 shown in Fig. 6C was 17.0 mm. A dimension w9 of the antenna element 102 shown in Fig. 6C was 25.0 mm. A dimension w10 (the length of the wiring 41) of the antenna element 102 shown in Fig. 6C was 30.0 mm. As shown in Fig. 6C, a pair of slit structures 102b are provided in a portion of the antenna element 102 connected to the wiring 41. The pair of slit structures 102b extend in the direction in which the wiring 41 extends. A space equal to the dimension w7 of the wiring 41 was provided between the pair of slit structures 102b. A dimension w13 (the length of the slit structure 102b) of the slit structure 102b shown in Fig. 6C was set to 11.0 mm. A dimension w14 (the width of the slit structure 102b) of the slit structure 102b shown in Fig. 6C was set to 1.0 mm. In Comparative Example 4, the dimension w7 was set to 1.9 mm, the dimension w8 was set to 17.0 mm, the dimension w9 was set to 21.0 mm, the dimension w10 was set to 22.0 mm, the dimension w13 was set to 8.5 mm, and the dimension w14 was set to 1.0 mm. After the dimensions of the antenna device 101 of each of Example 10 and Comparative Example 4 were determined as described above, a virtual antenna device in which the dimensions such as the dimensions w7, w8, w9, w10, w13, w14, and the like are the same as those of the antenna device 101 of Example 10 was simulated. Further, a virtual antenna device in which dimensions such as the dimensions w7, w8, w9, w10, w13, w14, and the like are the same as those of the antenna device of Comparative Example 4 was simulated. Subsequently, the S11 parameter (input reflection coefficient) of each of the virtual antenna device having the same dimensions as those of the antenna device 101 of Example 10 and the virtual antenna device having the same dimensions as those of the antenna device of Comparative Example 4 when an electric signal at a frequency of 3.9 GHz was applied to the antenna element was calculated. As a result, the S11 parameter of the virtual antenna device having the same dimensions as those of the antenna device 101 of Example 10 and the S11 parameter of the virtual antenna device having the same dimensions as those of the antenna device of Comparative Example 4 were both -33.5 dB. From this, it was confirmed that the setting of the dimensions of the antenna device 101 in Example 10 and Comparative Example 4 was an appropriate setting for comparing the gain and the beam width of the antenna device 101 between Example 10 and Comparative Example 4 as will be described later.

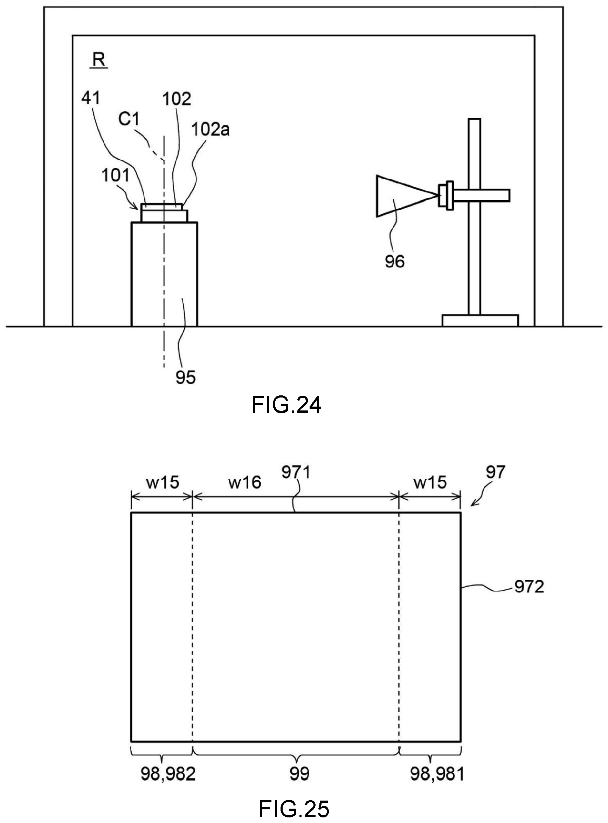

In the antenna performance evaluation test, a virtual antenna device that radiates radio waves with equal intensity in all directions was simulated with a network analyzer. At this time, the virtual antenna is a point having no volume. Then, the virtual antenna device that is a point having no volume was disposed on a rotary table 95 in a manner as with the antenna device 101 shown in Fig. 24 to be described later, and the intensity of a radio wave received by a receiving antenna 96 when an electric signal at a frequency of 3.9 GHz was applied to the antenna element was calculated.

Further, as shown in Fig. 24, the rotary table 95 rotatable about a rotation axis C1 extending in the vertical direction is disposed in a radio anechoic chamber R. Further, the receiving antenna 96 capable of receiving radio waves emitted from the antenna device 101 was disposed at a position horizontally apart from the rotation axis C1 of the rotary table 95 by a distance of 3 m in the radio anechoic chamber R. Subsequently, the produced antenna device 101 was fixed to a fixture, which is not shown, and then disposed, on the rotary table 95 in the radio anechoic chamber R, at a position where the rotation axis C1 passes. At this time, the antenna device 101 was disposed on the rotary table 95 such that a side 102a of the antenna element 102 shown in Fig. 6C faced the receiving antenna 96. In other words, the antenna device 101 was disposed on the rotary table 95 such that the receiving antenna 96 was positioned in the direction of the arrow A1 of the antenna device 101 shown in Fig. 6C. The antenna device 101 was fixed to the fixture such that the fixture was electrically connected to the wiring 41.

Subsequently, an electric signal was applied from the network analyzer to the antenna element 102 of the antenna device 101 via the fixture, which is not shown, to cause the antenna element 102 to transmit a radio wave. The frequency of the electric signal applied to the antenna element 102 was set to 3.9 GHz. Subsequently, the frequency of the electric signal applied to the antenna element 102 was changed, and the frequency at which the intensity of the radio wave received by the receiving antenna 96 was maximized was specified. A difference was calculated by subtracting the intensity of the radio wave calculated as described above with respect to the above-described virtual antenna device that is a point having no volume from the value of the intensity of the radio wave received by the receiving antenna 96 at the frequency at which the intensity of the radio wave received by the receiving antenna 96 is maximized. This difference was defined as the gain of the antenna device 101. The unit of the gain of the antenna device 101 calculated by the above calculation is dBi.

Further, while the electric signal having the frequency, which was specified in calculating the gain, at which the intensity of the radio wave received by the receiving antenna 96 was maximized was applied to the antenna element 102, the antenna device 101 was rotated by rotating the rotary table. When such an operation is performed, it is considered that the intensity of the radio wave received by the receiving antenna 96 takes a maximum value when the side 102a of the antenna element 102 faces the receiving antenna 96, and decreases as the rotation angle of the antenna device 101 from the position where the side 102a of the antenna element 102 faces the receiving antenna 96 increases. The intensity of the radio wave detected by the receiving antenna 96 was measured while the antenna device 101 was rotated. A difference was calculated by subtracting the intensity of the radio wave calculated as described above with respect to the above-described virtual antenna device that is a point having no volume from the measured intensity of the radio wave. It is considered that the value of this difference also changes as the rotation angle of the antenna device 101 changes. With respect to the value of the difference, the magnitude of the change in the rotation angle at which a decrease from the maximum value fell within the range of 3 dBi was calculated as the beam width (unit is °).

A method for calculating the beam width in a specific example will be described. In the specific example, when the antenna device 101 is rotated rightward by an angle of 30° or less from the position where the side 102a of the antenna element 102 faces the receiving antenna 96, the decrease in the intensity of the radio wave detected by the receiving antenna 96 from the maximum value thereof becomes 3 dBi or less. In the specific example, when the antenna device 101 is rotated leftward by an angle of 30° or less from the position where the side 102a of the antenna element 102 faces the receiving antenna 96, the decrease in the intensity of the radio wave detected by the receiving antenna 96 from the maximum value thereof becomes 3 dBi or less. At this time, the beam width is calculated as 60°.

### (8) Transmission Loss Evaluation Test

Next, a transmission loss evaluation test was performed on the films of Example 11 and Comparative Examples 5 and 6 each including the metal layer 40. In the transmission loss evaluation test, first, the linear wiring 43 having a desired shape, such as that shown in Fig. 6A, was formed from the metal layer 40 constituting one surface of the hollow-structure film 1 of each example or the film of each comparative example. The method for forming the linear wiring 43 having a desired shape from the metal layer 40 was the same as the method for forming the wiring pattern of the wiring 41 having a desired shape and the antenna element 102 from the metal layer 40, the method being described in "(7) Antenna Performance Evaluation Test". The length w5 of the linear wiring 43 shown in Fig. 6A was set to 5.0 cm. The width w6 of the linear wiring 43 shown in Fig. 6A was set to 0.75 mm.

The hollow-structure film 1 including the linear wiring 43 was fixed as shown in Fig. 6B to the fixture 93 (product name "Universal Test Fixture 3680V"), an electric signal was applied from a network analyzer (product name "N5247A", manufactured by Keysight Technologies Inc.) via the probe 94 attached to the fixture 93, and the transmission loss of the electric signal was measured. The transmission loss of the electric signal was measured under the following conditions. The electric signal was applied to a section of 5.0 cm of the linear wiring 43. At the time of measurement, in order to eliminate the influence of the fixture 93 from the measurement result, the de-embedding processing described in the above embodiment was performed. A value corresponding to the transmission loss measured by applying the electric signal to the section of a length of 3.5 cm of the linear wiring 43, from which the influence of the transmission loss in both end portions of the linear wiring 43 and the fixture 93 was removed by the de-embedding processing, was calculated.

Table 2 shows the results of the antenna performance evaluation test regarding the hollow-structure film 1 of Example 10 and the film of Comparative Example 4, and the results of the transmission loss evaluation test regarding the hollow-structure film 1 of Example 11 and the films of Comparative Example 5 and Comparative Example 6.

**[Table 2]**

| | Antenna performance evaluation test (3.9 GHz) | | Transmission loss (dB/3.5 cm) | | | |
|---|---|---|---|---|---|---|
| | Gain (dBi) | Beam width (°) | Frequency 10 GHz | Frequency 20 GHz | Frequency 30 GHz | Frequency 40 GHz |
| Example 10 | 5.7 | 81 | - | - | - | - |
| Example 11 | - | - | -0.24 | -0.30 | -0.50 | -0.65 |
| Comparative example 4 | 3.6 | 66 | - | - | - | - |
| Comparative example 5 | - | - | -1.58 | -3.03 | -4.45 | -6.05 |
| Comparative example 6 | - | - | -0.37 | -0.65 | -0.99 | -1.33 |

From the results of the antenna performance evaluation test and the transmission loss evaluation test, the following was found. It has been found that the hollow-structure film 1 in the present description exhibits more excellent performance than a commercially available PTFE substrate that is generally expected to have high antenna performance and an LCP film that is generally expected to have a small transmission loss (the value of the transmission loss having a negative value is close to zero). In particular, it has been found that the hollow-structure film 1 in the present description can suppress the transmission loss, which tends to be high and problematic in the antenna device 101 used in a high-frequency band, to be small (the value of the transmission loss having a negative value can be brought close to zero). Further, it has been clarified that the antenna device 101 using the hollow-structure film 1 in the present description exhibits excellent antenna performance by the action of the aforementioned hollow-structure film 1 as compared with the antenna device using a conventional film.

Further, the hollow-structure films 1 of Examples 12 to 14 and a film of Comparative Example 7 were prepared in order to evaluate the porosity, the dielectric constant, the dielectric loss tangent, the CTE of the main body portion 1c, and the peelability of the copper foil from the main body portion 1c when the copper foil and the main body portion 1c are bonded in the hollow-structure film 1 described above as Modification 6 in which the main body portion 1c includes the inorganic material member 70.

### (EXAMPLE 12)

The hollow-structure film 1 similar to the hollow-structure film 1 shown in Fig. 17 was manufactured. At this time, first, a pair of the single-sided shaped bodies 80 were produced using the mold 90. At this time, Kapton (registered trade mark), manufactured by Du Pont-Toray Co., Ltd., was prepared as a peelable substrate. Further, a mixture of a resin and an electron beam crosslinking agent was prepared as a material of the shaped-body corresponding portion 13. High-density polyethylene raw material pellets (product name "HI-ZEX (registered trade mark) 5000SR", manufactured by Prime Polymer Co., Ltd.) were used as the resin. The resin corresponds to high-density polyethylene (HDPE). As the electron beam crosslinking agent, TAIC (registered trade mark) (manufactured by Shinryo Corporation) was used. The ratio of the mass of the resin to the total mass of the resin and the electron beam crosslinking agent was 98 mass%. The ratio of the mass of the electron beam crosslinking agent to the total mass of the resin and the electron beam crosslinking agent was 2 mass%.

Subsequently, using the mold 90 having the surface 90a that has a shape corresponding to the shape of the single-sided shaped body 80 to be produced, the material of the shaped-body corresponding portion 13 was molded on the peelable substrate. Thus, the pair of single-sided shaped bodies 80 were produced from the material of the shaped-body corresponding portion 13. In molding of the material of the shaped-body corresponding portion 13, the sheet-shaped inorganic material member 70 was disposed on the upper side of a mixture of the resin and the electron beam crosslinking agent, and then the molding was performed. At the time of molding, the mixture of the resin and the electron beam crosslinking agent and the inorganic material member 70 were subjected to press working. By this press working, a portion of the material derived from the mixture of the resin and the electron beam crosslinking agent was moved to the upper side of the inorganic material member 70 through the inside of the inorganic material member 70. As a result, a pair of the single-sided shaped bodies 80, such as those shown in Fig. 19, in each of which the sheet-shaped inorganic material member 70 was included in the base portion 81 were produced. In particular, a pair of the single-sided shaped bodies 80 each having the base portion 81 including the sheet-shaped inorganic material member 70 and the material that is derived from the mixture of the resin and the electron beam crosslinking agent and that surrounds the inorganic material member 70 were produced. As the sheet-shaped inorganic material member 70, a glass cloth (product name "LU1017:L01Z (vinylsilane-based treatment)", manufactured by Unitika Ltd.) was used. The pair of single-sided shaped bodies 80 produced each had the sheet-shaped base portion 81 and a plurality of the projecting portions 82 formed on one surface of the base portion 81. The thickness (the total of the thickness of the base portion 81 and the dimension of the projecting portion 82 in the thickness direction of the base portion 81) of the single-sided shaped body 80 was 150 µm.

Further, the resin sheet 32 to be used as a material for the central portion 30 was produced. As the resin sheet 32, the resin sheet 32 obtained by molding a resin material into a sheet shape was used. Linear low-density polyethylene raw material pellets (product name "DOWLEX (registered trade mark): 2045.11G (C8 Copolymer)", manufactured by Dow Chemical Company) were used as the resin material contained in the resin sheet 32. The resin corresponds to linear low-density polyethylene (LLDPE). The thickness of the resin sheet 32 was 50 µm.

Subsequently, a pair of laminates each including the single-sided shaped body 80 and the peelable substrate were overlapped such that the plurality of projecting portions 82 of the pair of single-sided shaped bodies 80 partially faced each other. As a result, the pair of single-sided shaped bodies 80 were overlapped such that the plurality of projecting portions 82 partially faced each other. At this time, the resin sheet 32 was disposed between the pair of single-sided shaped bodies 80.

Subsequently, the pair of single-sided shaped bodies 80 were thermocompression-bonded. In particular, the pair of single-sided shaped bodies 80 were bonded to the resin sheet 32 at the plurality of projecting portions 82 by thermocompression-bonding the pair of single-sided shaped bodies 80. As a result, the pair of single-sided shaped bodies 80 were bonded to each other via the resin sheet 32. The heating temperature when the pair of single-sided shaped bodies 80 were thermocompression-bonded was set to be higher than the Vicat softening point of the resin contained in the central portion 30.

Subsequently, the peelable substrate was peeled off from the pair of single-sided shaped bodies 80.

Subsequently, a crosslinking step of irradiating the electron beam crosslinking agent contained in the single-sided shaped bodies 80 and the resin contained in the single-sided shaped bodies 80 with an electron beam to cause the electron beam crosslinking agent to react with the resin was performed. In the irradiation with the electron beam, the accelerating voltage was 200 kV, the current value was 5 mA, and the irradiation dose was 289 kGy. Further, in the crosslinking step, the resin contained in the resin sheet 32 was irradiated with an electron beam to cause a reaction of the resin. More specifically, in the crosslinking step, the electron beam crosslinking agent and the resin contained in each single-sided shaped body 80 and the resin contained in the resin sheet 32 were simultaneously irradiated with an electron beam. As a result, a reaction between the electron beam crosslinking agent and the resin was caused in the single-sided shaped body 80, and at the same time, a reaction of the resin was caused in the resin sheet 32. Thus, the hollow-structure film 1 shown in Fig. 17 was manufactured. The ratio of the width w2 to the interval w1 of the hollow-structure film 1 was 1:3.

### (EXAMPLE 13)

The hollow-structure film 1 was manufactured by the same method as in Example 12 except for the following points. In Example 13, the hollow-structure film 1 similar to the hollow-structure film 1 shown in Fig. 18 was manufactured. In Example 13, the sheet-shaped inorganic material member 70 was not disposed inside the mixture of the resin and the electron beam crosslinking agent when the material of the shaped-body corresponding portion 13 was molded. In Example 13, when the material of the shaped-body corresponding portion 13 was molded, a plurality of rod-shaped inorganic material members 70 were disposed inside the mixture of the resin and the electron beam crosslinking agent, and then the molding was performed. When the pair of single-sided shaped bodies 80 were molded, the amount of the rod-shaped inorganic material members 70 added was 30 mass% in terms of mass ratio with respect to the total mass of the resin, the electron beam crosslinking agent, and the inorganic material members 70. In this way, a pair of the single-sided shaped bodies 80, such as those shown in Fig. 20, in which the rod-shaped inorganic material members 70 were included in the base portion 81 and all of the plurality of projecting portions 82 were produced. In Example 13, when the resin sheet 32 was molded into a sheet shape, the molding was performed after the plurality of rod-shaped inorganic material members 70 were disposed inside the mixture of the resin as the material of the resin sheet 32 and the electron beam crosslinking agent. When the resin sheet 32 was produced, the amount of the rod-shaped inorganic material members 70 added was 30 mass% in terms of mass ratio with respect to the total mass of the resin, the electron beam crosslinking agent, and the inorganic material members 70. As the rod-shaped inorganic material members 70, glass fibers (product name "SS05DE-413SP", manufactured by Nitto Boseki Co., Ltd.) were used. In this way, the resin sheet 32, such as that shown in Fig. 20, including the rod-shaped inorganic material members 70 was produced. The hollow-structure film 1 shown in Fig. 18 was manufactured using the pair of single-sided shaped bodies 80 and the resin sheet 32 produced as described above.

### (EXAMPLE 14)

A hollow-structure film 1 was manufactured by the same method as in Example 13 except for the following points. In Example 14, a plurality of flaky inorganic material members 70 were used as the inorganic material members 70. Regarding the mixture of the resin as the material of the shaped-body corresponding portion 13 and the electron beam crosslinking agent, the ratio of the mass of the resin to the total mass of the resin and the electron beam crosslinking agent was set to 60 mass%. When the pair of single-sided shaped bodies 80 were produced, the amount of the flaky inorganic material members 70 added was 40 mass% in terms of the mass ratio to the total mass of the resin, the electron beam crosslinking agent, and the inorganic material members 70. As the flaky inorganic material members 70, the product name "REF015A" (manufactured by Nippon Sheet Glass Co., Ltd.) was used.

### (Comparative Example 7)

A film of Comparative Example 7 was prepared by dispersing an electron beam crosslinking agent in a resin and forming the resin into a sheet shape. High-density polyethylene raw material pellets (product name "HI-ZEX (registered trade mark) 5000SR", manufactured by Prime Polymer Co., Ltd.) were used as the resin material contained in the film of Comparative Example 7. The resin corresponds to high-density polyethylene (HDPE). As the electron beam crosslinking agent contained in the film of Comparative Example 7, TAIC (registered trade mark) (manufactured by Shinryo Corporation) was used. The ratio of the mass of the resin to the total mass of the resin and the electron beam crosslinking agent was 95 mass%. The ratio of the mass of the electron beam crosslinking agent to the total mass of the resin and the electron beam crosslinking agent was 5 mass%. The thickness of the film of Comparative Example 7 was 350 µm.

### (9) Porosity Measurement Test

Next, a porosity measurement test was performed on the hollow-structure films 1 of Examples 12 to 14. The porosity measurement test was performed by the same method as in "(1) Porosity Measurement Test" regarding the hollow-structure films 1 of Examples 1 to 9. The porosity of Comparative Example 7, which originally did not have the hollow portion B, was set to zero.

### (10) Measurement Test for Dielectric Constant and Dielectric Loss Tangent

Next, the hollow-structure films 1 of Examples 12 to 14 and the film of Comparative Example 7 were subjected to a measurement test for dielectric constant and dielectric loss tangent. The measurement test for dielectric constant and dielectric loss tangent was performed by the same method as in "(3) Measurement Test for Dielectric Constant and Dielectric Loss Tangent" regarding the hollow-structure films 1 of Examples 1 to 9 and the films of Comparative Examples 1 to 3.

### (11) CTE Measurement Test

Next, the hollow-structure films 1 of Examples 12 to 14 and the film of Comparative Example 7 were subjected to a CTE measurement test. In the CTE measurement test, the CTE of the main body portion 1c of the hollow-structure film 1 of each of Examples 12 to 14 and the CTE of the film of Comparative Example 7 was measured. The CTE was measured by the following method. A thermomechanical analyzer (product name: "TMA-60", manufactured by Shimadzu Corporation) was used as a measurement apparatus. First, as shown in Fig. 25, a rectangular sample 97 having a short side 972 of 5 mm and a long side 971 of 14 mm was cut out from each of the hollow-structure films 1 of Examples 12 to 14 and the film of Comparative Example 7. A region having the short side 972 of the sample 97 as one end and having a width w15 of 2 mm in the direction in which the long side 971 extends is referred to as a chucking region 98. The sample 97 has a pair of the chucking regions 98, including a first chucking region 981 and a second chucking region 982. An intermediate region 99 having a width w16 of 10 mm in the direction in which the long side 971 extends is formed between the first chucking region 981 and the second chucking region 982. In the measurement of the CTE, the first chucking region 981 was fixed to a first fixture by sandwiching the entirety of the first chucking region 981 with the first fixture. Further, the second chucking region 982 was fixed to a second fixture by sandwiching the entirety of the second chucking region 982 with the second fixture. Subsequently, a load of 3.0 g was applied to the intermediate region 99 of the sample 97 located between the first fixture and the second fixture via the first fixture and the second fixture. In a state where the load of 3.0 g was applied to the intermediate region 99 in this manner, the sample 97, the first fixture, and the second fixture were disposed inside a temperature control chamber. Subsequently, the temperature inside the temperature control chamber was once set to 10°C. Thereafter, the temperature inside the temperature control chamber was increased at a rate of 10°C/1 minute, and the amount of expansion of the intermediate region 99 of the sample 97 in the direction in which the long side 971 extended was measured. At this time, in particular, the width w16 of the intermediate region 99 when the temperature inside the temperature control chamber reached 25°C and the width w16 of the intermediate region 99 when the temperature inside the temperature control chamber reached 75°C were measured. From results of the above measurement, the elongation percentage of the width w16 of the intermediate region 99 when the temperature inside the temperature control chamber was increased from 25°C to 75°C was calculated in parts per million. A value obtained by dividing the elongation percentage by 50 (°C) corresponds to the elongation percentage of the sample 97 when the temperature is increased by 1°C. This value was obtained as the value of CTE (ppm/°C).

### (11) Evaluation Test for Peelability of Copper Foil

Next, an evaluation test for peelability of the copper foil was performed on the hollow-structure films 1 of Example 12 to Example 14 and the film of Comparative Example 7. In the evaluation test for peelability of the copper foil, a rectangular sample having a long side of 50 mm and a short side of 10 mm was cut out from the main body portion 1c of the hollow-structure film 1 of each example and the film of the comparative example. On the sample, a material (30 µm thick, product name "NUCREL (registered trade mark) AN4233C", manufactured by Dow-Mitsui Polychemicals, Co., Ltd.) for the metal adjacent layer and copper foil (10 µm thick, product name "CF-LB9-10", purchased from Hohsen Corp.) were stacked in this order so as to cover the entire sample. Subsequently, a portion where the sample, the material of the metal adjacent layer, and the copper foil overlap each other was thermocompression-bonded at 100°C. The compression-bonded portion was formed throughout the sample. Subsequently, the compression-bonded portion was allowed to stand in a room at a room temperature of 25°C for 48 hours. Whether the copper foil was peeled from the sample at the time of thermocompression bonding or at the time of standing in the room was observed.

The results of the porosity measurement test regarding the hollow-structure films 1 of Examples 12 to 14 are shown in Table 3. In addition, Table 3 shows the results of the measurement test for dielectric constant and dielectric loss tangent, the CTE measurement test, and the evaluation test for peelability of the copper foil regarding the hollow-structure films 1 of Examples 12 to 14 and the film of Comparative Example 7.

**[Table 3]**

| | Porosity (%) | Dielectric constant (5 GHz) | Dielectric loss tangent (5 GHz) | CTE (ppm/°C) | Results of evaluation test for peelability of copper foil |
|---|---|---|---|---|---|
| Example 12 | 35 | 1.9 | 0.00124 | 85 | no peeling occurred |
| Example 13 | 35 | 2.2 | 0.00133 | 120 | no peeling occurred |
| Example 14 | 35 | 2.1 | 0.00139 | 95 | no peeling occurred |
| Comparative example 7 | 0 | 2.3 | 0.00163 | 220 | peeling occurred |

From the results shown in Table 3, it was found that all of Examples 12 to 14 had a smaller dielectric constant than Comparative Example 7. It was found that all of Examples 12 to 14 had a lower CTE than Comparative Example 7. It was found that, in all of Examples 12 to 14, the CTE was 120 ppm/°C or less. Furthermore, in all of Examples 12 to 14, the copper foil did not peel off from the sample in the evaluation test for peelability of the copper foil.

It is also possible to combine, as necessary and as appropriate, a plurality of the constituent elements disclosed in the above-described embodiment and modifications. Alternatively, some constituent elements may be omitted from all the constituent elements presented in the embodiment and the modifications described above.

### Reference Signs List

1 hollow-structure film
1a first surface
1b second surface
10 base portion
20 pillar portion
30 central portion
40 metal layer
50 particle
51 glass particle
60 metal adjacent layer
80 single-sided shaped body
81 base portion
82 projecting portion
90 mold
100 circuit board
101 antenna device

## Claims

1. A hollow-structure film having a hollow structure, the hollow-structure film comprising:
a first base portion having a sheet shape;
a second base portion having a sheet shape and overlapping the first base portion; and
a plurality of pillar portions provided between the first base portion and the second base portion,
wherein the first base portion has a first facing surface facing the second base portion,
wherein the second base portion has a second facing surface facing the first base portion, and
wherein at least a part of the plurality of pillar portions constitutes a continuous pillar portion extending from the first facing surface to the second facing surface.

2. The hollow-structure film according to claim 1,
wherein the pillar portions extend in a first direction perpendicular to a thickness direction of the hollow-structure film,
wherein, in a cross section of the hollow-structure film taken along a cross section passing through the pillar portions and perpendicular to the first direction, an angle formed by a surface of the first base portion and a portion of a surface of each of the pillar portions connected to the first base portion is 90° or more and 150° or less, and
wherein, in a cross section of the hollow-structure film taken along a cross section passing through the pillar portions and perpendicular to the first direction, an angle formed by a surface of the second base portion and a portion of a surface of each of the pillar portions connected to the second base portion is 90° or more and 150° or less.

3. The hollow-structure film according to claim 1, the hollow-structure film comprising a main body portion,
wherein the main body portion includes the first base portion, the second base portion, the plurality of pillar portions, and a central portion having a sheet shape and located between the first facing surface and the second facing surface, and
wherein the plurality of pillar portions are located on the first facing surface side and the second facing surface side of the central portion.

4. The hollow-structure film according to claim 1, wherein the hollow-structure film has a thickness of 50 µm or more and 1000 µm or less.

5. The hollow-structure film according to claim 1, wherein at least one of the first base portion, the second base portion, and the pillar portions includes a first resin material having a density larger than 940 kg/m³ and a second resin material having a density smaller than or equal to 925 kg/m³.

6. The hollow-structure film according to claim 1, wherein the hollow-structure film has a storage modulus of 1.0 × 10⁵ Pa or more.

7. The hollow-structure film according to claim 1, wherein the hollow-structure film includes a glass particle.

8. The hollow-structure film according to claim 7, wherein the glass particle has a hollow portion.

9. The hollow-structure film according to claim 1, wherein the hollow-structure film includes a compound having a double bond active to radiation or to a thermal radical initiator.

10. The hollow-structure film according to claim 1, wherein the hollow-structure film has a porosity of 20% or more.

11. The hollow-structure film according to any one of claims 1 to 10,
wherein the hollow-structure film has a first surface and a second surface opposite to the first surface, and
wherein the hollow-structure film further comprises a metal layer constituting at least a portion of at least one of the first surface and the second surface.

12. The hollow-structure film according to claim 11, further comprising a metal adjacent layer that bonds the metal layer to at least one of the first base portion and the second base portion,
wherein a material of the metal adjacent layer is different from a material of the first base portion and a material of the second base portion.

13. The hollow-structure film according to claim 11, further comprising a metal adjacent layer that bonds the metal layer to at least one of the first base portion and the second base portion,
wherein a material of the metal adjacent layer is an adhesive.

14. The hollow-structure film according to claim 11, further comprising an ionomer layer or an ethylene (meth)acrylic acid copolymer layer that bonds the metal layer to at least one of the first base portion and the second base portion.

15. The hollow-structure film according to claim 11, wherein at least one of conditions is satisfied, the conditions including a condition in which a value of transmission loss of an electric signal having a frequency of 10 GHz and applied to linear wiring formed from the metal layer is greater than -0.30 dB/3.5 cm, a condition in which a value of transmission loss of an electric signal having a frequency of 20 GHz and applied to the linear wiring is greater than -0.60 dB/3.5 cm, a condition in which a value of transmission loss of an electric signal having a frequency of 30 GHz and applied to the linear wiring is greater than -0.90 dB/3.5 cm, a condition in which a value of transmission loss of an electric signal having a frequency of 40 GHz and applied to the linear wiring is greater than -1.30 dB/3.5 cm, a condition in which a value of transmission loss of an electric signal having a frequency of 50 GHz and applied to the linear wiring is greater than -1.80 dB/3.5 cm, and a condition in which a value of transmission loss of an electric signal having a frequency of 60 GHz and applied to the linear wiring is greater than -3.00 dB/3.5 cm.

16. A circuit board comprising:
the hollow-structure film according to any one of claims 1 to 10, the hollow-structure film having a first surface and a second surface opposite to the first surface; and
a wiring pattern provided on at least one of the first surface and the second surface.

17. An antenna device comprising:
the circuit board according to claim 16; and
an antenna element connected to the circuit board.

18. A method for manufacturing a hollow-structure film having a hollow structure, the method comprising:
a step of producing, using a mold, a pair of single-sided shaped bodies each including a base portion having a sheet shape and a plurality of projecting portions formed on one surface of the base portion; and
a step of overlapping the produced pair of single-sided shaped bodies such that a plurality of the projecting portions face each other at least partially, and thermocompression bonding the pair of single-sided shaped bodies.

19. A hollow-structure film having a hollow structure, the hollow-structure film comprising:
a main body portion including a first base portion having a sheet shape, a second base portion having a sheet shape and overlapping the first base portion, and a plurality of pillar portions provided between the first base portion and the second base portion,
wherein the first base portion has a first facing surface facing the second base portion,
wherein the second base portion has a second facing surface facing the first base portion,
wherein at least a part of a plurality of the pillar portions constitutes a continuous pillar portion extending from the first facing surface to the second facing surface,
wherein the main body portion includes an insulating inorganic material member, and
wherein a maximum width of the inorganic material member is more than or equal to three times a minimum width of the inorganic material member.

20. The hollow-structure film according to claim 19, wherein the inorganic material member is included in at least one of the first base portion and the second base portion.

21. The hollow-structure film according to claim 19, wherein the inorganic material member is included in at least a part of a plurality of the pillar portions.

22. The hollow-structure film according to claim 19,
wherein the main body portion further includes a central portion having a sheet shape and located between the first facing surface and the second facing surface, and
wherein the plurality of pillar portions are located on the first facing surface side and the second facing surface side of the central portion.

23. The hollow-structure film according to claim 22, wherein the inorganic material member is included in at least the central portion.

24. The hollow-structure film according to claim 19, wherein the inorganic material member contains glass.

25. The hollow-structure film according to claim 19, wherein the inorganic material member has a maximum width of 10 µm or more.

26. The hollow-structure film according to claim 19, wherein the main body portion contains polyolefin.

27. The hollow-structure film according to claim 19, wherein the hollow-structure film has a thickness of 50 µm or more and 1000 µm or less.

28. The hollow-structure film according to claim 19, wherein the hollow-structure film has a porosity of 20% or more.

29. The hollow-structure film according to claim 19,
wherein the hollow-structure film has a first surface and a second surface opposite to the first surface, and
wherein the hollow-structure film further comprises a metal layer constituting at least a portion of at least one of the first surface and the second surface.

30. The hollow-structure film according to claim 29, further comprising a metal adjacent layer that bonds the metal layer to at least one of the first base portion and the second base portion,
wherein a material of the metal adjacent layer is different from a material of the first base portion and a material of the second base portion.

31. The hollow-structure film according to claim 29, further comprising a metal adjacent layer that bonds the metal layer to at least one of the first base portion and the second base portion,
wherein a material of the metal adjacent layer is an adhesive.

32. The hollow-structure film according to claim 29, further comprising an ionomer layer or an ethylene (meth)acrylic acid copolymer layer that bonds the metal layer to at least one of the first base portion and the second base portion.

33. A circuit board comprising:
the hollow-structure film according to any one of claims 19 to 28, the hollow-structure film having a first surface and a second surface opposite to the first surface; and
a wiring pattern provided on at least one of the first surface and the second surface.

34. An antenna device comprising:
the circuit board according to claim 33; and
an antenna element connected to the circuit board.

35. A method for manufacturing a hollow-structure film having a hollow structure, the method comprising:
a step of producing, using a mold, a pair of single-sided shaped bodies each including a base portion having a sheet shape and a plurality of projecting portions formed on one surface of the base portion, the single-sided shaped bodies each including an insulating inorganic material member; and
a step of overlapping the produced pair of single-sided shaped bodies such that a plurality of the projecting portions face each other at least partially, and thermocompression bonding the pair of single-sided shaped bodies,
wherein a maximum width of the inorganic material member is more than or equal to three times a minimum width of the inorganic material member.
